(19) Europäisches Patentamt
European Patent Office
Office européen des brevets

(11) EP 4 474 163 A1

(12) EUROPEAN PATENT APPLICATION
published in accordance with Art. 153(4) EPC

(43) Date of publication:
**11.12.2024 Bulletin 2024/50**

(21) Application number: **23747182.6**

(22) Date of filing: **31.01.2023**

(51) International Patent Classification (IPC):
***B41N 1/14*** (2006.01) ***B41C 1/055*** (2006.01)
***B41C 1/10*** (2006.01) ***B41M 1/06*** (2006.01)
***B41N 1/08*** (2006.01) ***B41N 3/00*** (2006.01)
***G03F 7/00*** (2006.01) ***G03F 7/004*** (2006.01)
***G03F 7/029*** (2006.01) ***G03F 7/09*** (2006.01)
***G03F 7/11*** (2006.01)

(52) Cooperative Patent Classification (CPC):
**B41C 1/055; B41C 1/10; B41M 1/06; B41N 1/08; B41N 1/14; B41N 3/00; G03F 7/00; G03F 7/004; G03F 7/029; G03F 7/09; G03F 7/11**

(86) International application number:
**PCT/JP2023/003124**

(87) International publication number:
**WO 2023/145972 (03.08.2023 Gazette 2023/31)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **31.01.2022 JP 2022013339**
**21.07.2022 JP 2022116662**

(71) Applicant: **FUJIFILM Corporation**
**Tokyo 106-8620 (JP)**

(72) Inventors:
- **ARIMURA, Keisuke**
**Haibara-gun, Shizuoka 421-0396 (JP)**
- **WATANABE, Shumpei**
**Haibara-gun, Shizuoka 421-0396 (JP)**

(74) Representative: **HGF**
**HGF Limited**
**1 City Walk**
**Leeds LS11 9DX (GB)**

# (54) ON-PRESS DEVELOPMENT TYPE LITHOGRAPHIC PRINTING PLATE PRECURSOR, LITHOGRAPHIC PRINTING PLATE FABRICATION METHOD, LITHOGRAPHIC PRINTING METHOD, AND LAMINATE

(57) An on-press development type lithographic printing plate precursor, including an image-recording layer on a support, in which the image-recording layer contains an infrared absorber A, a borate compound B, an iodonium compound C, and a color forming substance precursor D, and a surface free energy of an outermost layer on an image-recording layer side is 115 mJ/m$^2$ or less, and a method of preparing a lithographic printing plate, a lithographic printing method, and a laminate using the on-press development type lithographic printing plate precursor.

EP 4 474 163 A1

## Description

### BACKGROUND OF THE INVENTION

1. Field of the Invention

The present disclosure relates to an on-press development type lithographic printing plate precursor, a method of preparing a lithographic printing plate, a lithographic printing method, and a laminate.

2. Description of the Related Art

In general, a lithographic printing plate is composed of lipophilic image areas that receive ink during a printing process and hydrophilic non-image areas that receive a dampening water. Lithographic printing is a printing method that utilizes the property that water and oil-based ink repel each other to cause differences in ink attachment behavior on a surface of the lithographic printing plate by using lipophilic image areas on the lithographic printing plate as an ink-receiving area and using hydrophilic non-image areas on the lithographic printing plate as dampening water-receiving areas (non-ink-receiving areas), thereby depositing the ink only to the image areas, and then transferring the ink to a printing material, such as paper.

In the related art, in order to prepare this lithographic printing plate, a lithographic printing plate precursor (PS plate) has been widely used which is obtained by providing a lipophilic photosensitive resin layer (image-recording layer) on a hydrophilic support. Usually, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing a surface of the hydrophilic support.

In response to the intensifying interest in the global environment, an environmental issue of waste liquid generated by wet treatments such as a development treatment has gathered more attention.

Regarding the environmental issue described above, an attempt is made to simplify development or plate making or to remove treatments. As one of simple preparation methods, a method called "on-press development" is being carried out. That is, the on-press development is a method of exposing a lithographic printing plate precursor, then immediately mounting the precursor on a printer without performing development of the related art, and removing an unnecessary portion of the image-recording layer at an initial stage of the ordinary printing step.

In the present disclosure, a lithographic printing plate precursor that can be used for such on-press development is called "on-press development type lithographic printing plate precursor".

Examples of the lithographic printing plate precursors in the related art include those described in WO2020/262692A.

WO2020/262692A describes an on-press development type lithographic printing plate precursor in which, the on-press development type lithographic printing plate precursor has two or more maximal absorption wavelengths in a wavelength range of 760 nm to 900 nm, and in a case of performing exposure to infrared rays having a wavelength of 830 nm at an energy density of 110 mJ/cm$^2$, a lightness change $\Delta L$ in a portion to be exposed between before exposure and after storage for 24 hours under conditions of 25°C and 70 %RH after exposure is 3.0 or more.

### SUMMARY OF THE INVENTION

An object of an embodiment of the present disclosure is to provide an on-press development type lithographic printing plate precursor having excellent development defect suppressiveness.

An object of another embodiment of the present disclosure is to provide a method of preparing a lithographic printing plate and a lithographic printing method in which the on-press development type lithographic printing plate precursor is used.

An object of another embodiment of the present disclosure is to provide a laminate of the on-press development type lithographic printing plate precursor having excellent development defect suppressiveness.

Means for solving the above issues include the following aspects.

<1> An on-press development type lithographic printing plate precursor, comprising an image-recording layer on a support, in which the image-recording layer contains an infrared absorber A, a borate compound B, an iodonium compound C, and a color forming substance precursor D, and a surface free energy of an outermost layer on an image-recording layer side is 115 mJ/m$^2$ or less.

<2> The on-press development type lithographic printing plate precursor according to <1>, in which the iodonium

compound C includes two types of iodonium compounds.

<3> The on-press development type lithographic printing plate precursor according to <1> or <2>, in which a molar absorption coefficient ε of a color forming substance generated from the color forming substance precursor D is 35,000 or more.

<4> The on-press development type lithographic printing plate precursor according to <3>, in which a ring-opening ratio of the color forming substance precursor, which is obtained by the following expression, is 40 mol% to 99 mol%, and a maximum absorption wavelength of the color forming substance generated from the color forming substance precursor, in a wavelength range of 380 nm to 750 nm, is 500 nm to 650 nm.

Ring-opening ratio = molar absorption coefficient of the color forming substance obtained in case of adding 1 molar equivalent of acid to the color forming substance precursor/molar absorption coefficient ε of the color forming substance generated from the color forming substance precursor × 100

<5> The on-press development type lithographic printing plate precursor according to any one of <1> to <4>, further comprising a protective layer on the image-recording layer.

<6> The on-press development type lithographic printing plate precursor according to <5>, in which the protective layer contains a filler.

<7> The on-press development type lithographic printing plate precursor according to any one of <1> to <6>, in which the image-recording layer further contains polymer particles containing a polymer having both of i: a constitutional unit having a pendant cyano group directly bonded to a hydrophobic main chain and ii: a constitutional unit having a pendant group including a hydrophilic poly(alkylene oxide) segment.

<8> The on-press development type lithographic printing plate precursor according to any one of <1> to <7>, in which the support has an aluminum plate and an anodic oxide film of aluminum, disposed on the aluminum plate, the anodic oxide film is positioned closer to the image-recording layer side than the aluminum plate, the anodic oxide film has a micropore extending in a depth direction from a surface of the anodic oxide film on the image-recording layer side, the micropore is configured with a large diameter portion extending to a position at a depth of 10 nm to 1,000 nm from the surface of the anodic oxide film and a small diameter portion communicating with a bottom portion of the large diameter portion and extending to a position at a depth of 20 nm to 2,000 nm from a communicate position, an average diameter of the large diameter portion within the surface of the anodic oxide film is 15 nm to 100 nm, and an average diameter of the small diameter portion at the communicate position is less than 15 nm.

<9> The on-press development type lithographic printing plate precursor according to any one of <1> to <7>, in which the support has an aluminum plate and an anodic oxide film of aluminum, disposed on the aluminum plate, the anodic oxide film is positioned closer to the image-recording layer side than the aluminum plate, the anodic oxide film has a micropore extending in a depth direction from a surface of the anodic oxide film on the image-recording layer side, the micropore is configured with a small diameter portion extending to a position at a depth of 10 nm to 1,000 nm from the surface of the anodic oxide film and a large diameter portion communicating with a bottom portion of the small diameter portion and extending to a position at a depth of 20 nm to 2,000 nm from a communicate position, an average diameter of the small diameter portion within the surface of the anodic oxide film is 35 nm or less, and an average maximum diameter of the large diameter portion is 40 nm to 300 nm.

<10> The on-press development type lithographic printing plate precursor according to any one of <1> to <7>, in which the support has an aluminum plate and an anodic oxide film of aluminum, disposed on the aluminum plate, the anodic oxide film is positioned closer to the image-recording layer side than the aluminum plate, the anodic oxide film is configured with an upper layer, an intermediate layer, and a lower layer, which have a micropore, the upper layer has a pore diameter of 20 nm to 100 nm and a thickness of 30 nm to 500 nm, the intermediate layer has a pore diameter of 1/2 times to 5 times the pore diameter of the upper layer and a thickness of 100 nm to 300 nm, and the lower layer has a pore diameter of 15 nm or less and a thickness of 300 nm to 2,000 nm.

<11> A method of preparing a lithographic printing plate, comprising a step of exposing the on-press development type lithographic printing plate precursor according to any one of <1> to <10> in a shape of an image, and a step of supplying at least one selected from the group consisting of a printing ink and dampening water on a printer to remove an image-recording layer in a non-image area.

<12> A lithographic printing method comprising a step of exposing the on-press development type lithographic printing plate precursor according to any one of <1> to <10> in a shape of an image, a step of supplying at least one selected from the group consisting of a printing ink and dampening water on a printer to remove an image-recording layer in a non-image area and to prepare a lithographic printing plate, and a step of performing printing using the obtained lithographic printing plate.

<13> A laminate comprising laminated on-press development type lithographic printing plate precursors, the on-press development type lithographic printing plate precursor including an image-recording layer on a support and having a

surface free energy of an outermost layer on an image-recording layer side of 115 mJ/m$^2$ or less, in which the image-recording layer contains an infrared absorber A, a borate compound B, an iodonium compound C, and a color forming substance precursor D, in which a protective material that protects the on-press development type lithographic printing plate precursor disposed on at least an uppermost portion of the laminated on-press development type lithographic printing plate precursors is provided, and the protective material has a moisture content of 10% by mass or less.

According to an embodiment of the present disclosure, it is possible to provide an on-press development type lithographic printing plate precursor having excellent development defect suppressiveness.

According to another embodiment of the present disclosure, it is possible to provide a method of preparing a lithographic printing plate and a lithographic printing method in which the on-press development type lithographic printing plate precursor is used.

According to another embodiment of the present disclosure, it is possible to provide a laminate of the on-press development type lithographic printing plate precursor having excellent development defect suppressiveness.

## BRIEF DESCRIPTION OF THE DRAWINGS

Fig. 1 is a graph showing an example of an alternating waveform current waveform diagram used for an electrochemical roughening treatment in a manufacturing method of an aluminum support having an anodic oxide film.

Fig. 2 is a lateral view showing an example of a radial cell in an electrochemical roughening treatment using alternating current in the manufacturing method of an aluminum support having an anodic oxide film.

Fig. 3 is a schematic view of an anodization treatment device used for an anodization treatment in a manufacturing method of an aluminum support having an anodic oxide film.

Fig. 4 is a schematic cross-sectional view of the device used for evaluating the development defect suppressiveness caused by shearing.

## DESCRIPTION OF THE PREFERRED EMBODIMENTS

Hereinafter, the contents of the present disclosure will be described in detail. The description of configuration requirements below is made based on representative embodiments of the present disclosure in some cases, but the present disclosure is not limited to such embodiments.

In the present specification, a numerical range expressed using "to" includes numerical values listed before and after "to" as the lower limit value and the upper limit value.

In addition, in the present specification, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

In the present specification, "(meth)acryl" is a term used to explain a concept including both the acryl and methacryl, and "(meth)acryloyl" is a term used to explain a concept including both the acryloyl and methacryloyl.

In addition, the term "step" in the present specification means not only an independent step but also a step that cannot be clearly differentiated from other steps as long as the intended goal of the step is achieved. In the present disclosure, "% by mass" has the same definition as "% by weight", and "part by mass" has the same definition as "part by weight".

Unless otherwise specified, each of the values of physical properties is measured at 25°C.

In the present disclosure, unless otherwise specified, as each component contained in a composition or each constitutional unit contained in a polymer, one component or one constitutional unit may be used alone, or two or more components or two or more constitutional units may be used in combination.

Furthermore, in the present disclosure, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.

Furthermore, in the present disclosure, a combination of two or more preferred aspects is a more preferred aspect.

In addition, in the present disclosure, unless otherwise specified, each of the weight-average molecular weight (Mw) and number-average molecular weight (Mn) is a molecular weight that is detected using a gel permeation

chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

In the present disclosure, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

In the present disclosure, "excellent in printing durability" means the large number of sheets can be printed using the lithographic printing plate.

Hereinafter, the present disclosure will be described in detail.

(On-press development type lithographic printing plate precursor)

The on-press development type lithographic printing plate precursor according to the present disclosure (hereinafter, also simply referred to as "lithographic printing plate precursor") includes an image-recording layer on a support, in which the image-recording layer contains an infrared absorber A, a borate compound B, an iodonium compound C, and a color forming substance precursor D, and a surface free energy of an outermost layer on an image-recording layer side is 115 $mJ/m^2$ or less.

In the on-press development type lithographic printing plate precursor of the related art, in a case where the components in the image-recording layer containing the infrared absorber A, the borate compound B, the iodonium compound C, and the color forming substance precursor D are attached to a roll in a manufacturing coating machine, and the attachment attached onto the roll is re-attached to another part of the surface of the on-press development type lithographic printing plate precursor, the re-attached attachment may remain on the precursor surface even after on-press development to cause a development defect (on-press development defect, attachment of ink to a non-image area, and the like).

In particular, in the on-press development type lithographic printing plate precursor, a protective thick paper (hereinafter, also referred to as an "protector cardboard") is disposed above and below the laminated lithographic printing plate precursors to prevent the on-press development type lithographic printing plate precursor from being bent, deformed by external force, damaged, or the like. However, there is a problem that a development defect occurs because the on-press development type lithographic printing plate precursor are brought into direct contact with the protector cardboard or brought into indirect contact with the protector cardboard (in a case where an interleaving paper is disposed between the protector cardboard and the on-press development type lithographic printing plate precursor).

As a result of detailed studies, the present inventors have found that, in an on-press development type lithographic printing plate precursor having an image-recording layer containing an infrared absorber A, a borate compound B, an iodonium compound C, and a color forming substance precursor D, the above-described development defect occurs frequently.

The on-press development type lithographic printing plate precursor according to the present disclosure has an image-recording layer containing an infrared absorber A, a borate compound B, an iodonium compound C, and a color forming substance precursor D, in which since the surface free energy of the outermost layer on the image-recording layer side is 115 $mJ/m^2$ or less, attachment of a component in the image-recording layer to a roll in a manufacturing coating machine is suppressed. Then, the on-press development type lithographic printing plate precursor having excellent development defect suppressiveness is provided.

Hereinafter, each of the configuration requirements in the lithographic printing plate precursor according to the present disclosure will be specifically described.

<Surface free energy of outermost layer on image-recording layer side>

In the on-press development type lithographic printing plate precursor according to the present disclosure, the surface free energy of the outermost layer on the image-recording layer side is 115 $mJ/m^2$ or less, and from the viewpoint of development defect suppressiveness, is preferably in a range of 50 $mJ/m^2$ to 115 $mJ/m^2$, more preferably in a range of 60 $mJ/m^2$ to 100 $mJ/m^2$, still more preferably in a range of 70 $mJ/m^2$ to 90 $mJ/m^2$, and particularly preferably in a range of 75 $mJ/m^2$ to 85 $mJ/m^2$.

A measuring method of the surface free energy according to the present disclosure is shown as follows.

The surface free energy is calculated from a contact angle with pure water, diiodomethane, and n-hexadecane. Specifically, the contact angles of the measurement surface with pure water, diiodomethane, and n-hexadecane are

measured at 25°C, and $\gamma sv^d$, $\gamma sv^p$, and $\gamma sv^h$ are obtained by solving the following linear equation with three unknowns, and the sum thereof is defined as the surface free energy γs.

$$\sqrt{\gamma sv^{d} \gamma Lv^{d}} + \sqrt{\gamma sv^{p} \gamma Lv^{p}} + \sqrt{\gamma sv^{h} \gamma Lv^{h}} = \frac{\gamma_L (1+\cos\Theta)}{2}$$

$\gamma sv^d$: a surface free energy dispersion element of the measurement surface
$\gamma sv^p$: a surface free energy polarity element of the measurement surface
$\gamma sv^h$: a surface free energy hydrogen bond element of the measurement surface
$\gamma Lv^d$: a surface free energy dispersion element of the dropped liquid
$\gamma Lv^p$: a surface free energy polarity element of the dropped liquid
$\gamma Lv^h$: a surface free energy hydrogen bond element of the dropped liquid
$\theta$: a contact angle after 2 seconds from dropping

$$\gamma L = \gamma Lv^{d} + \gamma Lv^{p} + \gamma Lv^{h}$$

The surface free energy dispersion element, polarity element, and hydrogen bond element of pure water, diiodomethane, and n-hexadecane are shown below.

[Table 1]

| Dropped liquid | $\gamma Lv^d$ | $\gamma Lv^p$ | $\gamma Lv^h$ |
|---|---|---|---|
| Water | 29.1 | 1.3 | 42.4 |
| Diiodomethane | 46.8 | 4.0 | 0 |
| n-Hexadecane | 29.1 | 0 | 0 |

<Image-recording layer>

The image-recording layer contains an infrared absorber A, a borate compound B, an iodonium compound C, and a color forming substance precursor D.

The image-recording layer is preferably a negative tone image-recording layer and more preferably a water-soluble or water-dispersible negative tone image-recording layer.

In the lithographic printing plate precursor according to the present disclosure, from the viewpoint of on-press developability, a non-exposed portion of the image-recording layer is preferably removable by at least any of dampening water or printing ink.

Hereinafter, each of the components to be contained in the image-recording layer will be specifically described.

[Infrared absorber A]

The lithographic printing plate precursor according to the present disclosure contains, in the image-recording layer, an infrared absorber A (hereinafter, also simply referred to as an "infrared absorber").

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine colorant, a squarylium colorant, a pyrylium salt, a nickel thiolate complex, and an indolenine cyanine colorant are particularly preferable. Furthermore, for example, a cyanine colorant or an indolenine cyanine colorant is preferable. Among these, a cyanine colorant is particularly preferable.

The infrared absorber is preferably a cationic polymethine colorant having an oxygen or nitrogen atom at the meso-position. Preferred examples of the cationic polymethine colorant include a cyanine colorant, a pyrylium colorant, a thiopyrylium colorant, an azulenium colorant, and the like. From the viewpoint of ease of availability, solubility in a solvent during an introduction reaction, and the like, a cyanine colorant is preferable.

Specific examples of the cyanine colorant include the compounds described in paragraphs "0017" to "0019" of

JP2001-133969A and the compounds described in paragraphs "0016" to "0021" of JP2002-023360A and paragraphs "0012" to "0037" of JP2002-040638A. As the cyanine colorant, for example, the compounds described in paragraphs "0034" to "0041" of JP2002-278057A and paragraphs "0080" to "0086" of JP2008-195018A are preferable, and the compounds described in paragraphs "0035" to "0043" of JP2007-90850A and the compounds described in paragraphs "0105" to "0113" of JP2012-206495A are particularly preferable.

In addition, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to "0076" of JP2008-195018A are preferable.

The aforementioned infrared absorber preferably includes, for example, an infrared absorber that decomposes due to exposure to infrared (decomposition-type infrared absorber), and more preferably includes a decomposing and color-forming infrared absorber.

Presumably, in a case where a decomposition-type infrared absorber is used as the aforementioned infrared absorber, the infrared absorber or a decomposition product thereof may promote polymerization, and the decomposition product of the infrared absorber and the polymerizable compound may interact with each other, which may result in excellent printing durability.

The decomposition-type infrared absorber is preferably an infrared absorber that has a function of forming color by absorbing infrared and decomposing by exposure to infrared.

Hereinafter, a color-forming compound formed as a result of infrared absorption and decomposition of the decomposition-type infrared absorber by exposure to infrared rays will be also called "color forming substance of the decomposition-type infrared absorber".

In addition, it is preferable that the decomposition-type infrared absorber has a function of absorbing infrared rays by exposure to infrared rays and converting the absorbed infrared rays into heat.

The decomposition-type infrared absorber may be an infrared absorber that decomposes by absorbing at least a part of light in the infrared wavelength region (wavelength of 750 nm to 1 mm). The decomposition-type infrared absorber is preferably an infrared absorber having a maximal absorption wavelength in a wavelength region of 750 nm to 1,400 nm, and more preferably an infrared absorber having a maximal absorption wavelength in a wavelength region of 760 nm to 900 nm.

More specifically, the decomposition-type infrared absorber is preferably a compound that decomposes upon the exposure to infrared and generates a compound having maximal absorption wavelength in a wavelength region of 500 nm to 600 nm.

The decomposition-type infrared absorber is preferably an infrared absorber that decomposes by either or both of heat and electron migration resulting from exposure to infrared rays, and more preferably an infrared absorber that decomposes by electron migration resulting from exposure to infrared rays. "Decomposes by electron migration" mentioned herein means that electrons excited to the lowest unoccupied molecular orbital (LUMO) from the highest occupied molecular orbital (HOMO) of the decomposition-type infrared absorber by exposure to infrared rays move to electron accepting groups (groups having potential close to LUMO) in a molecule by means of intramolecular electron migration and thus result in decomposition.

As the infrared absorber and the infrared absorber that decomposes by exposure to infrared, those described in WO2020/262692A can also be suitably used.

As the infrared absorber that decomposes by exposure to infrared, those described in JP2008-544322A or WO2016/027886A can also be suitably used.

In addition, as the cyanine colorant which is a decomposition-type infrared absorber, the infrared absorbing compounds described in WO2019/219560A can be suitably used.

From the viewpoints of printing durability and halftone dot reproducibility, the highest occupied molecular orbital (HOMO) value of the infrared absorber used in the present disclosure is preferably -5.00 eV or less and more preferably -5.30 eV or less.

From the viewpoints of printing durability and halftone dot reproducibility, the lower limit of HOMO of the infrared absorber is preferably -5.90 eV or more, more preferably -5.75 eV or more, and even more preferably -5.60 eV or more.

In the present disclosure, the energy of molecular orbital (MO) such as the highest occupied molecular orbital (HOMO) and the lowest unoccupied molecular orbital (LUMO) is calculated by the following methods.

First, free counter ions in the compound as a calculation object are excluded from the calculation object. For example, for a cationic iodonium compound and a cationic infrared absorber, counteranions are excluded from the calculation object, and for an anionic borate compound, countercations are excluded from the calculation object. "Free" mentioned herein means that the compound as an object and the counter ions thereof are not covalently linked to each other.

The structural optimization is carried out by DFT (B3LYP/6-31G(d)) using quantum chemical calculation software Gaussian 16.

The MO energy is calculated by DFT (B3LYP/6-31+G(d,p)/PCM (solvent = methanol)) with the optimum structure

obtained by the structural optimization, using quantum chemical calculation software Gaussian 16. For an iodine-containing compound, the MO energy is calculated under the condition of DFT (B3LYP/DGDZVP/PCM (solvent = methanol)).

The optimum structure mentioned herein means a structure in which the total energy obtained by DFT calculation is the most stable. The most stable structure is found by repeating the structural optimization as necessary.

By the following formula, the MO energy Ebare (unit: hartree) obtained by the above-described MO energy calculation is converted into Escaled (unit: eV) used as the values of HOMO and LUMO in the present disclosure.

$$\text{[Calculation formula for HOMO] Escaled} = 0.823168 \text{ x } 27.2114 \text{ x Ebare} - 1.07634$$

$$\text{[Calculation formula for LUMO] Escaled} = 0.820139 \times 27.2114 \times \text{Ebare} - 1.086039$$

27.2114 is simply a coefficient for converting hartree into eV, and 0.823168 and -1.07634 used for calculating HOMO and 0.820139 and -1.086039 used for calculating UMO are adjustment coefficients. These are determined such that the calculated values of HOMO and LUMO of the compound as a calculation object match the measured values.

Only one infrared absorber may be used, or two or more infrared absorbers may be used in combination. In addition, as the infrared absorber, a pigment and a dye may be used in combination.

The total content of the infrared absorber in the image-recording layer with respect to the total mass of the image-recording layer is preferably 0.1% by mass to 10.0% by mass, and more preferably 0.5% by mass to 5.0% by mass.

[Borate compound B]

The image-recording layer contains a borate compound B (hereinafter, also simply referred to as a "borate compound").

The borate compound is preferably a tetraaryl borate compound B or a monoalkyltriaryl borate compound, from the viewpoint of compound stability, more preferably a tetraaryl borate compound, and particularly preferably a tetraphenyl borate compound.

The countercation that the borate compound has is not particularly limited, but is preferably an alkali metal ion or a tetraalkyl ammonium ion and more preferably a sodium ion, a potassium ion, or a tetrabutylammonium ion.

Specifically, preferred examples of the borate compound include sodium tetraphenyl borate.

From the viewpoints of chemical resistance and printing durability, the highest occupied molecular orbital (HOMO) of the borate compound B is preferably -6.00 eV or more, more preferably -5.95 eV or more, even more preferably -5.93 eV or more, and particularly preferably more than -5.90 eV

The upper limit of HOMO is preferably -5.00 eV or less and more preferably -5.40 eV or less.

Hereinafter, specifically, preferred examples of the borate compound B suitably include the electron-donating polymerization initiators described in WO2020/262692A.

In the image-recording layer, the HOMO value of the infrared absorber - the HOMO value of the borate compound preferably equals 0.70 eV or less.

Only one type of borate compound B may be added to the image-recording layer, or two or more types of borate compounds B may be used in combination.

The content of the borate compound B with respect to the total mass of the image-recording layer is preferably 0.01% by mass to 30% by mass, more preferably 0.05% by mass to 25% by mass, and even more preferably 0.1% by mass to 20% by mass.

In addition, one of the preferred aspects in the present disclosure is an aspect in which the iodonium compound C and the borate compound B form a salt.

Specific examples thereof include an iodonium borate compound of an iodonium ion and a borate anion (for example, a tetraphenylborate anion).

Specifically, suitable examples of aspects of the above iodonium borate compound include those described in WO2020/262692A.

[Iodonium compound C]

The image-recording layer in the present disclosure contains an iodonium compound C (hereinafter, also simply referred to as an "iodonium compound") as a polymerization initiator.

Among these, from the viewpoint of development defect suppressiveness, the iodonium compound C preferably contains two or more types of iodonium compounds, more preferably contains two types or three types of iodonium

compounds, and particularly preferably contains two types of iodonium compounds.

Specific examples of iodonium compound C will be shown below, but the present disclosure is not limited thereto.

As the iodonium compound C, for example, a diaryliodonium compound is preferable. Particularly, an electron-donating group, for example, a diphenyl iodonium salt compound substituted with an electron-donating group such as an alkyl group or an alkoxyl group is more preferable. In addition, an asymmetric diphenyl iodonium compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=hexafluorophosphate, and bis(4-t-butylphenyl)iodonium=hexafluorophosphate.

As a counteranion of the iodonium compound C, a sulfonamide anion or a sulfonimide anion is preferable, and a sulfonimide anion is more preferable.

As the sulfonamide anion, an aryl sulfonamide anion is preferable.

In addition, as the sulfonimide anion, a bisaryl sulfonimide anion is preferable.

Specifically, suitable examples of the sulfonamide anion and the sulfonimide anion include those described in WO2020/262692A.

From the viewpoint of improving sensitivity and making it difficult for plate missing to occur, the lowest unoccupied molecular orbital (LUMO) of the iodonium compound C is preferably -3.00 eV or less, and more preferably -3.02 eV or less.

The lower limit of LUMO is preferably -3.80 eV or more and more preferably -3.60 eV or more.

The iodonium compound C may be used alone or in combination of two or more types thereof.

The content of the iodonium compound C with respect to the total mass of the image-recording layer is preferably 0.1% by mass to 50% by mass, more preferably 0.5% by mass to 30% by mass, and particularly preferably 0.8% by mass to 20% by mass.

[Relationship among infrared absorber A, borate compound B, and iodonium compound C]

In the image-recording layer of the present disclosure, HOMO of the borate compound B is preferably -6.0 eV or more, and LUMO of the iodonium compound C is preferably -3.0 eV or less.

More preferred aspects of HOMO of the borate compound B and LUMO of the iodonium compound C are as described above.

Presumably, in the image-recording layer of the present disclosure, energy transfer may occur among the borate compound B, the infrared absorber A, and the iodonium compound C.

Accordingly, it is considered that in a case where HOMO of the borate compound B is -6.0 eV or more and LUMO of the iodonium compound C is -3.0 eV or less, radicals may be more efficiently generated, which may facilitate further improvement of chemical resistance and printing durability.

From the viewpoints of printing durability and chemical resistance, the HOMO value of the infrared absorber A - the HOMO value of the borate compound B is preferably 1.0 eV or less, more preferably 0.70 eV or less, and particularly preferably 0.60 eV or less. In addition, from the same viewpoints as above, the HOMO value of the infrared absorber A - the HOMO value of the borate compound B is preferably -0.200 eV or more and more preferably -0.100 eV or more. The negative value means that HOMO of the borate compound B is higher than HOMO of the infrared absorber A.

In addition, from the viewpoints of printing durability and chemical resistance, the LUMO value of the iodonium compound C - the LUMO value of the infrared absorber A is preferably 1.00 eV or less and more preferably 0.700 eV or less. Furthermore, from the same viewpoints as above, the LUMO value of the iodonium compound C - the LUMO value of the infrared absorber A is preferably -0.200 eV or more and more preferably -0.100 eV or more.

In addition, from the same viewpoints as above, the LUMO value of the iodonium compound C - the LUMO value of the infrared absorber A is preferably in a range of 1.00 eV to -0.200 eV and more preferably in a range of 0.700 eV to -0.100 eV The negative value means that LUMO of the infrared absorber A is higher than LUMO of the iodonium compound C.

[Color forming substance precursor D]

From the viewpoint of visibility, the image-recording layer contains a color forming substance precursor D (hereinafter, also simply referred to as a "color forming substance precursor").

From the viewpoint of color formability, the color forming substance precursor preferably includes an acid color forming agent. In addition, from the viewpoint of color formability, the color forming substance precursor preferably includes a leuco compound.

"Color forming substance precursor" used in the present disclosure means a compound having properties that form color by a stimulus such as light or acid and thus change the color of the image-recording layer. Furthermore, "acid

color forming agent" means a compound having properties that form color by being heated in a state of receiving an electron accepting compound (for example, a proton of an acid or the like) and thus change the color of the image-recording layer. The acid color forming agent is particularly preferably a colorless compound which has a partial skeleton such as lactone, lactam, sultone, spiropyran, an ester, or an amide and allows such a partial skeleton to rapidly open the ring or to be cleaved when coming into contact with an electron-accepting compound.

From the viewpoint of UV printing durability, the hydrogen abstraction enthalpy of all hydrogen atoms present in a molecule of the color forming substance precursor is preferably -6.5 kcal/mol or more, more preferably -4.0 kcal/mol or more, even more preferably -2.0 kcal/mol or more, and particularly preferably -2.0 kcal/mol to 50 kcal/mol.

The higher the hydrogen abstraction enthalpy, the further the hydrogen atoms are inhibited from being abstracted from the color forming substance precursor by a polymerization initiation species such as radicals, and the further the polymerization reaction is prolonged. Therefore, curability is excellent, and printing durability, particularly, UV printing durability is further improved.

In the present disclosure, the hydrogen abstraction enthalpy of all hydrogen atoms presents in a molecule of the color forming substance precursor is calculated by the following method.

Regarding a reaction with propagating radicals caused by hydrogen abstraction, the enthalpy of each of the reactant and product is calculated using Gaussian 16 as a calculation program at a calculation level of density functional theory (B3LYP/6-31+G**). The solvent effect (solvent: methanol) is examined by the SCRF method. By finding the difference in the enthalpy between the reactant and the product, a reaction enthalpy is calculated.

More specifically, the hydrogen abstraction enthalpy is calculated as follows. In the following chemical reaction formula, for each of the propagating radical, LeucoDye-H, the hydrogenated propagating radical, and LeucoDye-radical, modeling is carried out using Gaussian pre/post software GaussView6. #p opt b3lyp/6-31+g (d, p) scrf = (solvent = methanol) is specified as a calculation condition, charge 0 multiplicity 2 is set for the radical, and charge 0 multiplicity 1 is set for substances other than the radical. #p is specified for detailed logging output, and may not be specified.

From the energy (unit: hartree) of the structure optimized by performing calculation, the enthalpy of formation of the reactant (sum of the energy of the propagating radical and LeucoDye-H) and the enthalpy of formation of the product (sum of the energy of the hydrogenated propagating radical and LeucoDye-radical) are calculated. The enthalpy of formation of the reactant is subtracted from the enthalpy of formation of the product, and the result is adopted as the hydrogen abstraction enthalpy. The unit is converted as 1 hartree = 627.51 kcal/mol.

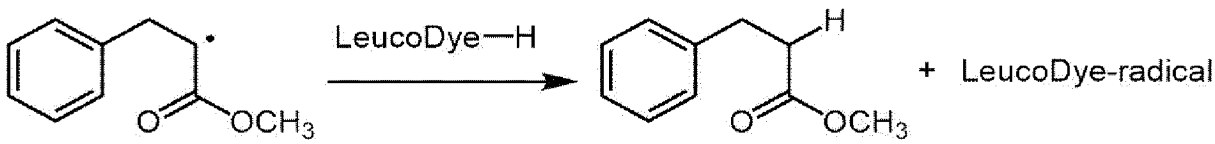


For example, the hydrogen abstraction enthalpy for each hydrogen atom of the following compound is as follows.

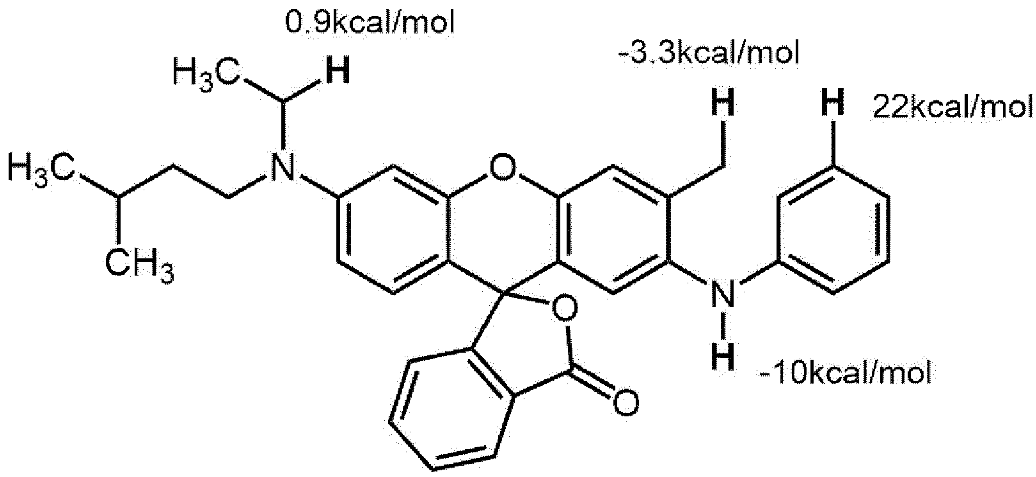


From the viewpoint of UV printing durability, it is preferable that the color forming substance precursor does not have a structure in which a hydrogen atom is directly bonded to a nitrogen atom.

The structure in which a hydrogen atom is directly bonded to a nitrogen atom (N-H structure) is a structure in which a hydrogen abstraction reaction is likely to occur by a radical or the like. In a case where the color forming substance precursor is a compound that does not have such a structure, the hydrogen atom abstraction from the color forming

substance precursor is inhibited, and the polymerization reaction is prolonged. Therefore, excellent curability is obtained, and printing durability, particularly, UV printing durability is further improved.

Particularly, from the viewpoint of color formability, the color forming agent used in the present disclosure is preferably at least one type of compound selected from the group consisting of a spiropyran compound, a spirooxazine compound, a spirolactone compound, and a spirolactam compound.

From the viewpoint of visibility, the hue of the colorant after color forming is preferably green, blue, or black.

From the viewpoints of color formability and visibility, the acid color forming agent preferably includes a leuco colorant.

The aforementioned leuco colorant is not particularly limited as long as it has a leuco structure. The leuco colorant preferably has a spiro structure, and more preferably has a spirolactone ring structure.

From the viewpoint of color formability and visibility of exposed portions, the leuco colorant is preferably a leuco colorant having a phthalide structure or a fluoran structure.

Furthermore, from the viewpoint of color formability and visibility of exposed portions, the leuco colorant having a phthalide structure or a fluoran structure is preferably a compound represented by any of Formula (Le-1) to Formula (Le-3), and more preferably a compound represented by Formula (Le-2).

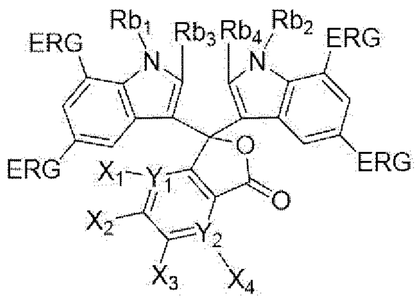
(Le - 1)

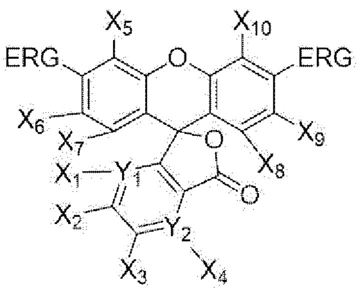
(Le - 2)

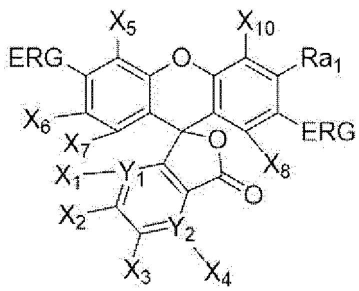
(Le - 3)

In Formula (Le-1) to Formula (Le-3), ERG's each independently represent an electron-donating group, $X_1$ to $X_4$ each independently represent a hydrogen atom, a halogen atom, or dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

From the viewpoints of color formability and visibility of exposed portions, the electron-donating group represented by ERG in Formula (Le-1) to Formula (Le-3) is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, or an aryloxy group, even more preferably a monoalkyl monoarylamino group, a diarylamino group, a diheteroarylamino group, or a monoaryl monoheteroarylamino group, and particularly preferably a monoalkyl monoarylamino group.

From the viewpoints of color formability and visibility of exposed portions, the electron-donating group represented by ERG is preferably a disubstituted amino group having an aryl group that has a substituent on at least one ortho position or a heteroaryl group that has a substituent on at least one ortho position, more preferably a disubstituted amino group having a phenyl group having a substituent on at least one ortho position and an electron-donating group at a para position, even more preferably an amino group having a phenyl group having a substituent on at least one ortho position and an electron-donating group at a para position, and an aryl group or a heteroaryl group, and particularly preferably an amino group having a phenyl group having a substituent on at least one ortho position and an electron-donating group at a para position, and an aryl group having an electron-donating group or a heteroaryl group having an electron-donating group.

In the present disclosure, in a case where a bonding position of an aryl group or a heteroaryl group with other structures is defined as position 1, the ortho position in the aryl group or heteroaryl group other than a phenyl group is called a bonding position (for example, position 2 or the like) adjacent to the position 1.

Furthermore, from the viewpoints of color formability and visibility of exposed portions, the electron-donating group that the aryl group or heteroaryl group has is preferably an amino group, an alkylamino group, an arylamino group, a

heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoints of color formability and visibility of exposed portions, $X_1$ to $X_4$ in Formula (Le-1) to Formula (Le-3) each independently are preferably a hydrogen atom or a chlorine atom, and more preferably each independently represent a hydrogen atom.

From the viewpoints of color formability and visibility of exposed portions, $X_5$ to $X_{10}$ in Formula (Le-2) or Formula (Le-3) each independently are preferably a hydrogen atom, a halogen atom, an alkyl group, an aryl group, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an alkoxycarbonyl group, an aryloxycarbonyl group, a heteroaryloxycarbonyl group, or a cyano group, more preferably a hydrogen atom, a halogen atom, an alkyl group, an aryl group, an alkoxy group, or an aryloxy group, even more preferably a hydrogen atom, a halogen atom, an alkyl group, or an aryl group, and particularly preferably a hydrogen atom.

From the viewpoints of color formability and visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoints of color formability and visibility of exposed portions, $Ra_1$ in Formula (Le-1) to Formula (Le-3) is preferably an alkyl group or an alkoxy group, more preferably an alkoxy group, and particularly preferably a methoxy group.

From the viewpoints of color formability and visibility of exposed portions, $Rb_1$ to $Rb_4$ in Formula (Le-1) to Formula (Le-3) preferably each independently represent a hydrogen atom or an alkyl group, more preferably each independently represent an alkyl group, and particularly preferably each independently represent a methyl group.

In addition, from the viewpoints of color formability and visibility of exposed portions, the leuco colorant having a phthalide structure or a fluoran structure is more preferably a compound represented by any of Formula (Le-4) to Formula (Le-6), and even more preferably a compound represented by Formula (Le-5).

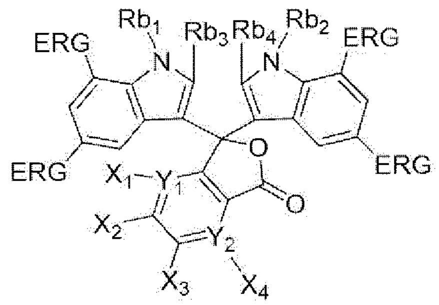
(Le - 4)

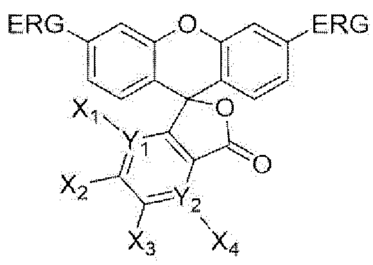
(Le - 5)

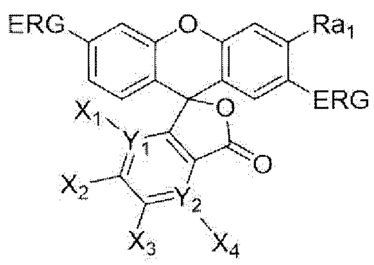
(Le - 6)

In Formula (Le-4) to Formula (Le-6), ERG's each independently represent an electron-donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent a hydrogen atom, an alkyl group, an aryl group, or a heteroaryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

Furthermore, from the viewpoints of color formability and visibility of exposed portions, the leuco colorant having a phthalide structure or a fluoran structure is even more preferably a compound represented by any of Formula (Le-7) to Formula (Le-9), and particularly preferably a compound represented by Formula (Le-8).

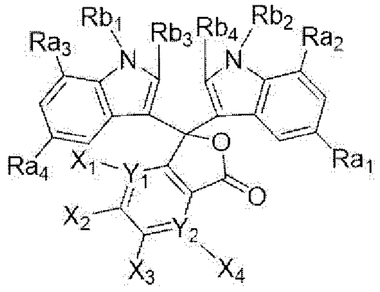

( Le - 7 )

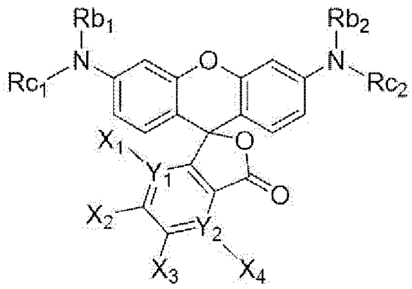

( Le - 8 )

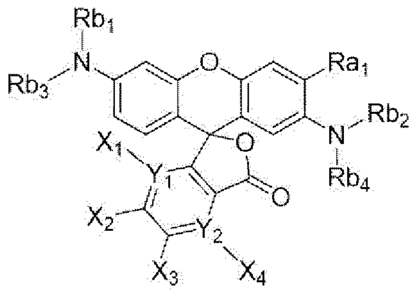

( Le - 9 )

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent a hydrogen atom, an alkyl group, an aryl group, or a heteroaryl group, and $Rc_1$ and $Rc_2$ each independently represent an aryl group or a heteroaryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoints of color formability and visibility of exposed portions, $Ra_1$ to $Ra_4$ in Formula (Le-7) or Formula (Le-9) each independently are preferably an alkyl group or an alkoxy group, more preferably an alkoxy group, and particularly preferably represent a methoxy group.

From the viewpoints of color formability and visibility of exposed portions, $Rb_1$ to $Rb_4$ in Formula (Le-7) to Formula (Le-9) each independently are preferably a hydrogen atom, an alkyl group, or an aryl group substituted with an alkoxy group, more preferably an alkyl group, and particularly preferably a methyl group.

From the viewpoints of color formability and visibility of exposed portions, $Rc_1$ and $Rc_2$ in Formula (Le-8) each independently are preferably a phenyl group or an alkylphenyl group, and more preferably a phenyl group.

From the viewpoints of color formability and visibility of exposed portions, $Rc_1$ and $Rc_2$ in Formula (Le-8) each independently are preferably an aryl group having a substituent on at least one ortho position or a heteroaryl group having a substituent on at least one ortho position, more preferably an aryl group having a substituent on at least one ortho position, even more preferably a phenyl group having a substituent on at least one ortho position, and particularly preferably a phenyl group having a substituent on at least one ortho position and having an electron-donating group at the para position. Examples of the substituent in $Rc_1$ and $Rc_2$ include substituents that will be described later.

In Formula (Le-8), from the viewpoints of color formability and visibility of exposed portions, it is preferable that $X_1$ to $X_4$ are a hydrogen atom, and $Y_1$ and $Y_2$ are C.

Furthermore, from the viewpoints of color formability and visibility of exposed portions, in Formula (Le-8), $Rb_1$ and $Rb_2$ each independently are preferably an alkyl group or an aryl group substituted with an alkoxy group.

Furthermore, from the viewpoints of color formability and visibility of exposed portions, in Formula (Le-8), $Rb_1$ and $Rb_2$ each independently are preferably an aryl group or a heteroaryl group, more preferably an aryl group, even more preferably an aryl group having an electron-donating group, and particularly preferably a phenyl group having an electron-donating group at the para position.

From the viewpoints of color formability and visibility of exposed portions, the electron-donating group in $Rb_1$, $Rb_2$, $Rc_1$, and $Rc_2$ is preferably an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, an alkoxy group, an aryloxy group, a heteroaryloxy group, or an alkyl group, more preferably an alkoxy group, an aryloxy group, a heteroaryloxy group, or an alkyl group, and particularly preferably an alkoxy group.

From the viewpoint of color formability and visibility of exposed portions, the acid color forming agent preferably includes a compound represented by Formula (Le-10).

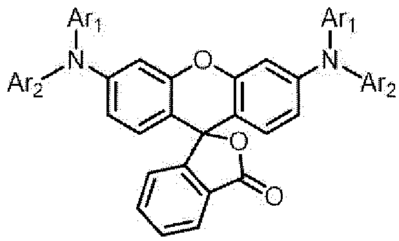

( Le - 10 )

In Formula (Le-10), $Ar_1$'s each independently represent an aryl group or a heteroaryl group, and $Ar_2$'s each independently represent an aryl group having a substituent on at least one ortho position or a heteroaryl group having a substituent on at least one ortho position.

Ari in Formula (Le-10) has the same definition as $Rb_1$ and $Rb_2$ in Formula (Le-7) to Formula (Le-9), and preferred aspects thereof are also the same.

$Ar_2$ in Formula (Le-10) has the same definition as $Rc_1$ and $Rc_2$ in Formula (Le-7) to Formula (Le-9), and preferred aspects thereof are also the same.

From the viewpoint of color formability and visibility of exposed portions, the acid color forming agent preferably includes a compound represented by Formula (Le-11).

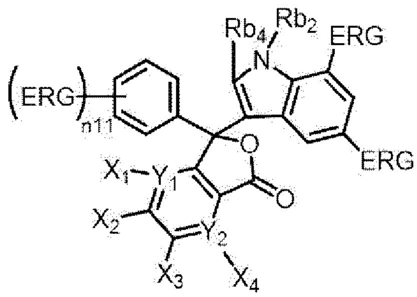

( Le - 11 )

In Formula (Le-11), ERG each independently represent an electron-donating group, n11 represents an integer of 1 to 5, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_2$ and $Rb_4$ each independently represent a hydrogen atom, an alkyl group, an aryl group, or a heteroaryl group.

ERG, $X_1$ to $X_4$, $Y_1$, $Y_2$, $Ra_1$, $Rb_2$, and $Rb_4$ in Formula (Le-11) have the same definitions as ERG, $X_1$ to $X_4$, $Y_1$, $Y_2$, $Ra_1$, $Rb_2$, and $Rb_4$ in Formula (Le-1) to Formula (Le-3) respectively, and preferred aspects thereof are also the same.

n 11 in Formula (Le-11) is preferably an integer of 1 to 3, and more preferably 1 or 2.

The alkyl group in Formula (Le-1) to Formula (Le-9) or Formula (Le-11) may be linear or branched or may have a ring structure.

The number of carbon atoms in the alkyl group in Formula (Le-1) to Formula (Le-9) or Formula (Le-11) is preferably 1 to 20, more preferably 1 to 8, even more preferably 1 to 4, and particularly preferably 1 or 2.

The number of carbon atoms in the aryl group in Formula (Le-1) to Formula (Le-11) is preferably 6 to 20, more preferably 6 to 10, and particularly preferably 6 to 8.

Specific examples of the aryl group in Formula (Le-1) to Formula (Le-11) include a phenyl group, a naphthyl group, an anthracenyl group, a phenanthrenyl group, and the like which may have a substituent.

Specific examples of the heteroaryl group in Formula (Le-1) to Formula (Le-11) include a furyl group, a pyridyl group, a pyrimidyl group, a pyrazoyl group, a thiophenyl group, and the like which may have a substituent.

Each of the groups in Formula (Le-1) to Formula (Le-11), such as a monovalent organic group, an alkyl group, an aryl group, a heteroaryl group, a dialkylanilino group, an alkylamino group, and an alkoxy group, may have a substituent. Examples of the substituent include an alkyl group, an aryl group, a heteroaryl group, a halogen atom, an amino group, an alkylamino group, an arylamino group, a heteroarylamino group, a dialkylamino group, a monoalkyl monoarylamino group, a monoalkyl monoheteroarylamino group, a diarylamino group, a diheteroarylamino group, a monoaryl monoheteroarylamino group, a hydroxy group, an alkoxy group, an aryloxy group, a heteroaryloxy group, an acyl group, an

alkoxycarbonyl group, an aryloxycarbonyl group, a heteroaryloxycarbonyl group, a cyano group, and the like. In addition, these substituents may be further substituted with these substituents.

As the color forming substance precursor to be used, for example, the following compounds are suitable. Me represents a methyl group, Et represents an ethyl group, Oct represents an octyl group, and Ph represents a phenyl group.

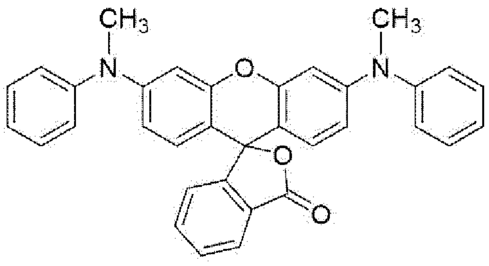

S - 1

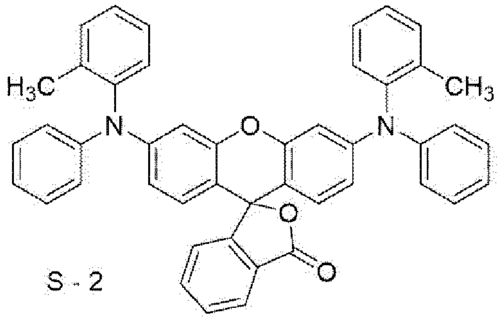

S - 2

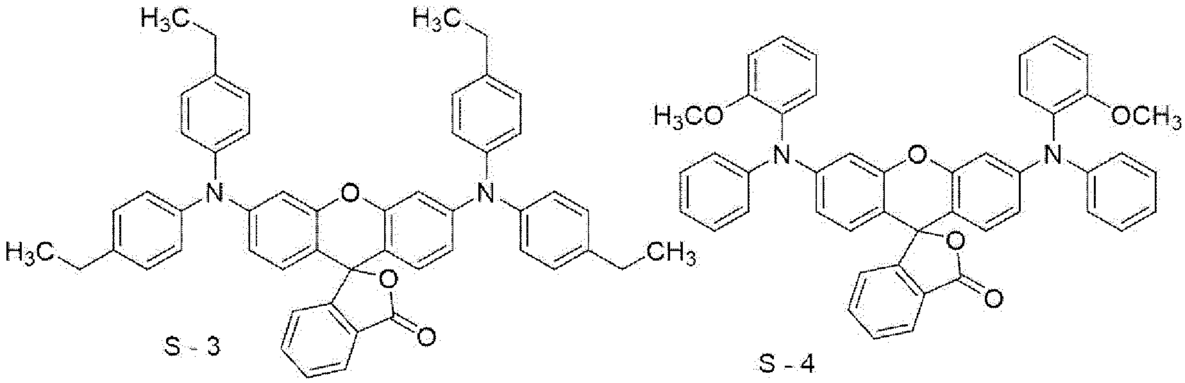

S - 3

S - 4

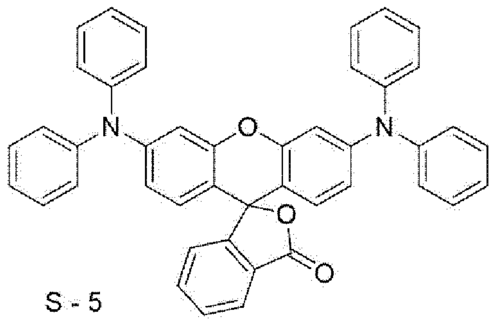

S - 5

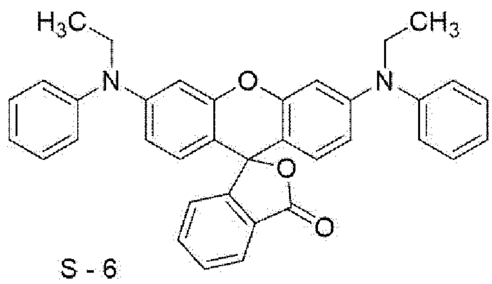

S - 6

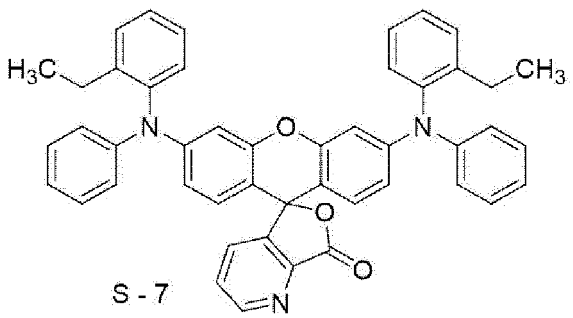

S - 7

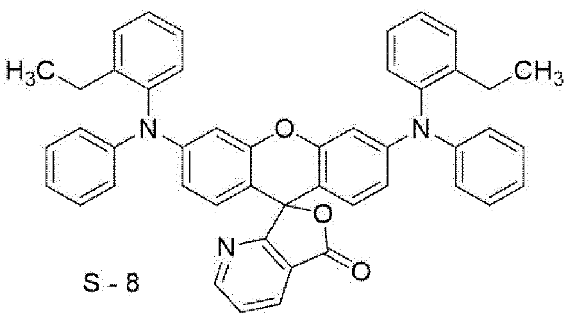

S - 8

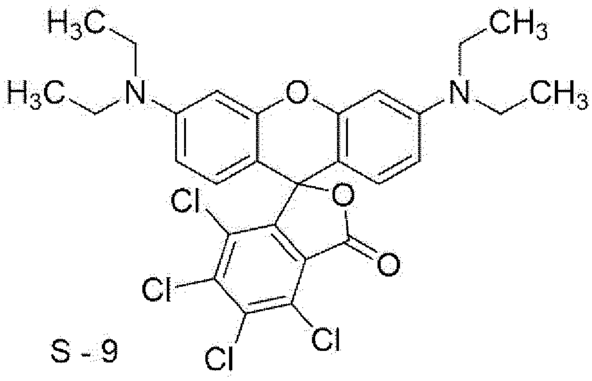

S - 9

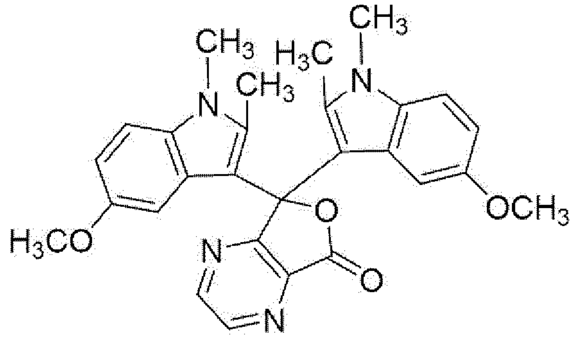

S - 10

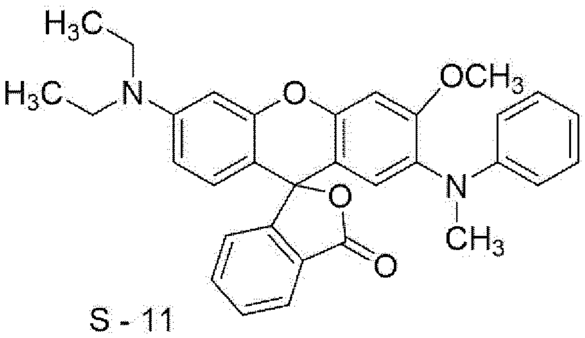

S - 11

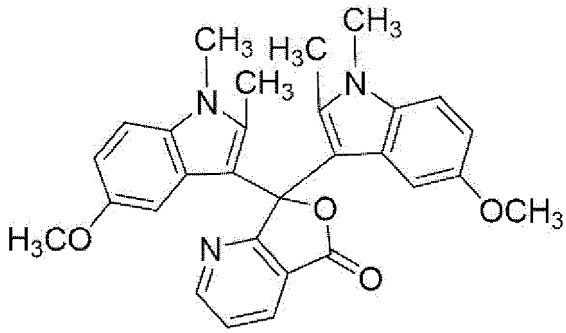

S - 12

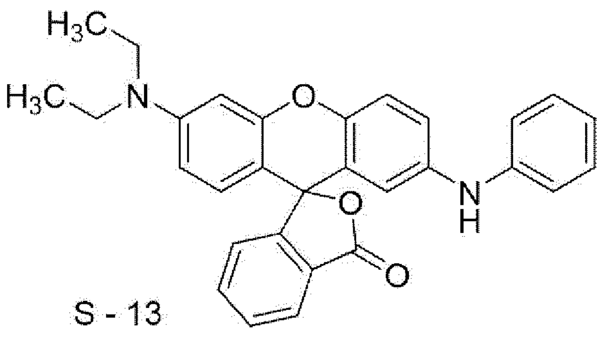

S - 13

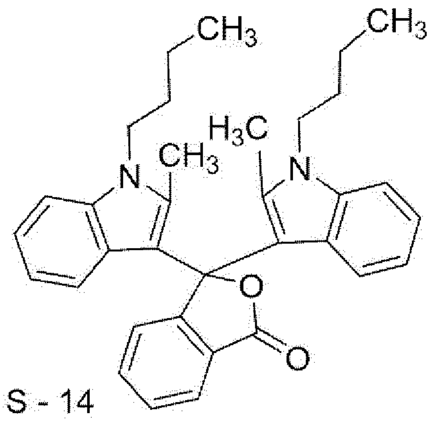

S - 14

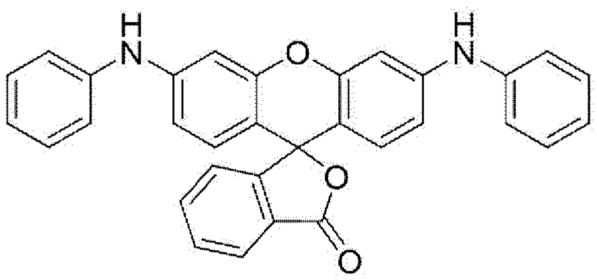

S - 15

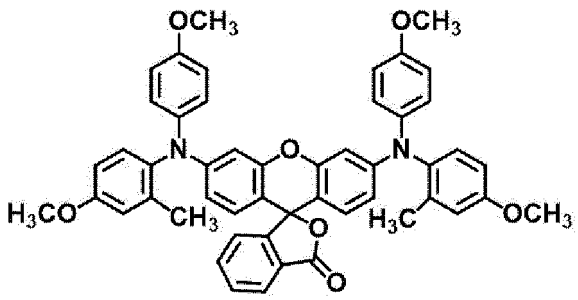

S - 16

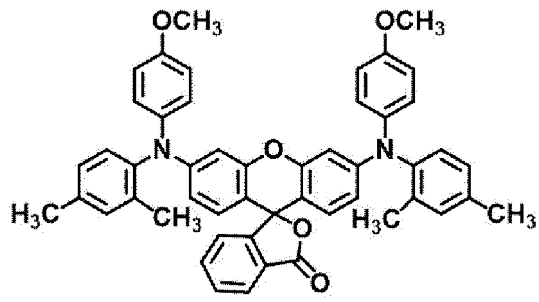

S - 17

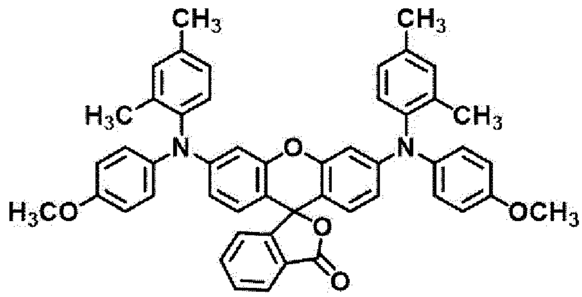

S - 18

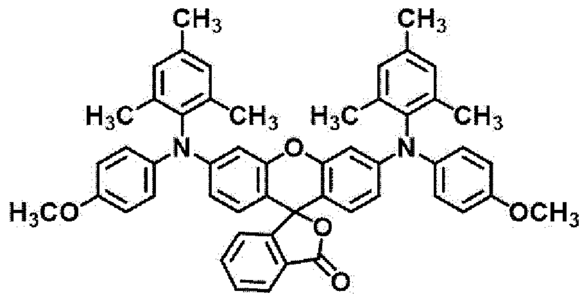

S - 19

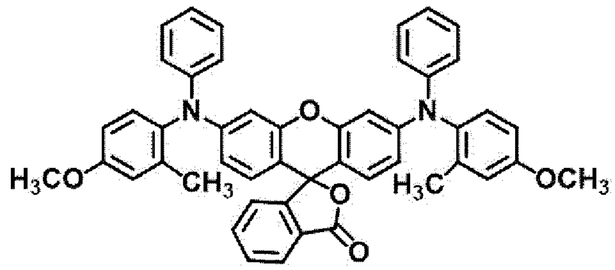

S - 20

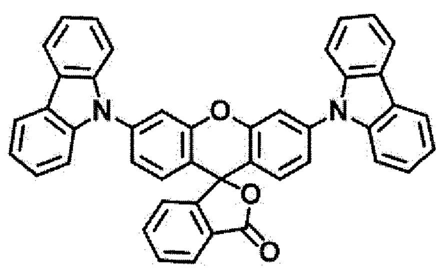

S - 21

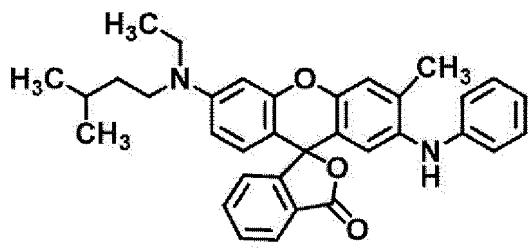

S - 22

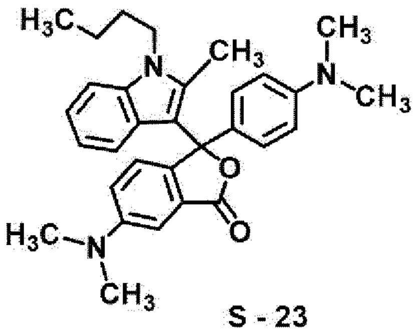

**S - 23**

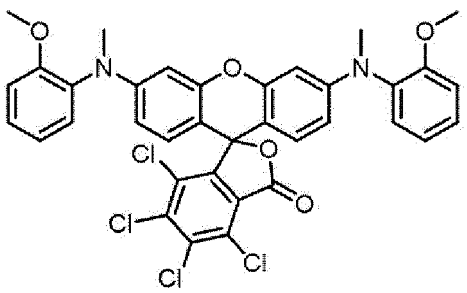

S - 24

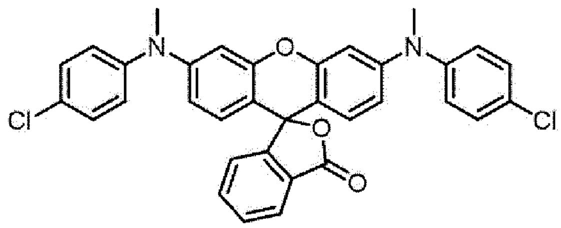

S - 25

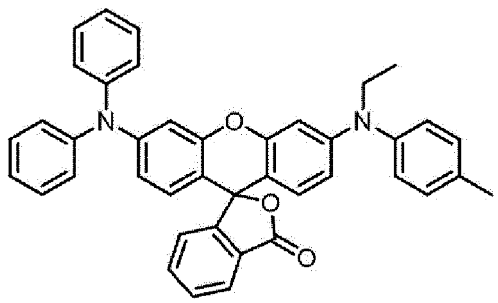

S - 26

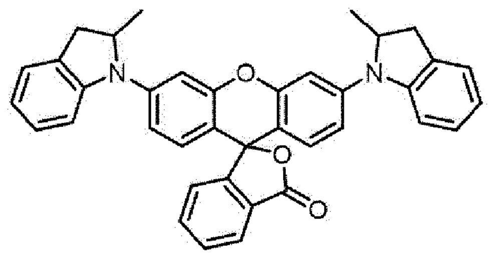

S - 27

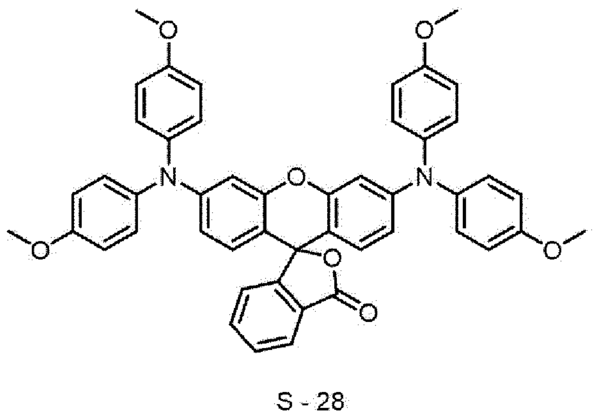

S - 28

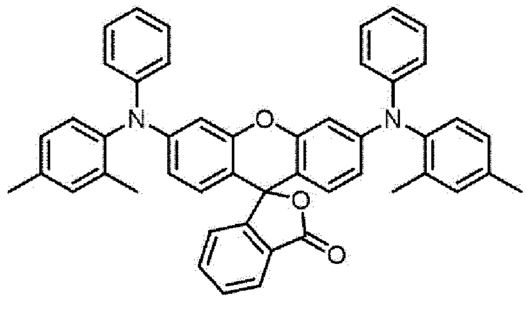

S - 29

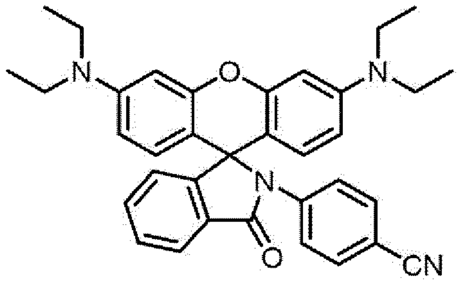

S - 30

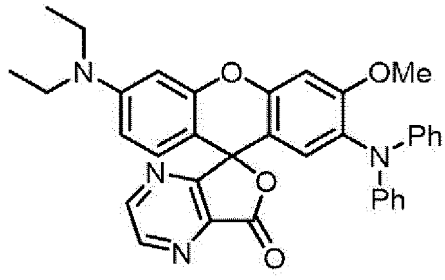

S - 31

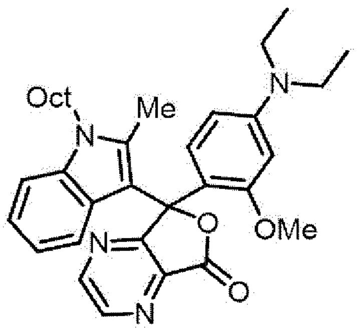

S - 32

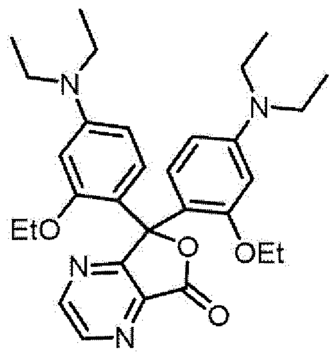

S - 33

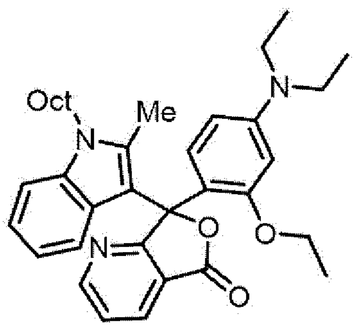

S - 34

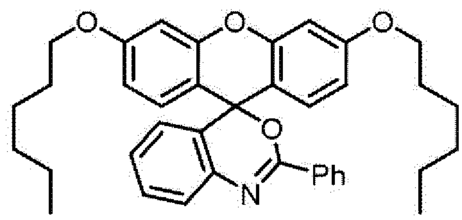

S - 35

As the color forming agent, a commercially available product can be used, and examples thereof include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by HODOGAYA CHEMICAL CO.,LTD.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals Inc.), and Crystal Violet Lactone (manufactured by Tokyo Chemical Industry Co., Ltd.), and the like. Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet lactone are preferable because these form a film having excellent visible light absorbance.

From the viewpoint of visibility, a molar absorption coefficient ε of a color forming substance generated from the color forming substance precursor is preferably 35,000 or more, more preferably 35,000 or more and 200,000 or less, and particularly preferably 50,000 or more and 150,000 or less.

In the present disclosure, the molar absorption coefficient ε of the color forming substance generated from the color forming substance precursor is measured by the following method.

The color forming substance precursor to be measured is weighed (0.04 mmol) and put in a 100 mL volumetric flask.

Acetic acid (about 90 mL) is added thereto. After it is visually confirmed that the measurement sample has completely dissolved,

acetic acid is added thereto such that the volume increases up to 100 mL, thereby preparing a dye solution A.

Acetic acid (about 80 mL) is added to another 100 mL volumetric flask, 5 mL of ion exchanged water and 5 mL of the dye solution A are then added thereto by using a 5 mL transfer pipette, and the solution is gently shaken.

After it is visually confirmed that the solution has no precipitate of the color forming substance precursor, acetic acid is added thereto so that the volume increases up to 100 mL, thereby preparing a dye solution B. In the dye solution B, the concentration of the color forming substance precursor is 0.02 mmol/L.

A measurement cell (quartz glass, optical path width: 10 mm) is filled with the dye solution B, and the solution is measured using an ultraviolet-visible spectrophotometer (UV-1800, manufactured by Shimadzu Corporation.).

As a blank, a solution of water:acetic acid = 5:95 is used.

From the obtained spectrum, the maximal absorption wavelength in the visible light region (380 nm to 750 nm) is read. From the absorbance at the wavelength, the molar absorption coefficient $\varepsilon$ is calculated.

From the viewpoint of visibility, a ring-opening ratio of the color forming substance precursor calculated by the following equation is preferably 15% or more and 100% or less, more preferably 40% or more and 99% or less, even more preferably 60% or more and 99% or less, particularly preferably 75% or more and 99% or less, and most preferably 85% or more and 99% or less.

Ring-opening ratio = molar absorption coefficient of the color forming substance obtained in case of adding 1 molar equivalent of acid to the color forming substance precursor/molar absorption coefficient $\varepsilon$ of the color forming substance generated from the color forming substance precursor $\times$ 100

From the viewpoint of visibility, in the visible light region (380 nm to 750 nm), the maximum absorption wavelength $\lambda$max of the color forming substance generated from the color forming substance precursor is preferably 500 nm to 650 nm, more preferably 520 nm to 600 nm, even more preferably 530 nm to 580 nm, and particularly preferably 540 nm to 570 nm.

In the present disclosure, the ring-opening ratio and $\lambda$max are measured by the following methods.

-Preparation of dye solution C-

The color forming substance precursor is weighed (0.1 mmol) and put in a 50 mL volumetric flask.

About 40 mL of acetonitrile is added thereto. After it is visually confirmed that the measurement sample has completely dissolved, acetonitrile is added thereto such that the volume increases up to 50 mL, thereby preparing a dye solution C.

-Preparation of acid solution D-

0.2 mmol of 10-camphorsulfonic acid (CSA) is added to a 100 mL volumetric flask, and about 80 mL of acetonitrile is added thereto. After it is confirmed that CSA has completely dissolved, acetonitrile is added thereto such that the volume increases up to 100 mL, thereby preparing an acid solution D.

-Preparation of measurement solution E-

5 mL of ion exchanged water is added to a 100 mL volumetric flask by using a transfer pipette, and 80 mL of acetonitrile is added thereto. 1 mL of the dye solution C and 1 mL of the acid solution D are added thereto, and the volume increases up to 100 mL, thereby preparing a measurement solution E.

In the measurement E, the concentration of the color forming substance precursor including the generated color forming substance is 0.02 mmol/L.

A measurement cell (quartz glass, optical path width: 10 mm) is filled with the dye solution E, and the solution is measured using an ultraviolet-visible spectrophotometer (UV-1800, manufactured by Shimadzu Corporation.).

As a blank, a solution of water: acetonitrile = 5:95 is used.

From the obtained spectrum, the maximal absorption wavelength $\lambda$max in the visible light region (380 nm to 750 nm) is read. From the absorbance at the wavelength, the molar absorption coefficient $\varepsilon$ is calculated.

The ring-opening ratio is calculated according to the following equation.

Ring-opening ratio = molar absorption coefficient of the color forming substance obtained in case of adding 1 molar equivalent of acid to the color forming substance precursor/molar absorption coefficient $\varepsilon$ of the color forming substance generated from the color forming substance precursor $\times$ 100

One of these color forming substance precursors may be used alone, or two or more of these components can be used in combination.
The content of the color forming substance precursor with respect to the total mass of the image-recording layer is preferably 0.5% by mass to 10% by mass, and more preferably 1% by mass to 5% by mass.

[Polymerizable compound]

It is preferable that the image-recording layer in the present disclosure contain a polymerizable compound.
In the present disclosure, a polymerizable compound refers to a compound having a polymerizable group.
The polymerizable group is not particularly limited, may be a known polymerizable group, and is preferably an ethylenically unsaturated group. In addition, the polymerizable group may be a radically polymerizable group or a cationically polymerizable group, and is preferably a radically polymerizable group.
Examples of the radically polymerizable group include a (meth)acryloyl group, an allyl group, a vinylphenyl group, a vinyl group, and the like. From the viewpoint of reactivity, a (meth)acryloyl group is preferable.
The molecular weight of the polymerizable compound (weight-average molecular weight in a case where the polymerizable compound has molecular weight distribution) is preferably 50 or more and less than 2,500.
The polymerizable compound used in the present disclosure may be, for example, a radically polymerizable compound or a cationically polymerizable compound, and is preferably an addition polymerizable compound having at least one ethylenically unsaturated bond (ethylenically unsaturated compound).
The ethylenically unsaturated compound is preferably a compound having at least one terminal ethylenically unsaturated bond, and more preferably a compound having two or more terminal ethylenically unsaturated bonds. The chemical form of the polymerizable compound is, for example, a monomer, a prepolymer that is a dimer, a trimer, or an oligomer, a mixture of these, or the like.
Particularly, from the viewpoint of printing durability, the polymerizable compound preferably includes a polymerizable compound having functionalities of 3 or more, more preferably includes a polymerizable compound having functionalities of 7 or more, and even more preferably includes a polymerizable compound having functionalities of 10 or more. In addition, from the viewpoint of printing durability of the lithographic printing plate to be obtained, the polymerizable compound preferably includes an ethylenically unsaturated compound having functionalities of 3 or more (preferably having functionalities of 7 or more and more preferably having functionalities of 10 or more), and more preferably includes a (meth)acrylate compound having functionalities of 3 or more (preferably having functionalities of 7 or more and more preferably having functionalities of 10 or more).
From the viewpoints of on-press developability and contamination suppressiveness, the polymerizable compound preferably includes a polymerizable compound having functionalities of 2 or less, more preferably includes a difunctional polymerizable compound, and particularly preferably includes a difunctional (meth)acrylate compound.
From the viewpoints of printing durability, on-press developability, and contamination suppressiveness, the content of the polymerizable compound having functionalities of 2 or less (preferably a difunctional polymerizable compound) with respect to the total mass of polymerizable compounds in the image-recording layer is preferably 5% by mass to 100% by mass, more preferably 10% by mass to 100% by mass, and particularly preferably 15% by mass to 100% by mass.

-Oligomer-

As the polymerizable compound contained in the image-recording layer, it is preferable that a polymerizable compound which is an oligomer (hereinafter, also simply called "oligomer") is contained.
In the present disclosure, an oligomer represents a polymerizable compound which has a molecular weight (weight-average molecular weight in a case where the compound has molecular weight distribution) of 600 or more and 40,000 or less and contains at least one polymerizable group.
From the viewpoints of excellent chemical resistance and excellent printing durability, the molecular weight of the oligomer is preferably 1,000 or more and 25,000 or less.
In addition, from the viewpoint of improving printing durability, the number of polymerizable groups in one molecule of the oligomer is preferably 2 or more, more preferably 3 or more, even more preferably 6 or more, and particularly preferably 10 or more.
The upper limit value of the polymerizable groups in the oligomer is not particularly limited, but the number of

polymerizable groups is preferably 20 or less.

From the viewpoints of printing durability and on-press developability, an oligomer having 7 or more polymerizable groups and a molecular weight of 1,000 or more and 40,000 or less is preferable, and an oligomer having 7 or more and 20 or less polymerizable groups and a molecular weight of 1,000 or more and 25,000 or less is more preferable.

The oligomer may contain a polymer component which is likely to be generated in the process of manufacturing the oligomer.

From the viewpoints of printing durability, visibility, and on-press developability, the oligomer preferably has at least one selected from the group consisting of a compound having a urethane bond, a compound having an ester bond, and a compound having an epoxy residue, and preferably has a compound having a urethane bond.

In the present disclosure, an epoxy residue refers to a structure formed of an epoxy group and for example, means a structure similar to a structure obtained by the reaction between an acid group (carboxylic acid group or the like) and an epoxy group.

As the compound having a urethane bond, those described in WO2020/262692A can be suitably used.

As the compound having a urethane bond, a compound may also be used which is prepared by obtaining polyurethane by a reaction between a polyisocyanate compound and a polyol compound and introducing a polymerizable group into the obtained polyurethane by a polymer reaction.

For example, the compound having a urethane bond may be obtained by reacting a polyol compound having an acid group with a polyisocyanate compound to obtain a polyurethane oligomer and reacting the obtained polyurethane oligomer with a compound having an epoxy group and a polymerizable group.

The number of polymerizable groups in the compound having an ester bond, which is an example of oligomer, is preferably 3 or more, and more preferably 6 or more.

As the compound having an epoxy residue, which is an example of oligomer, a compound containing a hydroxy group is preferable.

The number of polymerizable groups in the compound having an epoxy residue is preferably 2 to 6, and more preferably 2 or 3.

The compound having an epoxy residue can be obtained, for example, by reacting a compound having an epoxy group with an acrylic acid.

As the oligomer, commercially available products may also be used. Examples thereof include UA510H, UA-306H, UA-306I, and UA-306T (all manufactured by KYOEISHA CHEMICAL Co., Ltd.), UV-1700B, UV-6300B, and UV7620EA (all manufactured by The Nippon Synthetic Chemical Industry Co., Ltd.), U-15HA (manufactured by SHIN-NAKAMURA CHEMICAL Co., Ltd.), EBECRYL450, EBECRYL657, EBECRYL885, EBECRYL800, EBECRYL3416, and EBECRYL860 (all manufactured by DAICEL-ALLNEX LTD.), and the like. However, the oligomer is not limited to these.

From the viewpoints of improving chemical resistance, printing durability and, suppressiveness of the residues of on-press development, the content of the oligomer with respect to the total mass of polymerizable compounds in the image-recording layer is preferably 30% by mass to 100% by mass, more preferably 50% by mass to 100% by mass, and even more preferably 80% by mass to 100% by mass.

-Low-molecular-weight polymerizable compound-

The polymerizable compound may further include a polymerizable compound other than the oligomer described above.

From the viewpoint of chemical resistance, the polymerizable compound other than the oligomer is preferably a low-molecular-weight polymerizable compound. The low-molecular-weight polymerizable compound may take a chemical form such as a monomer, a dimer, a trimer, or a mixture of these.

From the viewpoint of chemical resistance, the low-molecular-weight polymerizable compound is preferably at least one polymerizable compound selected from the group consisting of a polymerizable compound having three or more ethylenically unsaturated groups and a polymerizable compound having an isocyanuric ring structure.

In the present disclosure, a low-molecular-weight polymerizable compound refers to a polymerizable compound having a molecular weight (weight-average molecular weight in a case where the compound has molecular weight distribution) of 50 or more and less than 800.

From the viewpoints of excellent chemical resistance, excellent printing durability, and excellent suppressiveness of the residues of on-press development, the molecular weight of the low-molecular-weight polymerizable compound is preferably 100 or more and less than 800, more preferably 300 or more and less than 800, and even more preferably 400 or more and less than 800.

In a case where the polymerizable compound includes a low-molecular-weight polymerizable compound as the polymerizable compound other than the oligomer, from the viewpoints of chemical resistance, printing durability, and suppressiveness of the residues of on-press development, the ratio (oligomer/low-molecular-weight polymerizable

compound) of the oligomer to the low-molecular-weight polymerizable compound (total amount in a case where the polymerizable compound includes two or more low-molecular-weight polymerizable compounds) based on mass is preferably 10/1 to 1/10, more preferably 10/1 to 3/7, and even more preferably 10/1 to 7/3.

As the low-molecular-weight polymerizable compound, the polymerizable compounds described in paragraphs "0082" to "0086" of WO2019/013268A can also be suitably used.

The details of how to use the polymerizable compound, such as the structure of the compound, whether the compound is used alone or used in combination with other compounds, and the additive amount of the compound, can be optionally set.

Particularly, from the viewpoint of printing durability, the image-recording layer preferably contains two or more polymerizable compounds.

The content of the polymerizable compound (total content of polymerizable compounds in a case where the image-recording layer contains two or more polymerizable compounds) with respect to the total mass of the image-recording layer is preferably 5% by mass to 75% by mass, more preferably 10% by mass to 70% by mass, and even more preferably 15% by mass to 60% by mass.

[Particles]

From the viewpoint of printing durability, the image-recording layer preferably contains particles.

The particles may be organic particles or inorganic particles. From the viewpoint of printing durability, the image-recording layer preferably contains organic particles, and more preferably contains polymer particles.

As inorganic particles, known inorganic particles can be used, and metal oxide particles such as silica particles and titania particles can be suitably used.

The polymer particles are preferably selected from the group consisting of thermoplastic resin particles, thermal reactive resin particles, polymer particles having a polymerizable group, microcapsules encapsulating a hydrophobic compound, and a microgel (crosslinked polymer particles). Among these, polymer particles having a polymerizable group or a microgel are preferable. In a particularly preferred embodiment, the polymer particles have at least one ethylenically unsaturated group. The presence of such polymer particles brings about effects of improving the printing durability of an exposed portion and improving the on-press developability of a non-exposed portion.

From the viewpoints of printing durability and on-press developability, the polymer particles are preferably thermoplastic resin particles.

The thermoplastic resin particles are preferably the thermoplastic polymer particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), EP931647B, and the like.

Specific examples of polymers constituting the thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylate or methacrylate having a polyalkylene structure, and the like and mixtures of these. Preferred examples thereof can include polystyrene, copolymers having styrene and acrylonitrile, or polymethyl methacrylate. The average particle diameter of the thermoplastic resin particle is preferably 0.01 $\mu$m to 3.0 $\mu$m.

Examples of the thermal reactive resin particles include polymer particles having a thermal reactive group. The thermal reactive polymer particles form a hydrophobilized region through crosslinking by a thermal reaction and the accompanying change in functional groups.

The thermal reactive group in the polymer particles having a thermal reactive group may be a functional group that causes any reaction as long as chemical bonds are formed, and is preferably a polymerizable group. Preferred examples thereof include an ethylenically unsaturated group that causes a radical polymerization reaction (for example, an acryloyl group, a methacryloyl group, a vinyl group, an allyl group, and the like), a cationically polymerizable group (for example, a vinyl group, a vinyloxy group, an epoxy group, an oxetanyl group, and the like), an isocyanato group or a blocked isocyanato group that causes an addition reaction, an epoxy group, a vinyloxy group, an active hydrogen atom-containing functional group that is a reaction partner thereof (for example, an amino group, a hydroxy group, a carboxy group, and the like), a carboxy group that causes a condensation reaction, a hydroxy group or an amino group that is a reaction partner of the carboxy group, an acid anhydride that causes a ring-opening addition reaction, an amino group or a hydroxy group which is a reaction partner of the acid anhydride, and the like.

Examples of the microcapsules include microcapsules encapsulating at least some of the constituent components of the image-recording layer as described in JP2001-277740A and JP2001-277742A. The constituent components of the image-recording layer can also be contained in the exterior of the microcapsules. In a preferred aspect, the image-recording layer containing microcapsules is constituted such that hydrophobic constituent components are encapsulated in the microcapsules and hydrophilic constituent components are contained in the exterior of the microcapsules.

The microgel (crosslinked polymer particles) can contain some of the constituent components of the image-recording layer, in at least one of the surface or the interior of the microgel. From the viewpoints of sensitivity of the lithographic printing plate precursor to be obtained and printing durability of the lithographic printing plate to be obtained, a reactive microgel having a radically polymerizable group on the surface thereof is particularly preferable.

In order to encapsulate the constituent components of the image-recording layer in microcapsules or microgel, known methods can be used.

From the viewpoints of printing durability, antifouling property, and storage stability of the lithographic printing plate to be obtained, the polymer particles are preferably polymer particles which are obtained by a reaction of a polyvalent isocyanate compound that is an adduct of a polyhydric phenol compound having two or more hydroxy groups in a molecule and isophorone diisocyanate with a compound having active hydrogen.

The polyhydric phenol compound is preferably a compound having a plurality of benzene rings having a phenolic hydroxy group.

The compound having active hydrogen is preferably a polyol compound or a polyamine compound, more preferably a polyol compound, and even more preferably at least one compound selected from the group consisting of propylene glycol, glycerin, and trimethylolpropane.

Preferred examples of the resin particles obtained by the reaction of a polyvalent isocyanate compound that is an adduct of a polyhydric phenol compound having two or more hydroxy groups in a molecule and isophorone diisocyanate, with a compound having active hydrogen include the polymer particles described in paragraphs "0032" to "0095" of JP2012-206495A.

Furthermore, from the viewpoints of printing durability and solvent resistance of the lithographic printing plate to be obtained, the polymer particles preferably include polymer particles containing a polymer having both i: a constitutional unit having a pendant cyano group directly bonded to the hydrophobic main chain and ii: a constitutional unit having a pendant group including a hydrophilic poly(alkylene oxide) segment.

Preferred examples of the hydrophobic main chain include an acrylic resin chain.

Preferred examples of the pendant cyano group include $-[CH_2CH(C{\equiv}N)]-$ or $-[CH_2C(CH_3)(C{\equiv}N)]-$.

In addition, the constitutional unit having the pendant cyano group can be easily derived from an ethylenically unsaturated monomer, for example, acrylonitrile or methacrylonitrile, or a combination of these.

Furthermore, as an alkylene oxide in the hydrophilic polyalkylene oxide segment, ethylene oxide or a propylene oxide is preferable, and ethylene oxide is more preferable.

The number of repeating alkylene oxide structures in the hydrophilic polyalkylene oxide segment is preferably 10 to 100, more preferably 25 to 75, and even more preferably 40 to 50.

Preferred examples of the resin particles including both i: the constitutional unit having the pendant cyano group directly bonded to the hydrophobic main chain and ii: the constitutional unit having the pendant group including the hydrophilic polyalkylene oxide segment include the particles described in paragraphs "0039" to "0068" of JP2008-503365A.

From the viewpoints of printing durability and on-press developability, the polymer particles preferably have a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

Among these, from the viewpoints of on-press developability and printing durability, a polyalkylene oxide structure is preferable, and a polyethylene oxide structure, a polypropylene oxide structure, or a polyethylene/propylene oxide structure is more preferable.

In addition, from the viewpoints of on-press developability and suppressiveness of the residues of development during on-press development, the polyalkylene oxide structure preferably has a polypropylene oxide structure, and more preferably has a polyethylene oxide structure and a polypropylene oxide structure.

From the viewpoints of printing durability, receptivity, and on-press developability, the hydrophilic group preferably has a constitutional unit having a cyano group, or a group represented by Formula Z, more preferably has a constitutional unit represented by Formula (AN) or a group represented by Formula Z, and particularly preferably has a group represented by Formula Z.

*-Q-W-Y Formula Z

In Formula Z, Q represents a divalent linking group, W represents a divalent group having a hydrophilic structure or a divalent group having a hydrophobic structure, and Y represents a monovalent group having a hydrophilic structure or a monovalent group having a hydrophobic structure, either W or Y has a hydrophilic structure, and * represents a bonding site with another structure.

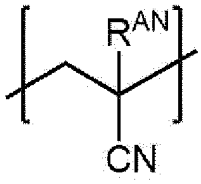

(AN)

In Formula (AN), $R^{AN}$ represents a hydrogen atom or a methyl group.

From the viewpoint of printing durability, the polymer contained in the polymer particles preferably has a constitutional unit formed of a compound having a cyano group.

Generally, it is preferable that a cyano group is introduced as a constitutional unit having a cyano group into a resin by using a compound (monomer) having a cyano group. Examples of the compound having a cyano group include acrylonitrile compounds and suitable examples thereof include (meth)acrylonitrile.

The constitutional unit having a cyano group is preferably a constitutional unit formed of an acrylonitrile compound, and more preferably a constitutional unit formed of (meth)acrylonitrile, that is, a constitutional unit represented by Formula (AN).

In a case where the polymer includes a polymer having a constitutional unit having a cyano group, from the viewpoint of printing durability, the content of the constitutional unit having a cyano group which is preferably a constitutional unit represented by Formula (AN) in the polymer having the constitutional unit having a cyano group with respect to the total mass of the polymer having the constitutional unit having a cyano group is preferably 5% by mass to 90% by mass, more preferably 20% by mass to 80% by mass, and particularly preferably 30% by mass to 60% by mass.

In addition, from the viewpoints of printing durability, receptivity, and on-press developability, the polymer particles preferably include polymer particles having a group represented by Formula Z.

Q in Formula Z is preferably a divalent linking group having 1 to 20 carbon atoms, and more preferably a divalent linking group having 1 to 10 carbon atoms.

In addition, Q in Formula Z is preferably an alkylene group, an arylene group, an ester bond, an amide bond, or a group formed by combining two or more of these, and more preferably a phenylene group, an ester bond, or an amide bond.

The divalent group having a hydrophilic structure represented by W in Formula Z is preferably a polyalkyleneoxy group or a group in which $-CH_2CH_2NR^W-$ is bonded to one terminal of a polyalkyleneoxy group. $R^W$ represents a hydrogen atom or an alkyl group.

The divalent group having a hydrophobic structure represented by W in Formula Z is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$'s each independently represent a linear, branched, or cyclic alkylene group having a carbon number of 6 to 120, a haloalkylene group having a carbon number of 6 to 120, an arylene group having a carbon number of 6 to 120, an alkarylene group having a carbon number of 6 to 120 (divalent group formed by removing one hydrogen atom from an alkylaryl group), or an aralkylene group having a carbon number of 6 to 120.

The monovalent group having a hydrophilic structure represented by Y in Formula Z is preferably -OH, -C(=O)OH, a polyalkyleneoxy group having a hydrogen atom or an alkyl group on a terminal, or a group in which $-CH_2CH_2NR^W-$ is bonded to one terminal of a polyalkyleneoxy group having a hydrogen atom or an alkyl group on the other terminal.

The monovalent group having a hydrophobic structure represented by Y in Formula Z is preferably a linear, branched, or cyclic alkyl group having 6 to 120 carbon atoms, a haloalkyl group having 6 to 120 carbon atoms, an aryl group having 6 to 120 carbon atoms, an alkaryl group (alkylaryl group) having 7 to 120 carbon atoms, an aralkyl group having 7 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoints of printing durability, receptivity, and on-press developability, in the polymer particles having a group represented by formula Z, W is preferably a divalent group having a hydrophilic structure, and it is more preferable that Q is a phenylene group, an ester bond, or an amide bond, W is a polyalkyleneoxy group, and Y is a polyalkyleneoxy group having a hydrogen atom or an alkyl group on a terminal.

From the viewpoints of printing durability and on-press developability, the polymer particles preferably include polymer particles having a polymerizable group, and more preferably include polymer particles having a polymerizable group on the particle surface.

Furthermore, from the viewpoint of printing durability, the polymer particles preferably include polymer particles having a hydrophilic group and a polymerizable group.

The polymerizable group may be a cationically polymerizable group or a radically polymerizable group and, from the viewpoint of reactivity, is preferably a radically polymerizable group.

The polymerizable group is not particularly limited as long as it is a polymerizable group, but from the viewpoint of

reactivity, is preferably an ethylenically unsaturated group, more preferably a vinylphenyl group (styryl group), a (meth) acryloxy group, or a (meth)acrylamide group, and particularly preferably a (meth)acryloxy group.

In addition, the polymer in the polymer particles having a polymerizable group preferably has a constitutional unit having a polymerizable group.

The polymerizable group may be introduced into the surface of the polymer particles by a polymer reaction.

In addition, from the viewpoints of printing durability and on-press developability, the image-recording layer preferably contains, as the polymer particles, addition polymerization-type resin particles having a dispersible group which more preferably includes a group represented by Formula Z.

From the viewpoints of printing durability, receptivity, on-press developability, and suppressiveness of the residues of development during on-press development, the polymer particles preferably contain a resin having a urea bond.

Suitable examples of the resin having a urea bond include those described in WO2020/262692A.

From the viewpoints of printing durability and on-press developability, the image-recording layer preferably contains thermoplastic resin particles.

The thermoplastic resin contained in the thermoplastic resin particles is not particularly limited, and examples thereof include polyethylene, polystyrene, polyvinyl chloride, polyvinylidene chloride, polymethyl (meth)acrylate, polyethyl (meth)acrylate, polybutyl (meth)acrylate, polyacrylonitrile, polyvinyl acetate, copolymers of these, and the like. The thermoplastic resin may be in the state of latex.

The thermoplastic resin according to the present disclosure is preferably a resin which melts or softens by heat generated in an exposure step that will be described later and thus forms a part or the entirety of a hydrophobic film forming the image-recording layer.

From the viewpoints of ink receptivity and printing durability, the thermoplastic resin preferably contains a resin having a constitutional unit formed of an aromatic vinyl compound and a constitutional unit having a cyano group.

Suitable examples of the resin having a constitutional unit formed of an aromatic vinyl compound and a constitutional unit having a cyano group include those described in WO2020/262692A.

From the viewpoints of printing durability and on-press developability, the thermoplastic resin contained in the thermoplastic resin particles preferably has a hydrophilic group.

The hydrophilic group is not particularly limited as long as it has a hydrophilic structure, and examples thereof include an acid group such as a carboxy group, a hydroxy group, an amino group, a cyano group, a polyalkylene oxide structure, and the like.

From the viewpoints of printing durability and on-press developability, the hydrophilic group is preferably a group having a polyalkylene oxide structure, a group having a polyester structure, or a sulfonic acid group, more preferably a group having a polyalkylene oxide structure or a sulfonic acid group, and even more preferably a group having a polyalkylene oxide structure.

From the viewpoint of on-press developability, the polyalkylene oxide structure is preferably a polyethylene oxide structure, a polypropylene oxide structure, or a poly(ethylene oxide/propylene oxide) structure.

In addition, from the viewpoint of on-press developability, among the hydrophilic groups, as a polyalkylene oxide structure, groups having a polypropylene oxide structure are preferable, and groups having a polyethylene oxide structure and a polypropylene oxide structure are more preferable.

From the viewpoint of on-press developability, the number of alkylene oxide structures in the polyalkylene oxide structure is preferably 2 or more, more preferably 5 or more, even more preferably 5 to 200, and particularly preferably 8 to 150.

In addition, from the viewpoint of on-press developability, the hydrophilic group is preferably a group represented by Formula Z.

From the viewpoints of printing durability and ink receptivity, the glass transition temperature (Tg) of the thermoplastic resin is preferably 60°C to 150°C, more preferably 80°C to 140°C, and even more preferably 90°C to 130°C.

In a case where the thermoplastic resin particles contain two or more types of thermoplastic resins, the value obtained by the FOX equation that will be described later is referred to as the glass transition temperature of the thermoplastic resin.

In the present disclosure, the glass transition temperature of a resin can be measured by differential scanning calorimetry (DSC).

Specifically, the glass transition temperature is measured according to the method described in JIS K 7121 (1987) or JIS K 6240 (2011). As the glass transition temperature in the present specification, an extrapolated glass transition initiation temperature (hereinafter, may be referred to as Tig) is used.

The method of measuring the glass transition temperature will be described in more detail.

In a case of determining the glass transition temperature, the device is kept at a temperature approximately 50°C lower than the expected Tg of the resin until the device stabilizes. Then, the resin is heated at a heating rate of 20 °C/min to a temperature approximately 30°C higher than the temperature at which the glass transition ends, and a differential

thermal analysis (DTA) curve or a DSC curve is created.

The extrapolated glass transition initiation temperature (Tig), that is, the glass transition temperature Tg in the present specification is determined as a temperature at an intersection point between a straight line that is obtained by extending the baseline of a low temperature side in the DTA curve or the DSC curve to a high temperature side and a tangent line that is drawn at a point where the slope of the curve of a portion in which the glass transition changes stepwisely is maximum.

In a case where the thermoplastic resin particles contain two or more types of thermoplastic resins, Tg of the thermoplastic resins contained in the thermoplastic resin particles is determined as follows.

In a case where Tg1 (K) represents Tg of a first thermoplastic resin, W1 represents the mass ratio of the first thermoplastic resin to the total mass of thermoplastic resin components in the thermoplastic resin particles, Tg2 (K) represents second Tg, and W2 represents the mass ratio of the second resin to the total mass of thermoplastic resin components in the thermoplastic resin particles, Tg0 (K) of the thermoplastic resin particles can be estimated according to the following FOX equation.

$$\text{FOX equation: } 1/Tg0 = (W1/Tg1) + (W2/Tg2)$$

In addition, in a case where the thermoplastic resin particles contain three types of resins or in a case where three types of thermoplastic resin particles each containing different types of thermoplastic resins are contained in a pretreatment liquid, similarly to the case described above, in a case where Tgn (K) represents Tg of nth resin and Wn represents the mass ratio of the nth resin to the total mass of resin components in the thermoplastic resin particles, Tg of the thermoplastic resin particles can be estimated according to the following equation.

$$\text{FOX equation: } 1/Tg0 = (W1/Tg1) + (W2/Tg2) + (W3/Tg3) \cdots + (Wn/Tgn)$$

As the differential scanning calorimeter (DSC), for example, EXSTAR 6220 manufactured by SII NanoTechnology Inc. can be used.

From the viewpoint of printing durability, the arithmetic mean particle diameter of the thermoplastic resin particles is preferably 1 nm or more and 200 nm or less, more preferably 3 nm or more and less than 80 nm, and even more preferably 10 nm or more and 49 nm or less.

Unless otherwise specified, the arithmetic mean particle diameter of the thermoplastic resin particles in the present disclosure refers to a value measured by a dynamic light scattering method (DLS). The measurement of the arithmetic mean particle diameter of the thermoplastic resin particles by DLS is carried out using Brookhaven BI-90 (manufactured by Brookhaven Instruments) according to the manual of the instrument.

The weight-average molecular weight of the thermoplastic resin contained in the thermoplastic resin particles is preferably 3,000 to 300,000, and more preferably 5,000 to 100,000.

The manufacturing method of the thermoplastic resin contained in the thermoplastic resin particles is not particularly limited, and the thermoplastic resin can be manufactured by known methods.

For example, the thermoplastic resin is obtained by polymerizing a styrene compound, an acrylonitrile compound, and as necessary, at least one optional compound selected from the group consisting of an N-vinyl heterocyclic compound, a compound used for forming a constitutional unit having an ethylenically unsaturated group, a compound used for forming a constitutional unit having an acidic group, a compound used for forming a constitutional unit having a hydrophobic group, and a compound used for forming the other constitutional units, by known methods.

Specifically, suitable examples of the thermoplastic resin contained in the thermoplastic resin particles include those described in WO2020/262692A.

The average particle diameter of the particles is preferably 0.01 μm to 3.0 μm, more preferably 0.03 μm to 2.0 μm, and still more preferably 0.10 μm to 1.0 μm. In a case where the average particle diameter is in this range, excellent resolution and excellent temporal stability are obtained.

The average primary particle diameter of the particles in the present disclosure is obtained by measuring with a light scattering method or by imaging an electron micrograph of the particles, measuring the particle diameter of a total of 5,000 particles in the photograph, and calculating the average value thereof. For non-spherical particles, the value of particle diameter of spherical particles having the same area as the area of the particles on the photograph is adopted as the particle diameter.

Unless otherwise specified, the average particle diameter in the present disclosure means a volume average particle diameter.

The image-recording layer may contain only one type of particles, particularly, one type of polymer particles or two or more types of polymer particles.

From the viewpoints of on-press developability and printing durability, the content of particles, particularly, the content of polymer particles in the image-recording layer with respect to the total mass of the image-recording layer is preferably 5% by mass to 90% by mass, more preferably 10% by mass to 90% by mass, even more preferably 20% by mass to 90% by mass, and particularly preferably 50% by mass to 90% by mass.
In addition, from the viewpoints of on-press developability and printing durability, the content of the polymer particles in the image-recording layer with respect to the total mass of components having a molecular weight of 3,000 or more in the image-recording layer is preferably 20% by mass to 100% by mass, more preferably 35% by mass to 100% by mass, even more preferably 50% by mass to 100% by mass, and particularly preferably 80% by mass to 100% by mass.

[Binder polymer]

The image-recording layer may contain a binder polymer.
The above-described polymer particles do not correspond to the binder polymer. That is, the binder polymer is a polymerized substance that is not in the form of particles.
The binder polymer is preferably a (meth)acrylic resin, a polyvinyl acetal resin, or a polyurethane resin.
Among these, as the binder polymer, known binder polymers that can be used in an image-recording layer in lithographic printing plate precursors can be suitably used. As an example, a binder polymer that is used for an on-press development type lithographic printing plate precursor (hereinafter, also called binder polymer for on-press development) will be specifically described.
As the binder polymer for on-press development, a binder polymer having an alkylene oxide chain is preferable. The binder polymer having an alkylene oxide chain may have a poly(alkylene oxide) moiety in a main chain or side chain. In addition, the binder polymer may be a graft polymer having poly(alkylene oxide) in a side chain or a block copolymer of a block composed of a poly(alkylene oxide)-containing repeating unit and a block composed of an (alkylene oxide)-free repeating unit.
In a case where the binder polymer has a poly(alkylene oxide) moiety in the main chain, a polyurethane resin is preferable. Examples of polymers as the main chain in a case where the binder polymer has a poly(alkylene oxide) moiety in the side chain include a (meth)acrylic resin, a polyvinyl acetal resin, a polyurethane resin, a polyurea resin, a polyimide resin, a polyamide resin, an epoxy resin, a polystyrene resin, a novolac-type phenol resin, a polyester resin, synthetic rubber, and natural rubber, and a (meth)acrylic resin is particularly preferable.
In addition, other preferred examples of the binder polymer include a polymer compound which has a polyfunctional thiol having functionalities of 6 or more and 10 or less as a nucleus and a polymer chain that is bonded to the nucleus by a sulfide bond and has a polymerizable group (hereinafter, this compound will be also called star-shaped polymer compound).
From the viewpoint of curability, preferred examples of the star-shaped polymer compound include a star-shaped polymer compound having a polymerizable group such as an ethylenically unsaturated group on a main chain or a side chain, and more preferably on a side chain.
Examples of the star-shaped polymer compound include those described in JP2012-148555A or WO2020/262692A.
The molecular weight of the binder polymer that is a polystyrene-equivalent weight-average molecular weight (Mw) determined by GPC is preferably 2,000 or more, more preferably 5,000 or more, and even more preferably 10,000 to 300,000.
As necessary, a hydrophilic polymer such as polyacrylic acid or polyvinyl alcohol described in JP2008-195018A can be used in combination. In addition, a lipophilic polymer and a hydrophilic polymer can be used in combination.
From the viewpoints of printing durability and on-press developability, the image-recording layer preferably contains a polymer having a constitutional unit formed of an aromatic vinyl compound, and more preferably contains a polymer having a constitutional unit formed of an aromatic vinyl compound and an infrared absorber which decomposes by exposure to infrared rays.
In addition, for example, from the viewpoint of inhibiting on-press developability from deteriorating with the passage of time, the glass transition temperature (Tg) of the binder polymer used in the present disclosure is preferably 50°C or higher, more preferably 70°C or higher, even more preferably 80°C or higher, and particularly preferably 90°C or higher.
Furthermore, from the viewpoint of ease of permeation of water into the image-recording layer, the upper limit of the glass transition temperature of the binder polymer is preferably 200°C, and more preferably 120°C or lower.
From the viewpoint of further inhibiting on-press developability from deteriorating with the passage of time, the binder polymer having the above-described glass transition temperature is preferably polyvinyl acetal.
Polyvinyl acetal is a resin obtained by acetalizing a hydroxy group of polyvinyl alcohol with an aldehyde.
Particularly, polyvinyl butyral is preferable which is obtained by acetalizing (that is, butyralizing) a hydroxy group of polyvinyl alcohol with butyraldehyde.

From the viewpoint of improving printing durability, the polyvinyl acetal preferably has an ethylenically unsaturated group.
Suitable examples of the polyvinyl acetal include those described in WO2020/262692A.
The image-recording layer in the present disclosure preferably contains a resin having a fluorine atom, and more preferably contains a fluoroaliphatic group-containing copolymer.
In a case where the resin having a fluorine atom, particularly, the fluoroaliphatic group-containing copolymer is used, it is possible to inhibit surface abnormalities resulting from foaming during the formation of the image-recording layer and to improve the condition of the coated surface, and further to improve the ink receptivity of the formed image-recording layer.
In addition, the image-recording layer containing the fluoroaliphatic group-containing copolymer has high gradation and is highly sensitive, for example, to laser light. Therefore, the obtained lithographic printing plate exhibits excellent fogging property by scattered light, reflected light, and the like and has excellent printing durability.
As the fluoroaliphatic group-containing copolymer, those described in WO2020/262692A can be suitably used.
In the image-recording layer used in the present disclosure, one binder polymer may be used alone, or two or more binder polymers may be used in combination.
The content of the binder polymer to be contained in the image-recording layer can be optionally set, and the content of the binder polymer with respect to the total mass of the image-recording layer is preferably 1% by mass to 90% by mass and more preferably 5% by mass to 80% by mass.

[Chain transfer agent]

The image-recording layer used in the present disclosure may contain a chain transfer agent. The chain transfer agent contributes to the improvement of printing durability of the lithographic printing plate.
The chain transfer agent is preferably a thiol compound, more preferably a thiol compound having 7 or more carbon atoms from the viewpoint of boiling point (low volatility), and even more preferably a compound having a mercapto group on an aromatic ring (aromatic thiol compound). The thiol compound is preferably a monofunctional thiol compound.
Specifically, suitable examples of the chain transfer agent include those described in WO2020/262692A.
Only one type of chain transfer agent may be added to the image-recording layer, or two or more types thereof may be used in combination.
The content of the chain transfer agent with respect to the total mass of the image-recording layer is preferably 0.01% by mass to 50% by mass, more preferably 0.05% by mass to 40% by mass, and even more preferably 0.1% by mass to 30% by mass.

[Oil sensitizing agent]

In order to improve ink receptivity, the image-recording layer preferably further contains an oil sensitizing agent.
Examples of the oil sensitizing agent include an onium compound, a nitrogen-containing low-molecular-weight compound, an ammonium compound such as an ammonium group-containing polymer, and the like.
Particularly, in a case where an inorganic lamellar compound is contained in a protective layer, these compounds function as a surface coating agent for the inorganic lamellar compound and can inhibit the receptivity deterioration due to the inorganic lamellar compound in the middle of printing.
In addition, from the viewpoint of receptivity, the oil sensitizing agent is preferably an onium compound.
Examples of the onium compound include a phosphonium compound, an ammonium compound, a sulfonium compound, and the like. From the viewpoint described above, the onium compound is preferably at least one compound selected from the group consisting of a phosphonium compound and an ammonium compound.
Preferred examples of the ammonium compound can include a nitrogen-containing low-molecular-weight compound, an ammonium group-containing polymer, and the like.
Specifically, suitable examples of the oil sensitizing agent include those described in WO2020/262692A.
The content of the oil sensitizing agent with respect to the total mass of the image-recording layer is preferably 1% by mass to 40.0% by mass, more preferably 2% by mass to 25.0% by mass, and even more preferably 3% by mass to 20.0% by mass.
The image-recording layer may contain only one type of oil sensitizing agent, or two or more types of oil sensitizing agents may be used in combination.
One of the preferred aspects of the image-recording layer used in the present disclosure is an aspect in which the image-recording layer contains two or more types of compounds as an oil sensitizing agent.
Specifically, from the viewpoint of satisfying both the on-press developability and receptivity, the image-recording layer used in the present disclosure preferably uses all the phosphonium compound, the nitrogen-containing low-molecular-weight compound, and the ammonium group-containing polymer as an oil sensitizing agent, and more

preferably uses all the phosphonium compound, the quaternary ammonium salts, and the ammonium group-containing polymer as an oil sensitizing agent.

[Development accelerator]

The image-recording layer used in the present disclosure preferably further contains a development accelerator.
The value of polarity element as an SP value of the development accelerator is preferably 6.0 to 26.0, more preferably 6.2 to 24.0, even more preferably 6.3 to 23.5, and particularly preferably 6.4 to 22.0.
In the present disclosure, as the value of polarity element as an SP value (solubility parameter, unit: $(cal/cm^3)^{1/2}$), the value of polarity element δp in the Hansen solubility parameters is used. The Hansen solubility parameters are obtained by dividing the solubility parameters introduced by Hildebrand into three components, a dispersion element δd, a polarity element δp, and a hydrogen bond element δh, and expressing the parameters in a three-dimensional space. In the present disclosure, the polarity element δp is used.
δp [$cal/cm^3$] is a dipole-dipole force element in the Hansen solubility parameters, V [$cal/cm^3$] is a molar volume, and μ [D] is a dipole moment. As δp, the following equation simplified by Hansen and Beerbower is generally used.

$$\delta_p = \frac{37.4\mu}{V^{1/2}}$$

The development accelerator is preferably a hydrophilic polymer compound or a hydrophilic low-molecular-weight compound.
In the present disclosure, "hydrophilic" means that the value of polarity element as an SP value is 6.0 to 26.0, the hydrophilic polymer compound refers to a compound having a molecular weight (weight-average molecular weight in a case where the compound has molecular weight distribution) of 3,000 or more, and the hydrophilic low-molecular-weight compound refers to a compound having a molecular weight (weight-average molecular weight in a case where the compound has molecular weight distribution) of less than 3,000.
Examples of the hydrophilic polymer compound include a cellulose compound and the like. Among these, a cellulose compound is preferable.
Examples of the cellulose compound include cellulose or a compound obtained by modifying at least a part of cellulose (modified cellulose compound). Among these, a modified cellulose compound is preferable.
Preferred examples of the modified cellulose compound include a compound which is obtained by substituting at least some of hydroxy groups of cellulose with at least one type of group selected from the group consisting of an alkyl group and a hydroxyalkyl group.
The degree of substitution of the compound, which is obtained by substituting at least some of hydroxy groups of cellulose with at least one type of group selected from the group consisting of an alkyl group and a hydroxyalkyl group, is preferably 0.1 to 6.0, and more preferably 1 to 4.
As the modified cellulose compound, an alkyl cellulose compound or a hydroxyalkyl cellulose compound is preferable, and a hydroxyalkyl cellulose compound is more preferable.
Preferred examples of the alkyl cellulose compound include methyl cellulose.
Preferred examples of the hydroxyalkyl cellulose compound include hydroxypropyl cellulose.
The molecular weight of the hydrophilic polymer compound (weight-average molecular weight in a case where the compound has molecular weight distribution) is preferably 3,000 to 5,000,000, and more preferably 5,000 to 200,000.
Examples of the hydrophilic low-molecular-weight compound include a glycol compound, a polyol compound, an organic amine compound, an organic sulfonic acid compound, an organic sulfamine compound, an organic sulfuric acid compound, an organic phosphonic acid compound, an organic carboxylic acid compound, a betaine compound, and the like. Among these, a polyol compound, an organic sulfonic acid compound, or a betaine compound is preferable.
Examples of the glycol compound include glycols such as ethylene glycol, diethylene glycol, triethylene glycol, propylene glycol, dipropylene glycol, and tripropylene glycol, and ether or ester derivatives of these compounds.
Examples of the polyol compound include glycerin, pentaerythritol, tris(2-hydroxyethyl) isocyanurate, and the like.
Examples of the organic amine compound include triethanolamine, diethanolamine, monoethanolamine, salts of these, and the like.
Examples of the organic sulfonic acid compound include alkyl sulfonic acid, toluene sulfonic acid, benzene sulfonic acid, salts of these, and the like. Among these, for example, alkyl sulfonic acid having an alkyl group having 1 to 10 carbon atoms is preferable.

Examples of the organic sulfamine compound include alkylsulfamic acid, salts thereof, and the like.
Examples of the organic sulfuric acid compound include alkyl sulfate, alkyl ether sulfuric acid, salts of these, and the like.
Examples of the organic phosphonic acid compound include phenylphosphonic acid, salts thereof, and the like.
Examples of the organic carboxylic acid compound include tartaric acid, oxalic acid, citric acid, malic acid, lactic acid, gluconic acid, salts of these, and the like.
Examples of the betaine compound include a phosphobetaine compound, a sulfobetaine compound, a carboxybetaine compound, and the like. Among these, for example, trimethylglycine is preferable.
The molecular weight of the hydrophilic low-molecular-weight compound (weight-average molecular weight in a case where the compound has molecular weight distribution) is preferably 100 or more and less than 3,000, and more preferably 300 to 2,500.
The development accelerator is preferably a compound having a cyclic structure.
The cyclic structure is not particularly limited. Examples thereof include a glucose ring in which at least some of hydroxy groups may be substituted, an isocyanuric ring, an aromatic ring which may have a heteroatom, an aliphatic ring which may have a heteroatom, and the like. Among these, for example, a glucose ring or an isocyanuric ring is preferable.
Examples of the compound having a glucose ring include the aforementioned cellulose compound.
Examples of the compound having an isocyanuric ring include the aforementioned tris(2-hydroxyethyl) isocyanurate and the like.
Examples of the compound having an aromatic ring include the toluene sulfonic acid and benzene sulfonic acid described above, and the like.
Examples of the compound having an aliphatic ring include a compound which is the aforementioned alkyl sulfate and has an alkyl group having a ring structure, and the like.
The compound having a cyclic structure preferably has a hydroxy group.
Preferred examples of the compound having a hydroxy group and a cyclic structure include the aforementioned cellulose compound and the aforementioned tris(2-hydroxyethyl) isocyanurate.
In addition, an onium compound is preferable as the development accelerator.
Examples of the onium compound include an ammonium compound and a sulfonium compound. Among these, an ammonium compound is preferable.
Examples of the development accelerator which is an onium compound include trimethylglycine.
In addition, the onium compound in the electron-accepting polymerization initiator is a compound in which the value of polarity element of the SP value is not in the range of 6.0 to 26.0 and is not included in the development accelerator.
The image-recording layer may contain only one type of development accelerator, or two or more types of development accelerators may be used in combination.
One of the preferred aspects of the image-recording layer used in the present disclosure is an aspect in which the image-recording layer contains two or more types of compounds as a development accelerator.
Specifically, from the viewpoint of on-press developability and receptivity, the image-recording layer used in the present disclosure preferably contains, as a development accelerator, the polyol compound and the betaine compound described above, the betaine compound and the organic sulfonic acid compound described above, or the polyol compound and the organic sulfonic acid compound described above.
The content of the development accelerator with respect to the total mass of the image-recording layer is preferably 0.1% by mass or more and 20% by mass or less, more preferably 0.5% by mass or more and 15% by mass or less, and even more preferably 1% by mass or more and 10% by mass or less.

[Other components]

As other components, a surfactant, a polymerization inhibitor, a higher fatty acid derivative, a plasticizer, an inorganic lamellar compound, and the like can be incorporated into the image-recording layer. Specifically, the description in paragraphs "0114" to "0159" of JP2008-284817A can be referred to.
As the polymerization inhibitor, for example, a known polymerization inhibitor such as phenothiazine can be used.

[Formation of image-recording layer]

The image-recording layer in the lithographic printing plate precursor according to the present disclosure can be formed, for example, by preparing a coating liquid by dispersing or dissolving the necessary components described above in a known solvent, coating a support with the coating liquid by a known method such as bar coating, and drying the coating liquid, as described in paragraphs "0142" and "0143" of JP2008-195018A.
As the solvent, known solvents can be used. Specific examples thereof include water, acetone, methyl ethyl

ketone (2-butanone), cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetylacetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 1-methoxy-2-propanol, 3-methoxy-1-propanol, methoxy methoxyethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxypropyl acetate, N,N-dimethylformamide, dimethyl sulfoxide, γ-butyrolactone, methyl lactate, ethyl lactate, and the like. Only one type of solvent may be used, or two or more types of solvents may be used in combination. The concentration of solid contents in the coating liquid is preferably 1% by mass to 50% by mass.

The coating amount (solid content) of the image-recording layer after coating and drying varies with uses, but from the viewpoint of obtaining excellent sensitivity and excellent film characteristics of the image-recording layer, is preferably 0.3 $g/m^2$ to 3.0 $g/m^2$.

In addition, the layer thickness of the image-recording layer is preferably 0.1 μm to 3.0 μm and more preferably 0.3 μm to 2.0 μm.

In the present disclosure, the layer thickness of each layer in the lithographic printing plate precursor is checked by preparing a slice by cutting the lithographic printing plate precursor in a direction perpendicular to the surface of the precursor and observing the cross section of the slice with a scanning electron microscope (SEM).

<Support>

The lithographic printing plate precursor according to the present disclosure has a support.

The support to be used can be appropriately selected from known supports for a lithographic printing plate precursor.

The support is preferably a support having a hydrophilic surface (hereinafter, also called "hydrophilic support").

As the support in the present disclosure, an aluminum plate is preferable which has been roughened using a known method and has undergone an anodization treatment. That is, the support in the present disclosure preferably has an aluminum plate and an anodic oxide coating film of aluminum, disposed on the aluminum plate.

In addition, it is preferable that the support has an aluminum plate and an anodic oxide film of aluminum, disposed on the aluminum plate, the anodic oxide film is positioned closer to the image-recording layer side than the aluminum plate and has micropores extending in a depth direction from the surface of the anodic oxide film on the image-recording layer side, and the average diameter of the micropores within the surface of the anodic oxide film is more than 10 nm and 100 nm or less.

Furthermore, it is preferable that the micropores are each configured with a large diameter portion that extends to a position at a depth of 10 nm to 1,000 nm from the surface of the anodic oxide film and a small diameter portion that is in communication with a bottom portion of the large diameter portion and extends to a position at a depth of 20 nm to 2,000 nm from a communicate position, an average diameter of the large diameter portion within the surface of the anodic oxide film is preferably 15 nm to 100 nm, and an average diameter of the small diameter portion at the communicate position is preferably 13 nm or less.

In addition, it is preferable that the support has an aluminum plate and an anodic oxide film of aluminum, disposed on the aluminum plate, the anodic oxide film is positioned closer to the image-recording layer side than the aluminum plate, the anodic oxide film has a micropore extending in a depth direction from a surface of the anodic oxide film on the image-recording layer side, the micropore is configured with a small diameter portion extending to a position at a depth of 10 nm to 1,000 nm from the surface of the anodic oxide film and a large diameter portion communicating with a bottom portion of the small diameter portion and extending to a position at a depth of 20 nm to 2,000 nm from a communicate position, an average diameter of the small diameter portion within the surface of the anodic oxide film is 35 nm or less, and an average maximum diameter of the large diameter portion is 40 nm to 300 nm.

It is possible to easily prepare the support of the above aspect by using an aqueous phosphoric acid solution as a first-stage anodization treatment and using an aqueous sulfuric acid solution as a second-stage anodization treatment in the treatment that will be described later.

The tensile strength of the present support is preferably 160 MPa or more.

The tensile strength is measured using an autograph AGC-H5KN (manufactured by Shimadzu Corporation.) as a tensile strength measuring machine and using a sample: JIS metal material tensile test piece No. 5 at a tensile speed of 2 mm/min.

The tensile strength of the support is preferably 160 MPa or more, more preferably 170 MPa or more, and particularly preferably 190 MPa or more.

In addition, the maximum tensile strength of the support is not particularly limited, but is preferably 300 MPa or less, more preferably 250 MPa or less, and even more preferably 220 MPa or less.

There is no limit particularly on how to obtain a support having a tensile strength of 160 MPa or more. For example, as will be described later, such a support is obtained by incorporating a specific amount of magnesium into the support and setting a reduction rate in a support rolling step to be equal to or more than a specific amount.

As the support, an aluminum support is preferable. The aluminum plate used in the aluminum support consists of a dimensionally stable metal containing aluminum as a main component, that is, aluminum or an aluminum alloy. It is preferable that the aluminum plate is selected from a pure aluminum plate and an alloy that contains aluminum as a main component and traces of foreign elements.

The foreign elements contained in the aluminum alloy include silicon, iron, manganese, copper, magnesium, chromium, zinc, bismuth, nickel, titanium, and the like. The content of the foreign elements in the alloy is 10% by mass or less. As the aluminum plate, a pure aluminum plate is suitable. However, the aluminum plate may be an alloy that contains traces of foreign elements, because it is difficult to manufacture perfectly pure aluminum by smelting technologies. The composition of the aluminum plate used for the aluminum support is not specified, and it is possible to appropriately use aluminum plates known in the related art, for example, JIS A 1050, JIS A 1100, JIS A 3103, and JIS A 3005 caused to have the above tensile strength.

It is preferable that the support is an aluminum support, and a magnesium content in the aluminum support is 0.020% by mass or more. Setting the magnesium content (content rate) in the aluminum support to be 0.020% by mass or more makes it possible to suitably obtain a support having a tensile strength of 160 MPa or more.

The magnesium content in the support is preferably 0.020% by mass or more, more preferably 0.040% by mass or more, and even more preferably 0.060% by mass or more.

The magnesium content in the support is not particularly limited, but is usually 0.200% by mass or less, preferably 0.150% by mass or less, and more preferably 0.100% by mass or less.

The magnesium content rate in the support is measured using an emission analysis apparatus (PDA-5500, manufactured by Shimadzu Corporation.) as a measurement apparatus.

In addition, it is preferable that the support is an aluminum support, and the aluminum support is configured with an aluminum plate that is subjected to a heat treatment at a temperature of 250°C or higher and then subjected to cold rolling at a reduction rate of 80% or more in the rolling step. In a case where this aspect is adopted, it is possible to suitably obtain a support having a tensile strength of 160 Mpa or more.

Controlling the reduction rate in the cold rolling step following the heat treatment makes it possible to control the tensile strength of the support (preferably the aluminum support). The reduction rate is an amount calculated by (h1 - h2)/h1 where h1 represents a plate thickness of a material not yet being rolled and h2 represents a plate thickness of the material having been rolled. The reduction rate shows a processing degree of rolling, which is preferably 80% or more, more preferably 90% or more, and even more preferably 95% or more.

In addition, the reduction rate is preferably less than 99% and more preferably 98% or less.

The thickness of the support (preferably, the aluminum plate) is preferably about 0.1 mm to 0.6 mm.

[Anodic oxide film]

The support preferably has an anodic oxide film.

The anodic oxide film means an anodic oxide film (preferably an anodic aluminum oxide film) which is formed on the surface of a support (preferably an aluminum plate) by an anodization treatment and has supermicropores (also called micropores). The micropores extend from the surface of the anodic oxide film on the side opposite to the support along the thickness direction (support side, depth direction).

From the viewpoints of tone reproducibility, printing durability, and blanket stain property, the average diameter (average opening diameter) of the micropores within the surface of the anodic oxide film is preferably 7 nm to 150 nm, more preferably 10 nm to 100 nm, even more preferably 10 nm to 60 nm, particularly preferably 15 nm to 60 nm, and most preferably 18 nm to 40 nm.

The depth of the micropores is preferably 10 nm to 3,000 nm, more preferably 10 nm to 2,000 nm, and even more preferably 10 nm to 1,000 nm.

Usually, the micropores have a substantially straight tubular shape (substantially cylindrical shape) in which the diameter of the micropores substantially does not change in the depth direction (thickness direction). The micropores may also have a conical shape that continues to taper in the depth direction (thickness direction). In addition, the diameter of the micropores may have a shape that discontinuously tapers along the depth direction (thickness direction).

Examples of the micropores having a shape that discontinuously tapers in the depth direction (thickness direction) include micropores each configured with a large diameter portion that extends along the depth direction from the surface of the anodic oxide film and a small diameter portion that is in communication with the bottom portion of the large diameter portion and extends along the depth direction from the communicate position.

Specifically, the micropores are preferable which are each configured with a large diameter portion that extends 10 nm to 1,000 nm in the depth direction from the surface of the anodic oxide film and a small diameter portion that is in

communication with the bottom portion of the large diameter portion and further extends 20 nm to 2,000 nm in the depth direction from the communicate position.

Hereinafter, the large diameter portion and the small diameter portion will be specifically described.

-Large diameter portion-

From the viewpoints of tone reproducibility, printing durability, and blanket stain property, the average diameter (average opening diameter) of the large diameter portion within the surface of the anodic oxide film is preferably 7 nm to 150 nm, more preferably 10 nm to 100 nm, even more preferably 15 nm to 100 nm, particularly preferably 15 nm to 60 nm, and most preferably 18 nm to 40 nm.

The average diameter of the large diameter portion is calculated by a method of observing the surface of the anodic oxide film with a field emission scanning electron microscope (FE-SEM) at 150,000X magnification (N = 4), measuring the sizes (diameters) of micropores (large diameter portions) existing in a range of 400 nm $\times$ 600 nm in the obtained 4 images, and calculating the arithmetic mean of the diameters.

In a case where the shape of the large diameter portion is not circular, the equivalent circle diameter is used. "Equivalent circular diameter" is a diameter determined on an assumption that the opening portion is in the form of a circle having the same projected area as the projected area of the opening portion.

The bottom portion of the large diameter portion is preferably in a position at a depth of 70 nm to 1,000 nm (hereinafter, also called depth A) from the surface of the anodic oxide film. That is, the large diameter portion is preferably a pore portion extending to a position at a depth of 70 nm to 1,000 nm from the surface of the anodic oxide film in the depth direction (thickness direction). Particularly, from the viewpoint of further improving the effect of the manufacturing method of a lithographic printing plate precursor, the depth A is more preferably 90 nm to 850 nm, even more preferably 90 nm to 800 nm, and particularly preferably 90 nm to 600 nm.

The depth is a value obtained by taking a photograph (150,000X magnification) of a cross section of the anodic oxide film, measuring the depths of 25 or more large diameter portions, and calculating the arithmetic mean thereof.

The shape of the large diameter portion is not particularly limited. Examples of the shape of the large diameter portion include a substantially straight tubular shape (substantially cylindrical shape) and a conical shape that tapers along the depth direction (thickness direction). Among these, a substantially straight tubular shape is preferable. The shape of the bottom portion of the large diameter portion is not particularly limited, and may be a curved (convex) or planar shape.

The inner diameter of the large diameter portion is not particularly limited, but is preferably as large as the diameter of the opening portion or smaller than the diameter of the opening portion. There may be a difference of about 1 nm to 10 nm between the inner diameter of the large diameter portion and the diameter of the opening portion.

-Small diameter portion-

The small diameter portion is a pore portion that is in communication with the bottom portion of the large diameter portion and further extends from the communicate position in the depth direction (thickness direction). Generally, one small diameter is in communication with one large diameter portion. However, two or more small diameter portions may be in communication with the bottom portion of one large diameter portion.

The average diameter of the small diameter portion at the communicate position is preferably less than 15 nm, more preferably 13 nm or less, even more preferably 11 nm or less, and particularly preferably 10 nm or less. The lower limit thereof is not particularly limited, but is preferably 5 nm.

The average diameter of the small diameter portion is obtained by observing the surface of the anodic oxide film with FE-SEM at 150,000X magnification (N = 4), measuring the sizes (diameters) of the micropores (small diameter portion) existing in a range of 400 nm $\times$ 600 nm in the obtained 4 images, and calculating the arithmetic mean of the diameters.

In a case where the large diameter portion is deep, as necessary, the upper portion of the anodic oxide film (region where the large diameter portion is located) may be cut (for example, cut by using argon gas), then the surface of the anodic oxide film may be observed with FE-SEM described above, and the average diameter of the small diameter portion may be determined.

In a case where the shape of the small diameter portion is not circular, the equivalent circle diameter is used. "Equivalent circular diameter" is a diameter determined on an assumption that the opening portion is in the form of a circle having the same projected area as the projected area of the opening portion.

The bottom portion of the small diameter portion is preferably in a position 20 nm to 2,000 nm distant from the communicate position (corresponding to the depth A described above) with the large diameter portion in the depth direction. In other words, the small diameter portion is a pore portion that extends further from the communicate position with the large diameter portion in the depth direction (thickness direction), and the depth of the small diameter portion is preferably 20 nm to 2,000 nm, more preferably 100 nm to 1,500 nm, and particularly preferably 200 nm to 1,000 nm.

The depth is a value obtained by taking a photograph (150,000X magnification) of a cross section of the anodic oxide film, measuring the depths of 25 or more small diameter portions, and calculating the arithmetic mean thereof.
The shape of the small diameter portion is not particularly limited. Examples of the shape of the small diameter portion include a substantially straight tubular shape (substantially cylindrical shape) and a conical shape that tapers along the depth direction. Among these, a substantially straight tubular shape is preferable. In addition, the shape of the bottom portion of the small diameter portion is not particularly limited, and may be a curved (convex) or planar shape.
The inner diameter of the small diameter portion is not particularly limited, and may be the same as the diameter at the communicate position, or may be smaller or larger than the diameter at the communicate position. Generally, there may be a difference of about 1 nm to 10 nm between the inner diameter of the small diameter portion and the diameter of the opening portion.
The ratio of the average diameter of the large diameter portion within the surface of the anodic oxide film to the average diameter of the small diameter portion at the communicate position, (average diameter of large diameter portion within surface of anodic oxide film)/(average diameter of small diameter portion at communicate position) is preferably 1.1 to 13, and more preferably 2.5 to 6.5.
The ratio of the depth of the large diameter portion to the depth of the small diameter portion, (depth of large diameter portion)/(depth of small diameter portion) is preferably 0.005 to 50, and more preferably 0.025 to 40.
The micropores have a substantially straight tubular shape (substantially cylindrical shape) in which the diameter of the micropores substantially does not change in the depth direction (thickness direction). The micropores may also have a conical shape that continues to widen in the depth direction (thickness direction). The micropores may have a shape that discontinuously widens along the depth direction (thickness direction).
Examples of the micropores having a shape that discontinuously widens in the depth direction (thickness direction) include micropores each configured with a small diameter portion that extends along the depth direction from the surface of the anodic oxide film and a large diameter portion that is in communication with the bottom portion of the small diameter portion and extends along the depth direction from the communicate position.
Specifically, the micropores are preferable which are each configured with a small diameter portion that extends 10 nm to 1,000 nm in the depth direction from the surface of the anodic oxide film and a large diameter portion that is in communication with the bottom portion of the small diameter portion and extends 20 nm to 2,000 nm in the depth direction from the communicate position.

-Small diameter portion-

The average diameter (average opening diameter) of the small diameter portion within the surface of the anodic oxide film is not particularly limited, but is preferably 35 nm or less, more preferably 25 nm or less, and particularly preferably 20 nm or less.
The lower limit thereof is not particularly limited, but is preferably 15 nm.
The average diameter of the small diameter portion is calculated by a method of observing the surface of the anodic oxide film with a field emission scanning electron microscope (FE-SEM) at 150,000X magnification (N = 4), measuring the sizes (diameters) of micropores (large diameter portions) existing in a range of 400 nm $\times$ 600 nm in the obtained 4 images, and calculating the arithmetic mean of the diameters.
In a case where the shape of the small diameter portion is not circular, the equivalent circle diameter is used. "Equivalent circular diameter" is a diameter determined on an assumption that the opening portion is in the form of a circle having the same projected area as the projected area of the opening portion.
The bottom portion of the small diameter portion is preferably in a position at a depth of 70 nm to 1,000 nm (hereinafter, also called depth A') from the surface of the anodic oxide film. That is, the small diameter portion is preferably a pore portion extending 70 nm to 1,000 nm in the depth direction (thickness direction) from the surface of the anodic oxide film.
The depth is a value obtained by taking a photograph (150,000X magnification) of a cross section of the anodic oxide film, measuring the depths of 25 or more large diameter portions, and calculating the arithmetic mean thereof.
The shape of the small diameter portion is not particularly limited. Examples of the shape of the small diameter portion include a substantially straight tubular shape (substantially cylindrical shape) and a conical shape that widens along the depth direction (thickness direction). Among these, a substantially straight tubular shape is preferable. In addition, the shape of the bottom portion of the small diameter portion is not particularly limited, and may be a curved (convex) or planar shape.
The inner diameter of the small diameter portion is not particularly limited, but is preferably as large as the diameter of the opening portion or smaller than the diameter of the opening portion. There may be a difference of about 1 nm to 10 nm between the inner diameter of the small diameter portion and the diameter of the opening portion.

-Large diameter portion-

The large diameter portion is a pore portion that is in communication with the bottom portion of the small diameter portion and further extends from the communicate position in the depth direction (thickness direction). Generally, in one large diameter, the bottom portion of the one large diameter portion may be in communication with two or more small diameter portions.

The average diameter of the large diameter portion at the communicate position is preferably 20 nm to 400 nm, more preferably 40 nm to 300 nm, even more preferably 50 nm to 200 nm, and particularly preferably 50 nm to 100 nm.

The average diameter of the large diameter portion is obtained by observing the surface of the anodic oxide film with FE-SEM at 150,000X magnification (N = 4), measuring the sizes (diameters) of the micropores (large diameter portion) existing in a range of 400 nm $\times$ 600 nm in the obtained 4 images, and calculating the arithmetic mean of the diameters.

In a case where the small diameter portion is deep, as necessary, the upper portion of the anodic oxide film (region where the small diameter portion is located) may be cut (for example, cut by using argon gas), then the surface of the anodic oxide film may be observed with FE-SEM described above, and the average diameter of the large diameter portion may be determined.

In a case where the shape of the large diameter portion is not circular, the equivalent circle diameter is used. "Equivalent circular diameter" is a diameter determined on an assumption that the opening portion is in the form of a circle having the same projected area as the projected area of the opening portion.

The bottom portion of the large diameter portion is preferably in a position 20 nm to 2,000 nm distant from the communicate position (corresponding to the depth A' described above) with the small diameter portion in the depth direction. In other words, the large diameter portion is a pore portion that extends further from the communicate position with the small diameter portion in the depth direction (thickness direction), and the depth of the large diameter portion is preferably 20 nm to 2,000 nm, more preferably 100 nm to 1,500 nm, and particularly preferably 200 nm to 1,000 nm.

The depth is a value obtained by taking a photograph (150,000X magnification) of a cross section of the anodic oxide film, measuring the depths of 25 or more large diameter portions, and calculating the arithmetic mean thereof.

The shape of the large diameter portion is not particularly limited. Examples of the shape of the large diameter portion include a substantially straight tubular shape (substantially cylindrical shape) and a conical shape that tapers along the depth direction. Among these, a substantially straight tubular shape is preferable. The shape of the bottom portion of the large diameter portion is not particularly limited, and may be a curved (convex) or planar shape.

The inner diameter of the large diameter portion is not particularly limited, and may be the same as the diameter at the communicate position, or may be smaller or larger than the diameter at the communicate position. Generally, there may be a difference of about 1 nm to 10 nm between the inner diameter of the large diameter portion and the diameter of the opening portion.

It is preferable that the support has an anodic oxide film, and

the anodic oxide film has, in order from the surface of the anodic oxide film along the depth direction,
an upper layer that has a thickness of 30 nm to 500 nm and has micropores having an average diameter of 20 nm to 100 nm,
an intermediate layer that has a thickness of 100 nm to 300 nm and has micropores having an average diameter 1/2 to 5 times the average diameter of the micropores in the micropore upper layer, and
a lower layer that has a thickness of 300 nm to 2,000 nm and has micropores having an average diameter of 15 nm or less.

In an on-press development type lithographic printing plate precursor, from the viewpoint of improving image visibility, a support is useful in which the surface of an anodic oxide film (surface on which an image-recording layer is to be formed) has high lightness.

Usually, in a printing step using a lithographic printing plate, before the printing plate is mounted on a printer, the plate is inspected to check whether an image is recorded as intended. For the on-press development type lithographic printing plate precursor, it is required to check the image at the stage where the image is exposed. Therefore, a means generating a so-called printed image in an image exposed portion is used.

Examples of a method of quantitatively evaluating the visibility of an image area (image visibility) of the on-press development type lithographic printing plate precursor having undergone exposure of an image include a method of measuring the lightness of an image exposed portion and the lightness of a non-exposed portion and calculating the difference therebetween. As the lightness, a value of lightness L* in the CIEL*a*b* color system can be used. The lightness can be measured using a color difference meter (Spectro Eye, manufactured by X-Rite, Incorporated.). The larger the difference between the measured lightness of the image exposed portion and the measured lightness of the non-exposed portion is, the higher the visibility of the image area is.

It has been revealed that the larger the value of lightness L* of the surface of the anodic oxide film in the CIEL*a*b* color system is, the more effective it is to increase the difference between the lightness of the image exposed portion and the lightness of the non-exposed portion. That is, the value of the lightness L* is preferably 60 to 100.

As necessary, the support having an anodic oxide film may have a backcoat layer containing the organic polymer compound described in JP1993-45885A (JP-H5-45885A), the alkoxy compound of silicon described in JP1994-35174A (JP-H6-35174A), or the like, on a surface opposite to the side where a constitutional layer containing a hydroxy acid compound having two or more hydroxyl groups is formed.

[Manufacturing of aluminum support having anodic oxide film]

The manufacturing method of an aluminum support having an anodic oxide film, which is an example of support, will be described.

The aluminum support having an anodic oxide film can be manufactured using known methods. The manufacturing method of the aluminum support having an anodic oxide film is not particularly limited. Examples of preferred aspects of the manufacturing method of the aluminum support having an anodic oxide film include a method including a step of performing a roughening treatment on an aluminum plate (roughening treatment step), a step of anodizing the aluminum plate having undergone the roughening treatment (anodization treatment step), and a step of bringing the aluminum plate having an anodic oxide film obtained by the anodization treatment step into contact with an aqueous acid solution or an aqueous alkali solution to increase the diameter of micropores in the anodic oxide film (pore widening treatment step).

Hereinafter, each step will be described in detail.

<<Roughening treatment step>>

The roughening treatment step is a step of performing a roughening treatment including an electrochemical roughening treatment on the surface of the aluminum plate. The roughening treatment step is preferably performed before the anodization treatment step which will be described later. However, in a case where the surface of the aluminum plate already has a preferable shape, the roughening treatment step may not be performed.

As the roughening treatment, only an electrochemical roughening treatment may be performed, or an electrochemical roughening treatment may be performed in combination with at least either a mechanical roughening treatment or a chemical roughening treatment.

In a case where the mechanical roughening treatment and the electrochemical roughening treatment are combined, it is preferable to perform the electrochemical roughening treatment after the mechanical roughening treatment.

The electrochemical roughening treatment is preferably performed in an aqueous solution of nitric acid or hydrochloric acid.

Generally, the mechanical roughening treatment is performed such that the aluminum plate has a surface roughness Ra of 0.35 μm to 1.0 μm.

The conditions of the mechanical roughening treatment are not particularly limited. For example, the mechanical roughening treatment can be performed according to the method described in JP1975-40047B (JP-S50-40047B). The mechanical roughening treatment can be performed by a brush graining treatment using a pumice stone suspension or by a transfer method.

The chemical roughening treatment is also not particularly limited, and can be performed according to known methods.

After the mechanical roughening treatment, it is preferable to perform the following chemical etching treatment.

By the chemical etching treatment performed after the mechanical roughening treatment, the edge portion of surface irregularities of the aluminum plate smoothed, such that ink clotting that may occur during printing is prevented, the antifouling property of the lithographic printing plate is improved, and unnecessary substances such as abrasive particles remaining on the surface are removed.

As the chemical etching treatment, etching with an acid and etching with an alkali are known. One of the examples of particularly efficient etching methods is a chemical etching treatment using an alkaline solution (hereinafter, also called "alkaline etching treatment").

The alkaline agent used in the alkaline solution is not particularly limited. Suitable examples thereof include caustic soda, caustic potash, sodium metasilicate, sodium carbonate, sodium aluminate, sodium gluconate, and the like.

The alkaline solution may contain aluminum ions. The concentration of the alkaline agent in the alkaline solution is preferably 0.01% by mass or more and more preferably 3% by mass or more. In addition, the concentration is preferably 30% by mass or less and more preferably 25% by mass or less.

The temperature of the alkaline solution is preferably equal to or more than room temperature and more

preferably 30°C or more. In addition, the temperature is preferably 80°C or less and more preferably 75°C or less.

The etching amount is preferably 0.01 g/m$^2$ or more, and more preferably 0.05 g/m$^2$ or more. In addition, the etching amount is preferably 30 g/m$^2$ or less, and more preferably 20 g/m$^2$ or less.

The treatment time preferably is in a range of 2 seconds to 5 minutes depending on the etching amount. In view of improving productivity, the treatment time is more preferably 2 seconds to 10 seconds.

In a case where the alkaline etching treatment is performed after the mechanical roughening treatment, in order to remove products generated by the alkaline etching treatment, the chemical etching treatment by using a low-temperature acidic solution (hereinafter, also called "desmutting treatment") is preferably performed.

The acid used in the acidic solution is not particularly limited, and examples thereof include sulfuric acid, nitric acid, and hydrochloric acid. The concentration of the acidic solution is preferably 1% to 50% by mass. The temperature of the acidic solution is preferably 20°C to 80°C. In a case where the concentration and temperature of the acidic solution are in this range, the lithographic printing plate using an aluminum support becomes more resistant to dot-like stain.

Examples of preferred aspects of the roughening treatment step are as below.

-Aspect SA-

An aspect in which the following treatments (1) to (8) are performed in this order.

(1) Chemical etching treatment using alkaline aqueous solution (first alkaline etching treatment)
(2) Chemical etching treatment using acidic aqueous solution (first desmutting treatment)
(3) Electrochemical roughening treatment using aqueous solution containing nitric acid as main component (first electrochemical roughening treatment)
(4) Chemical etching treatment using alkaline aqueous solution (second alkaline etching treatment)
(5) Chemical etching treatment using acidic aqueous solution (second desmutting treatment)
(6) Electrochemical roughening treatment using aqueous solution containing hydrochloric acid as main component (second electrochemical roughening treatment)
(7) Chemical etching treatment using alkaline aqueous solution (third alkaline etching treatment)
(8) Chemical etching treatment using acidic aqueous solution (third desmutting treatment)

-Aspect SB-

An aspect in which the following treatments (11) to (15) are performed in this order.

(11) Chemical etching treatment using alkaline aqueous solution (fourth alkaline etching treatment)
(12) Chemical etching treatment using acidic aqueous solution (fourth desmutting treatment)
(13) Electrochemical roughening treatment using aqueous solution containing hydrochloric acid as main component (third electrochemical roughening treatment)
(14) Chemical etching treatment using alkaline aqueous solution (fifth alkaline etching treatment)
(15) Chemical etching treatment using acidic aqueous solution (fifth desmutting treatment)

As necessary, a mechanical roughening treatment may be performed before the treatment (1) of the aspect SA or before the treatment (11) of the aspect SB.

The amount of the aluminum plate dissolved by the first alkaline etching treatment and the fourth alkaline etching treatment is preferably 0.5 g/m$^2$ to 30 g/m$^2$ and more preferably 1.0 g/m$^2$ to 20 g/m$^2$.

Examples of the aqueous solution containing nitric acid as a main component used in the first electrochemical roughening treatment of the aspect SA include aqueous solutions used in the electrochemical roughening treatment using direct current or alternating current. Examples thereof include an aqueous solution obtained by adding aluminum nitrate, sodium nitrate, ammonium nitrate, or the like to a 1 g/L to 100 g/L aqueous nitric acid solution.

Examples of the aqueous solution containing hydrochloric acid as a main component used in the second electrochemical roughening treatment of the aspect SA and in the third electrochemical roughening treatment of the aspect SB include aqueous solutions used in the electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, or ammonium nitrate; or chloride ions such as aluminum chloride, sodium chloride, or ammonium chloride may be further added to the aqueous solution.

As the waveform of an alternating current power source for the electrochemical roughening treatment, a sine wave, a square wave, a trapezoidal wave, a triangular wave, or the like can be used. The frequency is preferably 0.1 Hz to 250 Hz.

Fig. 1 is a graph showing an example of an alternating waveform current waveform diagram used for an electrochemical roughening treatment.

In Fig. 1, ta represents an anodic reaction time, tc represents a cathodic reaction time, tp represents the time taken for current to reach a peak from 0, Ia represents the peak current on the anodic cycle side, and Ic represents the peak current on the cathodic cycle side. For a trapezoidal wave, the time tp taken for current to reach a peak from 0 is preferably 1 msec to 10 msec. Regarding the conditions of one cycle of alternating current used for the electrochemical roughening treatment, a ratio tc/ta of the anodic reaction time ta of the aluminum plate and the cathodic reaction time tc of the aluminum plate is preferably within a range of 1 to 20, a ratio Qc/Qa of an electricity quantity Qc during the anodic reaction to an electricity quantity Qa during the anodic reaction of the aluminum plate is preferably within a range of 0.3 to 20, and the anodic reaction time ta is preferably within a range of 5 msec to 1,000 msec. The peak current density value of the trapezoidal wave is preferably 10 to 200 $A/dm^2$ at both the anodic cycle side Ia and the cathodic cycle side Ic of the current. Ic/Ia is preferably 0.3 to 20. At a point in time when the electrochemical roughening treatment has ended, the total quantity of electricity that participates in the anodic reaction of the aluminum plate is preferably 25 $C/dm^2$ to 1,000 $C/dm^2$.

The electrochemical roughening treatment using alternating current can be performed using the device shown in Fig. 2.

Fig. 2 is a lateral view showing an example of a radial cell in an electrochemical roughening treatment using alternating current.

In Fig. 2, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic liquid channel, 58 represents an auxiliary anode, 60 represents an auxiliary anode cell, and W represents an aluminum plate. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic liquid channel 57 between the radial drum roller 52 and the main poles 53a and 53b through the slit 56. The aluminum plate W treated in the main electrolytic cell 50 is then electrolyzed in the auxiliary anode cell 60. In the auxiliary anode cell 60, the auxiliary anode 58 is disposed to face the aluminum plate W. The electrolytic solution 55 is supplied to flow in the space between the auxiliary anode 58 and the aluminum plate W.

In view of easily manufacturing a predetermined lithographic printing plate precursor, the amount of the aluminum plate dissolved by the second alkaline etching treatment is preferably 1.0 $g/m^2$ to 20 $g/m^2$ and more preferably 2.0 $g/m^2$ to 10 $g/m^2$.

In view of easily manufacturing a predetermined lithographic printing plate precursor, the amount of the aluminum plate dissolved by the third alkaline etching treatment and the fifth alkaline etching treatment is preferably 0.01 $g/m^2$ to 0.8 $g/m^2$ and more preferably 0.05 $g/m^2$ to 0.3 $g/m^2$.

In the chemical etching treatment (first to fifth desmutting treatments) using an acidic aqueous solution, an acidic aqueous solution containing phosphoric acid, nitric acid, sulfuric acid, chromic acid, hydrochloric acid, or a mixed acid consisting of two or more of these acids is suitably used.

The concentration of the acid in the acidic aqueous solution is preferably 0.5% by mass to 60% by mass.

<<Anodization treatment step>>

The anodization treatment step is a step of performing an anodization treatment on the aluminum plate having undergone the roughening treatment such that an aluminum oxide film is formed on the surface of the aluminum plate. By the anodization treatment, an anodic oxide film of aluminum, having micropores is formed on the surface of the aluminum plate.

The anodization treatment can be performed according to the method known in the field of the related art, by appropriately setting manufacturing conditions in consideration of the desired micropore shape.

In the anodization treatment step, an aqueous solution of sulfuric acid, phosphoric acid, oxalic acid, or the like can be mainly used as an electrolytic solution. In some cases, an aqueous solution or a non-aqueous solution of chromic acid, sulfamic acid, benzene sulfonic acid, or the like or an aqueous solution or a non-aqueous solution combining two or more types among the above acids can also be used. In a case where direct current or alternating current is applied to the aluminum plate in the electrolytic solution, an anodic oxide film can be formed on the surface of the aluminum plate. The electrolytic solution may contain aluminum ions.

The content of the aluminum ions is not particularly limited, but is preferably 1 g/L to 10 g/L.

The conditions of the anodization treatment are appropriately set depending on the electrolytic solution used. Generally, the concentration of the electrolytic solution of 1% by mass to 80% by mass (preferably 5% by mass to 20% by mass), the liquid temperature of 5°C to 70°C (preferably 10°C to 60°C), the current density of 0.5 $A/dm^2$ to 60 $A/dm^2$

(preferably 5 $A/dm^2$ to 50 $A/dm^2$), the voltage of 1 V to 100 V (preferably 5 V to 50 V), and the electrolysis time of 1 second to 100 seconds (preferably 5 seconds to 60 seconds) are appropriate ranges.

One of the preferred examples of the anodization treatment is the anodization method described in British Patent 1,412,768, which is performed in a sulfuric acid at a high current density.

The anodization treatment can also be performed multiple times. It is possible to change one or more of conditions, such as the type, concentration, and liquid temperature of the electrolytic solution used in each anodization treatment, the current density, the voltage, and the electrolysis time. In a case where the anodization treatment is performed twice, sometime the firstly performed anodization treatment is called first anodization treatment, and the secondly performed anodization treatment is called second anodization treatment. Performing the first anodization treatment and the second anodization treatment makes it possible to form anodic oxide films having different shapes and to provide a lithographic printing plate precursor having excellent printing performance.

Furthermore, it is also possible to perform the following pore widening treatment after the anodization treatment and then perform the anodization treatment again. In this case, the first anodization treatment, the pore widening treatment, and the second anodization treatment are performed.

Using the method of performing the first anodization treatment, the pore widening treatment, and the second anodization treatment makes it possible to form micropores each configured with a large diameter portion that extends from the surface of the anodic oxide film along the depth direction and a small diameter portion that is in communication with the bottom portion of the large diameter portion and extends from the communicate position along the depth direction.

<<Pore widening treatment step>>

The pore widening treatment step is a treatment of enlarging the diameter of micropores (pore diameter) present in the anodic oxide film formed by the anodization treatment step (pore diameter enlarging treatment). By the pore widening treatment, the diameter of the micropores is enlarged, and an anodic oxide film having micropores having a larger average diameter is formed.

The pore widening treatment can be carried out by bringing the aluminum plate obtained by the anodization treatment step into contact with an aqueous acid solution or an aqueous alkali solution. The contact method is not particularly limited, and examples thereof include a dipping method and a spraying method. Among these, a dipping method is preferable.

In a case where an aqueous alkali solution is used in the pore widening treatment step, it is preferable to use at least one aqueous alkali solution selected from the group consisting of sodium hydroxide, potassium hydroxide, and lithium hydroxide. The concentration of the aqueous alkali solution is preferably 0.1% by mass to 5% by mass. As an appropriate treatment method, the pH of the aqueous alkali solution is adjusted to 11 to 13, and the aluminum plate is brought into contact with the aqueous alkali solution for 1 second to 300 seconds (preferably 1 second to 50 seconds) under the condition of 10°C to 70°C (preferably 20°C to 50°C). At this time, the alkaline treatment liquid may contain a metal salt of a polyvalent weak acid such as carbonate, borate, or phosphate.

In a case where an aqueous acid solution is used in the pore widening treatment step, it is preferable to use an aqueous solution of an inorganic acid such as sulfuric acid, phosphoric acid, nitric acid, or hydrochloric acid, or a mixture of these. The concentration of the aqueous acid solution is preferably 1% by mass to 80% by mass and more preferably 5% by mass to 50% by mass. As an appropriate treatment method, the aluminum plate is brought into contact with the aqueous acid solution for 1 second to 300 seconds (preferably 1 second to 150 seconds) under the condition of a liquid temperature of the acidic aqueous solution of 5°C to 70°C (preferably 10°C to 60°C).

The aqueous alkali solution or the aqueous acid solution may contain aluminum ions. The content of the aluminum ions is not particularly limited, but is preferably 1 g/L to 10 g/L.

The manufacturing method of the aluminum support having an anodic oxide film may include a hydrophilic treatment step of performing a hydrophilic treatment after the pore widening treatment step described above. As the hydrophilic treatment, it is possible to use the known method described in paragraphs "0109" to "0114" of JP2005-254638A.

The hydrophilic treatment is preferably performed by a method of immersing the aluminum plate in an aqueous solution of an alkali metal silicate such as sodium silicate or potassium silicate, a method of coating the aluminum plate with a hydrophilic vinyl polymer or a hydrophilic compound to form a hydrophilic undercoat layer, or the like.

The hydrophilic treatment using aqueous solution of an alkali metal silicate such as sodium silicate or potassium silicate can be performed according to the method and procedure described in US2714066A and US3181461A.

<Undercoat layer>

The lithographic printing plate precursor used in the present disclosure preferably has an undercoat layer (also called interlayer in some cases) between the image-recording layer and the support. The undercoat layer enhances the

adhesiveness between the support and the image-recording layer in an exposed portion, and enables the image-recording layer to be easily peeled from the support in a non-exposed portion. Therefore, the undercoat layer inhibits the deterioration of printing durability and contributes to the improvement of developability. In addition, in the case of exposure to infrared laser, the undercoat layer functions as a heat insulating layer and thus brings about an effect of preventing sensitivity reduction resulting from the diffusion of heat generated by exposure to the support.

Examples of compounds that are used in the undercoat layer include polymers having absorptive groups that can be absorbed onto the surface of the support and hydrophilic groups. In order to improve adhesiveness to the image-recording layer, it is preferable that polymers having absorptive groups and hydrophilic groups further have crosslinkable groups. The compounds that are used in the undercoat layer may be low-molecular-weight compounds or polymers. As necessary, as the compounds that are used in the undercoat layer, two or more compounds may be used by being mixed together.

In a case where the compound used in the undercoat layer is a polymer, a copolymer of a monomer having an absorptive group, a monomer having a hydrophilic group, and a monomer having a crosslinkable group is preferable.

As the absorptive group that can be absorbed onto the surface of the support, a phenolic hydroxy group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinkable groups, an acryl group, a methacryl group, an acrylamide group, a methacrylamide group, an allyl group, and the like are preferable.

The polymer may have a crosslinkable group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

Specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or high-molecular-weight compounds having crosslinkable groups (preferably ethylenically unsaturated groups), functional groups that interact with the surface of the support, and hydrophilic groups described in JP2005-238816A, JP2005-125749A, JP2006-239867A, and JP2006-215263A are also preferably used.

For example, the high-molecular-weight polymers having absorptive groups that can be absorbed onto the surface of the support, hydrophilic groups, and crosslinkable groups described in JP2005-125749A and JP2006-188038A are more preferable.

The content of ethylenically unsaturated group in the polymer used in the undercoat layer is preferably 0.1 mmol to 10.0 mmol per gram of the polymer and more preferably 0.2 mmol to 5.5 mmol per gram of the polymer.

The weight-average molecular weight (Mw) of the polymer used in the undercoat layer is preferably 5,000 or more and more preferably 10,000 to 300,000.

In order to prevent contamination with the passage of time, the undercoat layer may contain, in addition to the compounds for the undercoat layer described above, a chelating agent, a secondary or tertiary amine, a polymerization inhibitor, a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, hydroxyethyl ethylenediaminetriacetic acid, dihydroxyethyl ethylenediaminediacetic acid, hydroxyethyl iminodiacetic acid, and the like), and the like.

The undercoat layer is formed by known coating methods. The coating amount (solid content) of the undercoat layer is preferably 0.1 $mg/m^2$ to 100 $mg/m^2$ and more preferably 1 $mg/m^2$ to 30 $mg/m^2$.

<Protective layer>

The lithographic printing plate precursor according to the present disclosure preferably has a protective layer (also called "overcoat layer" in some cases) on a surface of the image-recording layer that is opposite to the support side.

In addition, the lithographic printing plate precursor according to the present disclosure preferably has a support, an image-recording layer, and a protective layer in this order.

The protective layer may have a function of preventing the damage of the image-recording layer, and a function of preventing ablation during exposure to high-illuminance lasers, in addition to a function of suppressing the reaction inhibiting image formation by blocking oxygen.

The protective layer having such characteristics is described, for example, in US3458311A and JP1980-49729B (JP-S55-49729B). As polymers with low oxygen permeability that are used in the protective layer, any of water-soluble polymers and water-insoluble polymers can be appropriately selected. As necessary, two or more such polymers can be used by being mixed together. From the viewpoint of on-press developability, the polymers with low oxygen permeability preferably include a water-soluble polymer.

In the present disclosure, a water-soluble polymer means a polymer having a solubility of more than 5% by mass

in water at 25°C.

Examples of the water-soluble polymer used in the protective layer include polyvinyl alcohol, modified polyvinyl alcohol, polyvinylpyrrolidone, a cellulose derivative, polyethylene glycol, poly(meth)acrylonitrile, and the like.

In addition, the hydrophilic polymer preferably includes at least one selected from the group consisting of a modified polyvinyl alcohol and a cellulose derivative.

As the modified polyvinyl alcohol, acid-modified polyvinyl alcohol having a carboxy group or a sulfo group is preferably used. Specific examples thereof include modified polyvinyl alcohols described in JP2005-250216A and JP2006-259137A.

Examples of the cellulose derivative include methyl cellulose, hydroxypropyl methyl cellulose, carboxymethyl cellulose, and the like.

Among the above water-soluble polymers, a polymer containing polyvinyl alcohol is preferable, and a polymer containing polyvinyl alcohol having a saponification degree of 50% or more is more preferable.

The saponification degree is preferably 60% or more, more preferably 70% or more, and even more preferably 85% or more. The upper limit of the saponification degree is not particularly limited, and may be 100% or less.

The saponification degree is measured according to the method described in JIS K 6726: 1994.

As an aspect of the protective layer, for example, an aspect in which the protective layer contains polyvinyl alcohol and polyethylene glycol is also preferable.

In a case where the protective layer in the present disclosure contains the water-soluble polymer, the content of the water-soluble polymer with respect to the total mass of the protective layer is preferably 1% by mass to 99% by mass, more preferably 3% by mass to 97% by mass, and even more preferably 5% by mass to 95% by mass.

The protective layer preferably contains a hydrophobic polymer.

The hydrophobic polymer refers to a polymer that dissolves less than 5 g or does not dissolve in 100 g of pure water at 125°C.

Examples of the hydrophobic polymer include polyethylene, polystyrene, polyvinyl chloride, polyvinylidene chloride, polyalkyl (meth)acrylate ester (for example, polymethyl (meth)acrylate, polyethyl (meth)acrylate, polybutyl (meth)acrylate, and the like), a copolymer obtained by combining raw material monomers of these resins, and the like.

In addition, the hydrophobic polymer preferably includes a polyvinylidene chloride resin.

Furthermore, the hydrophobic polymer preferably includes a styrene-acrylic copolymer (also called styrene acrylic resin).

Furthermore, from the viewpoint of on-press developability, the hydrophobic polymer is preferably hydrophobic polymer particles.

Only one type of hydrophobic polymer may be used, or two or more types of hydrophobic polymers may be used in combination.

In a case where the protective layer contains the hydrophobic polymer, the content of the hydrophobic polymer with respect to the total mass of the protective layer is preferably 1% by mass to 70% by mass, more preferably 5% by mass to 50% by mass, and even more preferably 10% by mass to 40% by mass.

In the present disclosure, the proportion of the area of the hydrophobic polymer occupying the surface of the protective layer is preferably 30 area% or more, more preferably 40 area% or more, and even more preferably 50 area% or more.

The upper limit of the proportion of the area of the hydrophobic polymer occupying the surface of the protective layer is, for example, 90 area%.

The proportion of the area of the hydrophobic polymer occupying the surface of the protective layer can be measured as follows.

By using PHI nano TOFII time-of-flight secondary ion mass spectrometer (TOF-SIMS) manufactured by ULVAC-PHI, INCORPORATED., the surface of the protective layer is irradiated with Bi ion beams (primary ions) at an acceleration voltage of 30 kV, and the peak of ions (secondary ions) corresponding to a hydrophobic portion (that is, a region formed of the hydrophobic polymer) that are emitted from the surface is measured, so that the hydrophobic portion is mapped. By measuring the area of the hydrophobic portion in an area of 100 $\mu m^2$, the proportion of the area occupied by the hydrophobic portion is determined and adopted as "proportion of the area of the hydrophobic polymer occupying the surface of the protective layer".

For example, in a case where the hydrophobic polymer is an acrylic resin, the proportion is measured using the peak of $C_6H_{13}O^-$. In addition, in a case where the hydrophobic polymer is polyvinylidene chloride, the proportion is measured using the peak of $C_2H_2Cl^+$.

The proportion of occupied area can be adjusted by the additive amount of the hydrophobic polymer or the like.

From the viewpoint of development defect suppressiveness, the protective layer preferably contains a filler.

Examples of the filler include inorganic particles, organic resin particles, and an inorganic lamellar compound, and the like. Among these, an inorganic lamellar compound is preferable. Using an inorganic lamellar compound makes it possible to effectively inhibit an attachment re-attached from the roll surface from being directly attached to the surface of

the image-recording layer.

Examples of the inorganic particles include metal oxide particles such as silica particles.

Examples of the organic resin particles include crosslinked resin particles.

The inorganic lamellar compound refers to particles in the form of a thin flat plate, and examples thereof include mica groups such as natural mica and synthetic mica, talc represented by Formula $3MgO \cdot 4SiO \cdot H_2O$, taeniolite, montmorillonite, saponite, hectorite, zirconium phosphate, and the like.

As the inorganic lamellar compound, a mica compound is preferably used. Examples of the mica compound include mica groups such as natural mica and synthetic mica, which are represented by Formula: $A(B, C)_{2-5}D_4O_{10}(OH, F, O)_2$ [here, A represents any of K, Na, and Ca, B and C represent any of Fe (II), Fe (III), Mn, Al, Mg, and V, and D represents Si or Al.].

In the mica group, examples of the natural mica include muscovite, soda mica, phlogopite, biotite, and lepidolite. Examples of synthetic mica include non-swelling mica such as fluorine phlogopite $KMg_3(AlSi_3O_{10})F_2$, potassium tetrasilic mica $KMg_{2.5}Si_4O_{10})F_2$, and, Na tetrasilylic mica $NaMg_{2.5}(Si_4O_{10})F_2$, swelling mica such as Na or Li taeniolite (Na, Li) $Mg_2Li(Si_4O_{10})F_2$, montmorillonite-based Na or Li hectorite $(Na, Li)_{1/8}Mg_{2/5}Li_{1/8}(Si_4O_{10})F_2$. Furthermore, synthetic smectite is also useful.

Among the mica compounds, fluorine-based swelling mica is particularly useful. That is, swelling synthetic mica has a laminated structure consisting of unit crystal lattice layers having a thickness in a range of about 10Å to 15Å (1Å is equal to 0.1 nm), and metal atoms in lattices are more actively substituted than in any other clay minerals. As a result, positive charges are deficient in the lattice layers, and positive ions such as $Li^+$, $Na^+$, $Ca^{2+}$, and $Mg^{2+}$ are absorbed between the layers in order to compensate for the deficiency. Positive ions interposed between the layers are referred to as exchangeable positive ions and are exchangeable with various positive ions. Particularly, in a case where the positive ions between the layers are $Li^+$ and $Na^+$, the ionic radii are small, and thus the bonds between lamellar crystal lattices are weak, and mica is significantly swollen by water. In a case where shearing is applied in this state, mica easily cleavages and forms a stable sol in water. Swelling synthetic mica is particularly preferably used because it clearly exhibits such a tendency.

From the viewpoint of diffusion control, regarding the shapes of the mica compounds, the thickness is preferably thin, and the planar size is preferably large as long as the smoothness and actinic ray-transmitting property of coated surfaces are not impaired. As a result, the aspect ratio is preferably 20 or more, more preferably 100 or more, and particularly preferably 200 or more. The aspect ratio is the ratio of the major diameter to the thickness of a particle, and it can be measured, for example, from a projection view obtained from the microphotograph of the particle. As the aspect ratio increases, the obtained effect is stronger.

Regarding the particle diameter of the mica compound, the average major diameter thereof is preferably 0.3 μm to 20 μm, more preferably 0.5 μm to 10 μm, and particularly preferably 1 μm to 5 μm. The average thickness of the particles is preferably 0.1 μm or less, more preferably 0.05 μm or less, and particularly preferably 0.01 μm or less. Specifically, for example, as a preferable aspect of swelling synthetic mica which is a representative compound, the thickness thereof is in a range of about 1 nm to 50 nm and the surface size (major diameter) is in a range of about 1 μm to 20 μm.

The content of the inorganic lamellar compound with respect to the total mass of the protective layer is preferably 1% by mass to 60% by mass and more preferably 3% by mass to 50% by mass. Even in a case where two or more inorganic lamellar compounds are used in combination, the total amount of the inorganic lamellar compounds preferable equals the content described above. In a case where the content is within the above range, the oxygen barrier property is improved, and excellent sensitivity is obtained. In addition, the deterioration of receptivity can be prevented.

The protective layer may contain known additives such as a plasticizer for imparting flexibility, a surfactant for improving coating property, and inorganic particles for controlling surface sliding property. In addition, the oil sensitizing agent described above regarding the image-recording layer may be contained in the protective layer.

The protective layer is formed by known coating methods. The coating amount (solid content) of the protective layer is preferably 0.01 $g/m^2$ to 10 $g/m^2$, more preferably 0.02 $g/m^2$ to 3 $g/m^2$, and particularly preferably 0.02 $g/m^2$ to 1 $g/m^2$.

The film thickness of the protective layer in the lithographic printing plate precursor according to the present disclosure is preferably 0.1 μm to 5.0 μm and more preferably 0.3 μm to 4.0 μm.

The lithographic printing plate precursor according to the present disclosure may have other layers in addition to those mentioned above.

Known layers can be adopted as those other layers without particular limitations. For example, as necessary, a backcoat layer may be provided on a surface of the support that is opposite to the image-recording layer side.

(Method of preparing lithographic printing plate and lithographic printing method)

Although the method of preparing a lithographic printing plate according to the present disclosure is not particularly limited, but it is preferable that the method of preparing a lithographic printing plate include a step of exposing the lithographic printing plate precursor in the shape of an image (exposure step) and a step of removing the image-recording layer in a non-image area by supplying at least one selected from the group consisting of a printing ink and dampening water to the lithographic printing plate precursor having undergone exposure on a printer (on-press development step).

The lithographic printing method according to the present disclosure preferably includes a step of exposing the lithographic printing plate precursor in the shape of an image (exposure step), a step of removing the image-recording layer in a non-image area by supplying at least one selected from the group consisting of a printing ink and dampening water on a printer to prepare a lithographic printing plate (on-press development step), and a step of performing printing by using the obtained lithographic printing plate (hereinafter, also called "printing step").

<Exposure step>

The method of preparing a lithographic printing plate according to the present disclosure preferably includes an exposure step of exposing the lithographic printing plate precursor in the shape of an image to form an exposed portion and a non-exposed portion. The lithographic printing plate precursor according to the present disclosure is preferably exposed to a laser through a transparent original picture having a linear image, a halftone dot image, or the like or exposed in the shape of an image by laser light scanning according to digital data, or the like.

The wavelength of a light source to be used is preferably 750 nm to 1,400 nm. As the light source having a wavelength of 750 nm to 1,400 nm, a solid-state laser or a semiconductor laser that radiates infrared is suitable. In a case where an infrared laser is used, the output is preferably 100 mW or more, the exposure time per pixel is preferably 20 microseconds or less, and the amount of irradiation energy is preferably 10 $mJ/cm^2$ to 300 $mJ/cm^2$. In addition, in order to shorten the exposure time, a multibeam laser device is preferably used. The exposure mechanism may be any of an inner surface drum method, an external surface drum method, a flat head method, or the like.

The image exposure can be carried out by a common method using a platesetter or the like. In the case of on-press development, image exposure may be carried out on a printer after the lithographic printing plate precursor is mounted on the printer.

<On-press development step>

The method of preparing a lithographic printing plate according to the present disclosure preferably includes an on-press development step of removing the image-recording layer in a non-image area by supplying at least one selected from the group consisting of printing ink and dampening water on a printer.

Hereinafter, the on-press development method will be described.

[On-press development method]

In the on-press development method, the lithographic printing plate precursor having undergone image exposure is preferably supplied with an oil-based ink and an aqueous component on a printer such that the image-recording layer in a non-image area is removed and a lithographic printing plate is prepared.

That is, in a case where the lithographic printing plate precursor is subjected to image exposure and then mounted as it is on a printer without being subjected to any development treatment, or the lithographic printing plate precursor is mounted on a printer and then subjected to image exposure on the printer, and then an oil-based ink and an aqueous component are supplied to perform printing, at the initial stage in the middle of printing, in a non-image area, by either or both of the supplied oil-based ink and the aqueous component, a non-cured image-recording layer is dissolved or dispersed to remove, and the hydrophilic surface is exposed in the non-image area. Meanwhile, the image-recording layer cured by exposure forms an oil-based ink-receiving area having a lipophilic surface in the exposed portion. What is supplied first to the precursor surface may be any of the oil-based ink or the aqueous component. However, in view of preventing the plate from being contaminated by the components of the image-recording layer from which aqueous components are removed, it is preferable that the oil-based ink be supplied first. In the manner described above, the lithographic printing plate precursor is subjected to on-press development on a printer and used as it is for printing a number of sheets. As the oil-based ink and the aqueous component, ordinary printing ink and ordinary dampening water for lithographic printing are suitably used.

<Printing step>

The lithographic printing method according to the present disclosure includes a printing step of printing a recording medium by supplying a printing ink to the lithographic printing plate.

The printing ink is not particularly limited, and various known inks can be used as desired. In addition, preferred examples of the printing ink include oil-based ink or ultraviolet-curable ink (UV ink).

In the printing step, as necessary, dampening water may be supplied.
In addition, the printing step may be successively carried out after the on-press development step or the development step using a developer, without stopping the printer.
The recording medium is not particularly limited, and a known recording medium can be used as desired.
In the method of preparing a lithographic printing plate and the lithographic printing method according to the present disclosure, as necessary, the entire surface of the lithographic printing plate precursor may be heated before exposure, in the middle of exposure, or during a period of time from exposure to development. In a case where the lithographic printing plate precursor is heated as above, an image-forming reaction in the image-recording layer is accelerated, which can result in advantages such as improvement of sensitivity and printing durability, and stabilization of sensitivity. Heating before development is preferably carried out under a mild condition of 150°C or lower. In a case where this aspect is adopted, it is possible to prevent problems such as curing of a non-image area. For heating after development, it is preferable to use an extremely severe condition which is preferably in a range of 100°C to 500°C. In a case where this aspect is adopted, a sufficient image-strengthening action is obtained, and it is possible to inhibit problems such as the deterioration of the support or the thermal decomposition of the image area.

(Laminate)

The laminate according to the present disclosure is formed by at least laminating the on-press development type lithographic printing plate precursors according to the present disclosure.
In addition, it is preferable that the laminate according to the present disclosure includes laminated on-press development type lithographic printing plate precursors, the on-press development type lithographic printing plate precursor including an image-recording layer on a support and having a surface free energy of an outermost layer on an image-recording layer side of 115 $mJ/m^2$ or less, in which the image-recording layer contains an infrared absorber A, a borate compound B, an iodonium compound C, and a color forming substance precursor D, in which a protective material that protects the on-press development type lithographic printing plate precursor disposed on at least an uppermost portion of the laminated on-press development type lithographic printing plate precursors is provided, and the protective material has a moisture content of 10% by mass or less.
The on-press development type lithographic printing plate precursor is in the form of one sheet of thin plate adopting a metal as a support. Therefore, in a case where damages or deformation occurs in the corners, sides, inside, or the like of the lithographic printing plate precursor, unfortunately, images are likely to be blurred by photosensitization, or ink is likely to be non-uniformly distributed by printing.
Therefore, in a case where a plurality of precursors is laminated to constitute a laminate, in order to protect the on-press development type lithographic printing plate precursor, generally, the protective material is disposed between a predetermined number of the precursors such that the precursors are reliably protected.
Furthermore, the precursors between which the protective material is disposed are packaged as they are with a packaging material to prepare a packaged substance, and handled (transported, stored, or the like). In a case where the protective material is disposed, deformation (such as bending) of the precursor is unlikely to occur during, for example, handling, which prevents damage of the precursor. In addition, even though external force acts, the external force is partially absorbed into the protective material, which prevents deformation or damages of the precursor.
Preferred aspects of the on-press development type lithographic printing plate precursor in the laminate according to the present disclosure is the same as the preferred aspects of the on-press development type lithographic printing plate precursor according to the present disclosure described above.

<Protective material>

The laminate according to the present disclosure preferably has a protective material that protects the on-press development type lithographic printing plate precursor disposed on at least the uppermost portion of the laminated on-press development type lithographic printing plate precursors, and a moisture content of the protective material is preferably 10% by mass or less.
From the viewpoint of development defect suppressiveness, the moisture content of the protective material is preferably 10% by mass or less, more preferably 7% by mass or less, and particularly preferably 3% by mass or less. The lower limit value of the moisture content is 0% by mass.
Examples of the material of the protective material include thick paper, cardboard, plastic, and the like. Among these, from the viewpoint of development defect suppressiveness, cardboard or plastic is preferable, and plastic is more preferable.
As the plastic, a known polymer can be used, and examples thereof include polyester, polycarbonate, and polyolefin. Among these, polyester is preferable.
The size (length × width) of the protective material is not particularly limited and can be appropriately selected

depending on the on-press development type lithographic printing plate precursor to be used. For example, the size of the protective material is the same as or slightly larger than the size of the on-press development type lithographic printing plate precursor.

The thickness of the protective material is not particularly limited. From the viewpoint of strength, moisture permeability, and development defect suppressiveness, the thickness of the protective material is preferably 10 μm to 10 mm and more preferably 100 μm to 5 mm.

In addition, it is preferable that the protective material be disposed not only in the uppermost portion of the laminate but also in the lowermost portion.

interleaving paper>

The laminate according to the present disclosure may have interleaving paper between two on-press development type laminated lithographic printing plate precursors.

In addition, the interleaving paper may be between the on-press development type lithographic printing plate precursor and the protective material.

Furthermore, the interleaving paper may be in the lowermost portion of the laminate.

In order to reduce the material cost, it is preferable to select low-cost raw materials as the material of the interleaving paper used in the present disclosure. For example, it is possible to use paper using wood pulp 100% by mass, paper using wood pulp together with synthetic pulp, paper composed of the above paper and a low-density or high-density polyethylene layer provided on the surface of the paper, and the like.

Specifically, examples thereof include acidic paper made of paper stock prepared by adding a sizing agent and a paper strengthening agent to paper stock obtained by beating bleached kraft pulp and then diluting the beaten pulp to a concentration of 4% by mass such that the amounts of the sizing agent and paper strengthening agent are 0.1% by mass and 0.2% by mass respectively with respect to the mass of the paper stock and then adding aluminum sulfate thereto until the pH reaches 5.0. It is preferable to use alkaline paper having a pH of 7 to 8 in which a neutral sizing agent, such as an alkyl ketene dimer (AKD) or an alkenyl succinic anhydride (ASA), is used as a sizing agent and calcium carbonate is used as a filler instead of aluminum sulfate.

As the interleaving paper, among these, paper is preferable, paper containing aluminum sulfate or calcium carbonate is more preferable, and paper containing calcium carbonate is particularly preferable.

The material of the interleaving paper is preferably paper containing 50% by mass or more of pulp, more preferably paper containing 70% by mass or more of pulp, and particularly preferably paper containing 80% by mass or more of pulp.

In the interleaving paper, the calcium content with respect to the total mass of the interleaving paper is preferably 0.15% by mass to 0.5% by mass, more preferably 0.2% by mass to 0.45% by mass, and particularly preferably 0.25% by mass to 0.4% by mass.

The calcium content of the interleaving paper is obtained by performing X-ray fluorescence spectrometry on the interleaving paper.

The calcium contained in paper is mainly calcium carbonate which is widely used as a filler for alkaline paper, and performs an action of increasing whiteness of the paper.

The basis weight of the interleaving paper (determined by measuring method specified in JIS P8124 (2011)) is not particularly limited, but from the viewpoints of printing durability and on-press developability, is preferably 29 $g/m^2$ to 80 $g/m^2$, more preferably 35 $g/m^2$ to 70 $g/m^2$, and particularly preferably 51 $g/m^2$ to 65 $g/m^2$.

From the viewpoints of UV printing durability and on-press developability, the basis weight of the interleaving paper is preferably 51 $g/m^2$ or more.

The thickness of the interleaving paper (determined by the measuring method specified in JIS P8118 (2014)) is not particularly limited, but is preferably 20 μm to 100 μm, more preferably 42 μm to 80 μm, even more preferably 45 μm to 65 μm, and particularly preferably 45 μm to 55 μm.

From the viewpoint of dot-like color defect suppressiveness, the moisture content of the interleaving paper (moisture content of the interleaving paper stored at 25°C/50% RH until the moisture content of the interleaving paper is stabilized) with respect to the total mass of the interleaving paper is preferably 0% by mass to 20% by mass, more preferably 0% by mass to 15% by mass, and particularly preferably 0% by mass to 10% by mass.

As the interleaving paper, the interleaving paper described in JP2010-76336A can be suitably used.

The shape of the interleaving paper is not particularly limited, and examples thereof include a shape which is the same as or larger than the shape of the lithographic printing plate precursor in the plane direction.

The laminate according to the present disclosure may be entirely packaged by a known method.

Examples

Hereinafter, the present disclosure will be described in detail with reference to examples, but the present disclosure is not limited thereto. In the present examples, unless otherwise specified, "%" and "part" mean "% by mass" and "part by mass" respectively. Unless otherwise described, the molecular weight of a high-molecular-weight compound is a weight-average molecular weight (Mw), and the ratio of repeating constitutional units of a polymer compound is expressed as molar percentage. In addition, the weight-average molecular weight (Mw) is a polystyrene-equivalent molecular weight measured by gel permeation chromatography (GPC).

(Examples 1 and 4 to 6 and Comparative Example 1)

(1) Production of support A:

«Mechanical roughening treatment (brush graining method)»

A pumice suspension (specific gravity: 1.1 g/$cm^3$) as an abrasive slurry was supplied to the surface of an aluminum plate, and in this state, a mechanical roughening treatment is performed using a rotating bundled brush to grain the surface of an aluminum plate. In the mechanical roughening treatment, an abrasive having a median diameter ($\mu$m) of 30 $\mu$m and 4 brushes were used, and the rotation speed (revolutions per minute (rpm)) of the brushes was set to 250 rpm. The bundled brush was made of 6·10 nylon and consisted of bristles having a diameter of 0.3 mm and a length of 50 mm. The brush was prepared by making holes in a $\phi$ 300 mm stainless steel cylinder and densely implanting bristles therein. The distance between two support rollers ($\phi$ 200 mm) under the bundled brush was 300 mm. The bundled brush was pressed until the load of the drive motor for rotating the brush was 10 kW higher than the load applied before the bundled brush was pressed on the aluminum plate. The rotation direction of the brush was the same as the moving direction of the aluminum plate.

<<Alkaline etching treatment>>

The aluminum plate obtained in the above-described manner was subjected to an etching treatment by spraying a caustic soda aqueous solution in which the concentration of caustic soda was 26% by mass and the concentration of aluminum ions was 6.5% by mass using a spray at a temperature of 70°C. Then, water washing was performed by means of spraying. The amount of dissolved aluminum was 6 g/$m^2$.

<<Desmutting treatment using acidic aqueous solution>>

Next, a desmutting treatment was performed using an aqueous nitric acid solution. Specifically, the desmutting treatment was performed for 3 seconds by spraying the aqueous nitric acid solution onto the aluminum plate. As the aqueous nitric acid solution used for the desmutting treatment, a waste liquid of nitric acid used for the subsequent electrochemical roughening treatment step was used. The liquid temperature was 35°C.

<<Electrochemical roughening treatment>>

An electrochemical roughening treatment was continuously performed using an AC voltage of 60 Hz in nitric acid electrolysis. As an electrolytic solution at this time, an electrolytic solution which had been adjusted to have a concentration of aluminum ions of 4.5 g/L by adding aluminum nitrate to a nitric acid aqueous solution having a concentration of 10.4 g/L at a liquid temperature of 35°C was used. By using an alternating current power source having the waveform shown in Fig. 1, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 2 was used. The current density was 30 A/$dm^2$ in terms of the peak value of current, and 5% of the current coming from the power source was allowed to flow into the auxiliary anode. The electricity quantity (C/$dm^2$) was 185 C/$dm^2$, which is the total quantity of electricity used during the anodic reaction of the aluminum plate. Then, water washing was performed by means of spraying.

<<Alkaline etching treatment>>

The aluminum plate obtained in the above-described manner was subjected to an etching treatment by spraying a caustic soda aqueous solution in which the concentration of caustic soda was 27% by mass and the concentration of

aluminum ions was 2.5% by mass using a spray at a temperature of 45°C. Then, water washing was performed by means of spraying.

Changing the temperature in the alkaline etching treatment makes it possible to control the etching amount of aluminum of a surface subjected to a roughening treatment and to adjust the L value of the support.

<<Desmutting treatment using acidic aqueous solution>>

Next, a desmutting treatment was performed using an aqueous sulfuric acid solution. Specifically, the desmutting treatment was performed for 3 seconds by spraying the aqueous sulfuric acid solution onto the aluminum plate. As the aqueous sulfuric acid solution used for the desmutting treatment, an aqueous solution having a sulfuric acid concentration of 170 g/L and an aluminum ion concentration of 5 g/L was used. The liquid temperature was 30°C.

<<Electrochemical roughening treatment>>

An electrochemical roughening treatment was continuously performed using an AC voltage of 60 Hz in hydrochloric acid electrolysis. An electrolytic solution at a liquid temperature of 35°C was used which was prepared by adding aluminum chloride to 6.2 g/L aqueous hydrochloric acid solution such that the aluminum ion concentration was adjusted to 4.5 g/L. By using an alternating current power source having the waveform shown in Fig. 1, alternating current having a trapezoidal rectangular waveform, and a carbon electrode as a counter electrode, an electrochemical roughening treatment was performed under the conditions of a time tp taken for the current value to reach the peak from zero of 0.8 msec and the duty ratio of 1:1. As an auxiliary anode, ferrite was used. The electrolytic cell shown in Fig. 2 was used. The current density was 25 $A/dm^2$ in terms of the peak value of current, and the quantity of electricity ($C/dm^2$) during the hydrochloric acid electrolysis was 63 $C/dm^2$ which is the total quantity of electricity used during the anodic reaction of the aluminum plate. Then, water washing was performed by means of spraying.

<<Desmutting treatment using acidic aqueous solution>>

Next, a desmutting treatment was performed using an aqueous sulfuric acid solution. Specifically, the desmutting treatment was performed for 3 seconds by spraying the aqueous sulfuric acid solution onto the aluminum plate. As the aqueous sulfuric acid solution used for the desmutting treatment, a waste liquid generated in the anodization treatment step (an aqueous solution having a sulfuric acid concentration of 170 g/L and an aluminum ion concentration of 5 g/L) was used. The liquid temperature was 35°C.

<<First-stage anodization treatment>>

By using the anodization device for direct current electrolysis, a first-stage anodization treatment was performed to form an anodic oxide film having a film thickness of 110 nm.

<<Pore widening treatment>>

The aluminum plate having undergone the above anodization treatment was immersed in an aqueous solution of caustic soda at a temperature of 40°C and having a caustic soda concentration of 5% by mass and an aluminum ion concentration of 0.5% by mass for 2.7 seconds, thereby performing a pore widening treatment. Then, water washing was performed by means of spraying.

<<Second-stage anodization treatment>>

By using the anodization device for direct current electrolysis, a second-stage anodization treatment was performed to form an anodic oxide film having a film thickness of 1,500 nm and to prepare the support A.

<Formation of undercoat layer 1>

The support A was coated with the undercoat layer coating liquid 1 having the following composition such that the dry coating amount was 0.1 $g/m^2$, to form an undercoat layer 1.

[Undercoat layer coating liquid 1]

· Compound for undercoat layer (the following U-1, 11% aqueous solution): 0.10502 parts
· Sodium gluconate: 0.0700 parts
· Surfactant (EMALEX (registered trademark) 710, NIHON EMULSION Co., Ltd.): 0.00159 parts
· Preservative (BIOHOPE L, manufactured by K·I Chemical Industry Co., LTD.): 0.00149 parts
· Water: 3.29000 parts

(U-1)

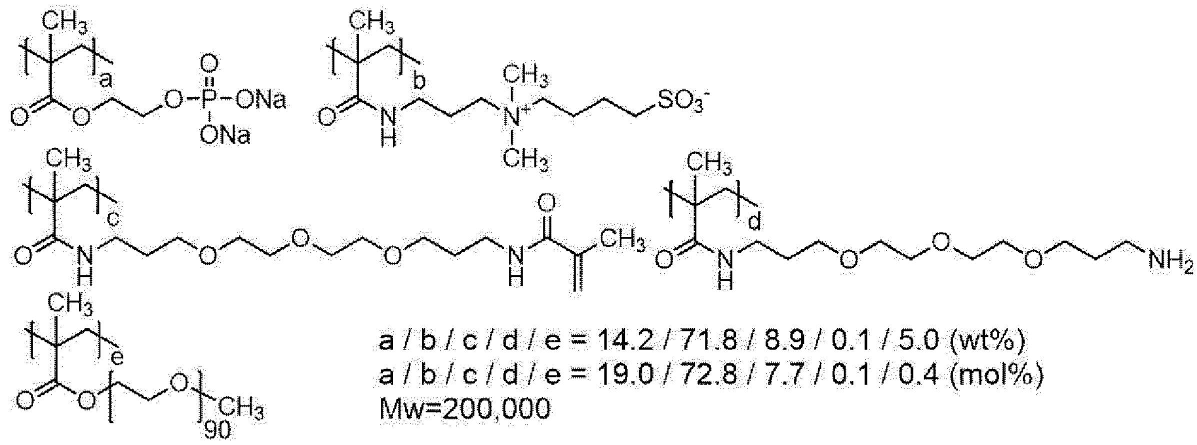

a / b / c / d / e = 14.2 / 71.8 / 8.9 / 0.1 / 5.0 (wt%)
a / b / c / d / e = 19.0 / 72.8 / 7.7 / 0.1 / 0.4 (mol%)
Mw=200,000

<Formation of image-recording layer 1>

The undercoat layer 1 was bar-coated with the image-recording layer coating liquid 1, followed by drying in an oven at 120°C for 40 seconds, thereby forming an image-recording layer 1 having a dry coating amount of 1.0 g/m$^2$.

-Image-recording layer coating liquid 1-

The following components were dissolved and dispersed in a mixed solvent of 1-methoxy-2-propanol (MFG), methyl ethyl ketone (MEK), and methanol (MFG:MEK:methanol = 4:4:1 (mass ratio)), and the solid content was prepared to 6%, thereby preparing an image-recording layer coating liquid 1.

-Image-recording layer coating liquid 1-

Infrared absorber (A-1): 0.0080 parts
Infrared absorber (A-2): 0.0270 parts
Borate compound (B-1): 0.0200 parts
Iodonium compound (C-1): 0.1000 part
Color forming substance precursor (D-1): 0.0300 parts
Color forming substance precursor (D-2): 0.0120 parts
Polymerizable compound (the following M-1): 0.1908 parts
Anionic surfactant (W-1): 0.0060 parts
Fluorine-based surfactant (W-2): 0.0042 parts
Additive (P-1): 0.0125 parts
Microgel (1): 2.0000 parts

| | |
|---|---|
| P-1 | 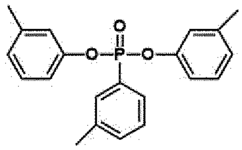 |
| A-1 | 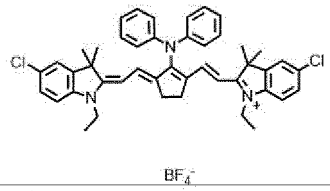 |
| A-2 | 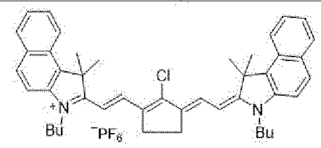 |
| C-1 | 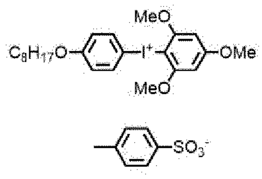 |
| D-1 | 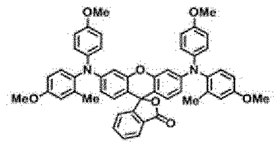 |
| D-2 | 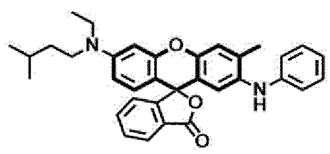 |
| W-1 | 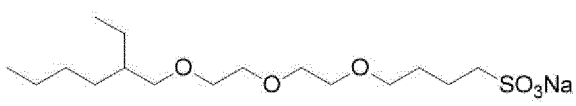 |
| B-1 | 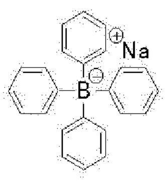 |
| W-2 | 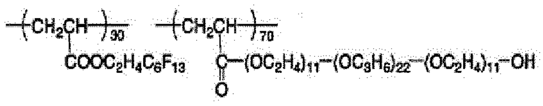 |

<Synthesis method of polymerizable compound (M-1)>

A mixed solution of TAKENATE D-160N (polyisocyanate trimethylolpropane adduct, manufactured by Mitsui Chemicals, Inc., 4.7 parts), ARONIX M-403 (manufactured by TOAGOSEI CO., LTD., amount yielding the ratio of NCO value of TAKENATE D-160N:hydroxyl number of ARONIX M-403 = 1:1), t-butylbenzoquinone (0.02 parts), and methyl ethyl ketone (11.5 parts) was heated at 65°C. NEOSTAN U-600 (bismuth-based polycondensation catalyst, manufactured by NITTO KASEI CO., LTD., 0.11 parts) was added to the reaction solution, and the reaction solution was heated at 65°C for 4 hours. The reaction solution was cooled to room temperature (25°C), and methyl ethyl ketone was added thereto, thereby synthesizing a urethane acrylate (M-1) solution having a solid content of 50% by mass.

A method of preparing a microgel (1) will be described below.

<Preparation of polyvalent isocyanate compound (1)>

43 mg of bismuth tris(2-ethylhexanoate) (NEOSTANN U-600, manufactured by NITTO KASEI CO., LTD.) was added to an ethyl acetate (25.31 g) suspension solution of 17.78 g (80 mmol) of isophorone diisocyanate and 7.35 g (20 mmol) of the following polyhydric phenol compound (1), and the resulting solution was stirred. The reaction temperature was set to 50°C at a point in time when heat release subsided, and the solution was stirred for 3 hours, thereby obtaining an ethyl acetate solution of the polyvalent isocyanate compound (1) (50% by mass).

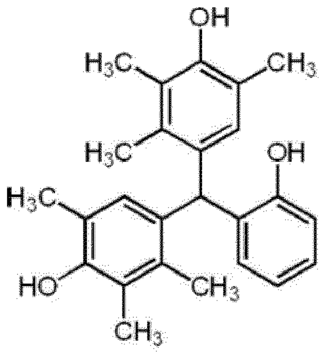

polyhydric phenol compound (1)

<Preparation of microgel (1)>

The following oil-phase components and water-phase components were mixed together and emulsified at 12,000 rpm for 10 minutes by using a homogenizer. The obtained emulsion was stirred at 45°C for 4 hours, 5.20 g of a 10% by mass aqueous solution of 1,8-diazabicyclo[5.4.0]undec-7-ene-octylate (U-CAT SA102, manufactured by San-Apro Ltd.) was added thereto, and the solution was stirred at room temperature for 30 minutes and left to stand at 45°C for 24 hours. Distilled water was added thereto such that the concentration of solid contents was adjusted to 20% by mass, thereby obtaining an aqueous dispersion liquid of a microgel (1). The average particle diameter thereof measured by a light scattering method was 0.28 μm.

-Oil-phase component-

(Component 1) ethyl acetate: 12.0 g
(Component 2) adduct (50 mass% ethyl acetate solution, manufactured by Mitsui Chemicals, Inc.) obtained by adding trimethylolpropane (6 mol) and xylene diisocyanate (18 mol) and adding methyl side-terminal polyoxyethylene (1 mol, number of repeating oxyethylene units: 90) thereto: 3.76 g
(Component 3) polyvalent isocyanate compound (1) (as 50% by mass ethyl acetate solution): 15.0 g
(Component 4) 65% by mass ethyl acetate solution of dipentaerythritol pentaacrylate (SR-399, manufactured by Arkema S.A.): 11.54 g
(Component 5) 10% ethyl acetate solution of sulfonate type surfactant (PIONIN A-41-C, manufactured by TAKEMOTO OIL & FAT Co., Ltd.): 4.42 g

-Water-phase component-

Distilled water: 46.87 g

<Formation of protective layer 1>

The image-recording layer was bar-coated with the following protective layer coating liquid 1 and dried in an oven at 120°C for 60 seconds, thereby forming a protective layer 1 having a dry coating amount of 0.05 g/m$^2$. In this way, a lithographic printing plate precursor was prepared. In Comparative Example 1, the protective layer was not formed.

-Protective layer coating liquid 1-

Inorganic lamellar compound dispersion liquid (1) (described below): 0.3375 parts
Hydrophilic polymer (1) (20% aqueous solution of the following compound): 0.0825 parts
METOLOSE SM04 (methyl cellulose, manufactured by Shin-Etsu Chemical Co., Ltd., methoxy substitution degree = 1.8): 0.0125 parts
RAPISOL A-80 (anionic surfactant, manufactured by NOF CORPORATION, 80% aqueous solution): 0.0094 parts
Ion exchanged water: 3.0581 parts

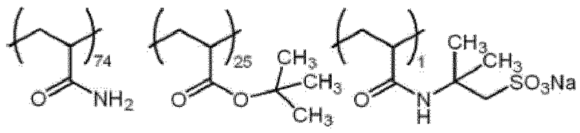

Hydrophilic polymer (1)

The method of preparing an inorganic lamellar compound dispersion liquid (1) used in the protective layer coating liquid will be described below.

-Preparation of inorganic lamellar compound dispersion liquid (1)-

Synthetic mica (SOMASIF ME-100 manufactured by Co-op Chemical Co., Ltd., 6.4 parts) was added to ion exchanged water (193.6 parts) and was dispersed using a homogenizer until the average particle diameter (the laser scattering method) reached 3 μm. The aspect ratio of the obtained dispersed particles was 100 or more.

<Development defect suppressiveness>

The lithographic printing plate precursor having a size of 62 cm × 40 cm was passed through the nip roll 50 times, 30 sheets of interleaving paper and 30 sheets of the lithographic printing plate precursor are laminated alternately, and the obtained laminate was further overlapped with the protective material having a size of 62 cm × 40 cm × 0.65 mm described in Table 2 on top and bottom and packaged with aluminum kraft paper. The packaged article was left to stand in an environment of 50°C for 20 days to produce a laminate. In all the laminates, the lithographic printing plate precursors were laminated with the support side facing down. The following evaluations were performed using a lithographic printing plate precursor which was in contact with a protective material at the uppermost portion of the obtained laminate through an interleaving paper.

Each of the obtained lithographic printing plate precursors was exposed by Luxel (registered trademark) PLATESETTER T-6000III (manufactured by Fujifilm Corporation) equipped with an infrared semiconductor laser under conditions of an outer drum rotation speed of 1,000 rpm, a laser output of 70%, and a resolution of 2,400 dpi. The exposure image included a solid image, a fine linear image (a test chart in which the thickness of the fine line (fine line-shaped image area in the non-image area) was changed at intervals of 2 μm from 4 μm to 30 μm), and a 50% halftone dot chart of a 20 μm dot FM screen.

The obtained exposed precursor was mounted to the plate cylinder of a printer LITHRONE26 (manufactured by KOMORI Corporation) without performing a development treatment. By using dampening water containing Ecolity-2 (manufactured by FUJIFILM Corporation)/tap water = 2/98 (volume ratio) and Values-G(N) black ink (manufactured by DIC Corporation), on-press development was performed by supplying the dampening water and ink according to the standard automatic printing start method of LITHRONE26. Thereafter, printing was performed on 100 sheets of TOKUBISHI ART (manufactured by MITSUBISHI PAPER MILLS LIMITED., ream weight: 76.5 kg) at a printing rate of

10,000 sheets/hour.

The number of the printing papers required until the ink on the non-image area of the printed matter was completely wiped off was measured as the development defect suppressiveness.

<Suppressiveness of development defect by shearing>

In addition to the above-described pressurization method using the nip roll in <Development defect suppressiveness>, for evaluation of the development defect by shearing, a sample for evaluation by shearing was produced by the following method.

The lithographic printing plate precursor was cut to be striped with a width of 20 mm and a length of 300 mm. The striped sample was installed as shown in Fig. 4. In Fig. 4, a surface of the striped sample 12 on the image-recording layer side is in contact with a surface of a transport roll 14 made of acrylonitrile butadiene rubber (NBR), and the transport roll 14 is connected to a brake equipment (manufactured by Tsubakimoto Chain Co., model number: MK10, not shown) capable of arbitrarily adjusting an activation torque. In addition, among both terminals of the striped sample 12 having a length of 300 mm, one terminal was fixed to an air cylinder 16 (manufactured by Airtac International Group, model number: HLH10X50S) capable of acceleration and deceleration, and the other terminal was fixed to a weight 18 (500 g) capable of achieving a transport tension.

By operating the activation torque, a roll slip occurs between the striped sample 12 and the transport roll 14. The activation torque was adjusted to cause reciprocating motion 20 times with a stroke of 100 mm such that the roll slip was 0.098 $m/s^2$ at both of an acceleration and a deceleration, and a sample for evaluation by shearing was produced. The sample for evaluation by shearing was packaged by the above-described method, and left to stand in an environment of 50°C for 20 days to produce a laminate.

Using the lithographic printing plate precursor which was in contact with a protective material at the uppermost portion of the obtained laminate through an interleaving paper, the number of the printing papers required until the ink on the non-image area of the printed matter was completely wiped off was measured as the suppressiveness of the development defect by shearing, by the same operation as the above-described development defect suppressiveness.

<Moisture content measurement method>

The moisture content (equilibrium moisture content) of the protective material was measured by a measuring method according to JIS P 8202.

(Examples 2 and 3 and Comparative Examples 2 and 3)

(1) Production of support B:

The following treatments (F-a) to (F-g) were performed on an aluminum plate to produce a support B. A water washing treatment was performed between all the treatment steps. After the water washing treatment, water was drained using a nip roller.

(F-a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. The amount of dissolved aluminum within the surface to be subjected to the electrochemical roughening treatment later was 5 $g/m^2$.

(F-b) Desmutting treatment using acidic aqueous solution

As an acidic aqueous solution, an aqueous solution at a liquid temperature of 30°C having a sulfuric acid concentration of 150 g/L was sprayed on an aluminum plate for 3 seconds, thereby performing a desmutting treatment.

(F-c) Electrochemical roughening treatment

An electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 $A/dm^2$ in terms of the peak current value of the alternating current waveform. In addition, the quantity of electricity was 450 $C/dm^2$ which was the total quantity of electricity used for the aluminum plate to have an anodic reaction, and the electrolytic treatment was performed 4 times by conducting electricity of 112.5 $C/dm^2$ for 4 seconds at each treatment session. A carbon electrode was used as the counter electrode of the aluminum plate.

(F-d) Alkaline etching treatment

An aqueous solution of caustic soda having a caustic soda concentration of 5% by mass and an aluminum ion concentration of 0.5% by mass was sprayed onto the aluminum plate at a temperature of 45°C, thereby performing an etching treatment. The amount of dissolved aluminum within the surface having undergone the electrochemical roughening treatment was 0.2 $g/m^2$.

(F-e) Desmutting treatment using acidic aqueous solution

As an acidic aqueous solution, an aqueous solution at a liquid temperature of 35°C having a sulfuric acid concentration of 170 g/L and an aluminum ion concentration of 5 g/L was sprayed on an aluminum plate for 3 seconds, thereby performing a desmutting treatment.

(F-f) First-stage anodization treatment

By using the anodization device for direct current electrolysis having the structure shown in Fig. 3, a first-stage anodization treatment was performed. By using a 150 g/L aqueous phosphoric acid solution as an electrolytic solution, an anodization treatment was performed under the conditions of a liquid temperature of 35°C and a current density of 4.5 $A/dm^2$, thereby forming an anodic oxide film having a film amount of 1 $g/m^2$.

In the anodization treatment device 610 shown in Fig. 3, an aluminum plate 616 is transported as indicated by the arrow in Fig. 3. In a power supply tank 612 storing an electrolytic solution 618, the aluminum plate 616 is positively (+) charged by a power supply electrode 620. Further, the aluminum plate 616 is transported upward by a roller 622 in the power supply tank 612, redirected downward by a nip roller 624, transported toward an electrolytic treatment tank 614 in which an electrolytic solution 626 is stored, and redirected to the horizontal direction by a roller 628. Next, the aluminum plate 616 is negatively (-) charged by an electrolysis electrode 630 so that an anodic oxide film is formed on the surface thereof, and the aluminum plate 616 coming out of the electrolytic treatment tank 614 is transported to the next step. In the anodization device 610, direction changing means is formed of the roller 622, the nip roller 624, and the roller 628. The aluminum plate 616 is transported in a mountain shape and an inverted U shape by the roller 622, the nip roller 624, and the roller 628 in an inter-tank portion between the power supply tank 612 and the electrolytic treatment tank 614. The power supply electrode 620 and the electrolysis electrode 630 are connected to a direct current power source 634. A tank wall 632 is disposed between the power supply tank 612 and the electrolytic treatment tank 614.

(F-g) Second-stage anodization treatment

By using the anodization device for direct current electrolysis having the structure shown in Fig. 3, a second-stage anodization treatment was performed. By using a 170 g/L aqueous sulfuric acid solution as an electrolytic solution, an anodization treatment was performed under the conditions of a liquid temperature of 50°C and a current density of 13 $A/dm^2$, thereby forming an anodic oxide film having a film amount of 2.1 $g/m^2$. Then, water washing was performed by means of spraying. The average diameter of the micropores in the support B was 40 nm.

(1) Production of support C:

The following treatments (F-a) to (F-f) were performed on an aluminum plate to produce a support C. A water washing treatment was performed between all the treatment steps. After the water washing treatment, water was drained using a nip roller.

(F-a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an

etching treatment. The amount of dissolved aluminum within the surface to be subjected to the electrochemical roughening treatment later was 5 g/$m^2$.

(F-b) Desmutting treatment using acidic aqueous solution

As an acidic aqueous solution, an aqueous solution at a liquid temperature of 30°C having a sulfuric acid concentration of 150 g/L was sprayed on an aluminum plate for 3 seconds, thereby performing a desmutting treatment.

(F-c) Electrochemical roughening treatment

An electrochemical roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/$dm^2$ in terms of the peak current value of the alternating current waveform. In addition, the quantity of electricity was 450 C/dm2 which was the total quantity of electricity used for the aluminum plate to have an anodic reaction, and the electrolytic treatment was performed 4 times by conducting electricity of 112.5 C/$dm^2$ for 4 seconds at each treatment session. A carbon electrode was used as the counter electrode of the aluminum plate.

(F-d) Alkaline etching treatment

An aqueous solution of caustic soda having a caustic soda concentration of 5% by mass and an aluminum ion concentration of 0.5% by mass was sprayed onto the aluminum plate at a temperature of 45°C, thereby performing an etching treatment. The amount of dissolved aluminum within the surface having undergone the electrochemical roughening treatment was 0.2 g/$m^2$.

(F-e) Desmutting treatment using acidic aqueous solution

As an acidic aqueous solution, an aqueous solution at a liquid temperature of 35°C having a sulfuric acid concentration of 170 g/L and an aluminum ion concentration of 5 g/L was sprayed on an aluminum plate for 3 seconds, thereby performing a desmutting treatment.

(F-f) First-stage anodization treatment

By using the anodization device for direct current electrolysis having the structure shown in Fig. 3, a first-stage anodization treatment was performed. By using a 150 g/L aqueous phosphoric acid solution as an electrolytic solution, an anodization treatment was performed under the conditions of a liquid temperature of 35°C and a current density of 4.5 A/$dm^2$, thereby forming an anodic oxide film having a film amount of 1 g/$m^2$.

The average diameter of the micropores in the support C was 40 nm.

<Formation of undercoat layer 2>

The support described in Table 2 was coated with the undercoat layer coating liquid 2 having the following composition such that the dry coating amount was 0.03 mg/$m^2$. In this way, an undercoat layer 2 was formed.

-Undercoat layer coating liquid 2-

· Aqueous polyacrylic acid solution (solid content of 40% by mass, Jurymer AC-10S, manufactured by TOAGOSEI CO., LTD.): 3.0 parts
· Water: 27.0 parts

<Formation of image-recording layer 2>

The undercoat layer 2 was bar-coated with an image recording layer coating liquid 2 with the following composition and dried in an oven at 110°C for 40 seconds, thereby forming an image-recording layer 2 having a dry weight of 0.9/$m^2$.

-Image-recording layer coating liquid 2-

Polymer dispersion liquid: 0.675 parts
Hydroxypropyl methyl cellulose: 0.400 parts
Monomer 1: 0.036 parts
Monomer 2: 0.115 parts
Monomer 3: 0.087 parts
Infrared absorber (IR Dye-6): 0.028 parts
Surfactant 1: 0.045 parts
Iodonium salt 1: 0.073 parts
Iodonium salt 2: 0.053 parts
Leuco colorant (Leuco-3): 0.040 parts
Phenothiazine: 0.005 parts
1-Propanol: 2.6 parts
2-Butanone: 3.5 parts
1-Methoxy-2-propanol: 0.92 parts
δ-butyrolactone: 0.10 parts
Water: 1.16 parts

Polymer dispersion liquid: a dispersion obtained by dispersing polymer particles of a graft copolymer of polyethylene glycol) methyl ether methacrylate/styrene/acrylonitrile (= 10:9:81 [mass ratio]), at 24% by mass, in a solvent in which a mass ratio of n-propanol/water is 80/20. In addition, a volume average particle diameter of the polymer particles in the dispersion was 193 nm.

Hydroxypropyl methyl cellulose is a 5% aqueous solution. In addition, in the hydroxypropyl methyl cellulose, 30% of hydroxyl groups in cellulose are methoxylated, and 10% of hydroxyl groups in cellulose are hydroxypropoxylated. The hydroxypropyl methyl cellulose has a viscosity of 5 mPa·s in a 2% by mass aqueous solution at 20°C.

Monomer 1: the following compound

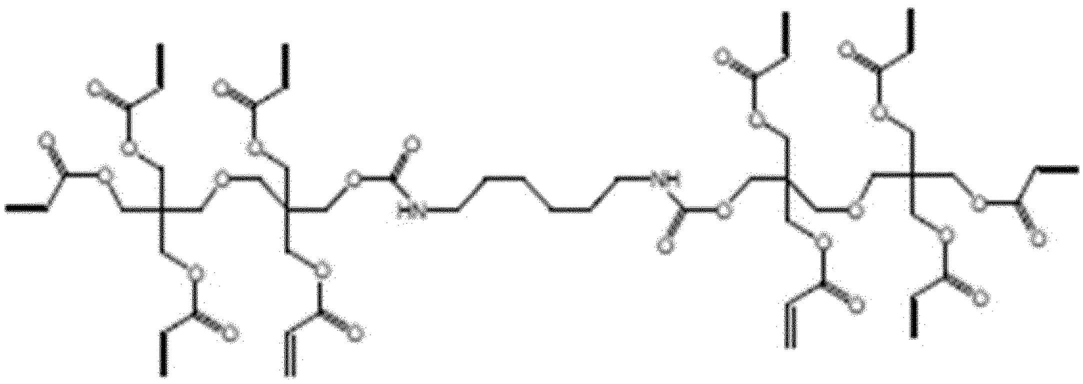

Monomer 2: the following compound

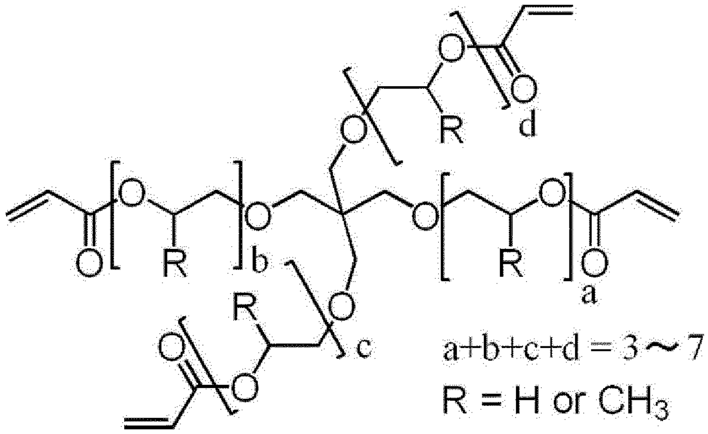

Monomer 3: the following compound

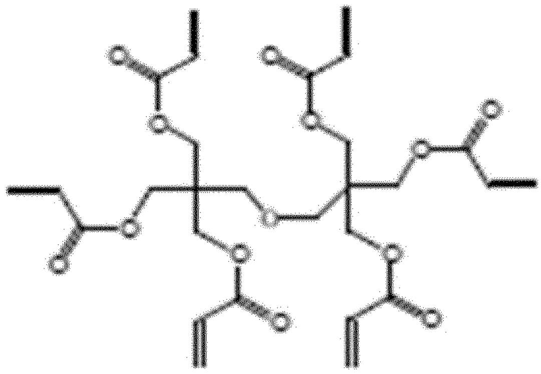

Surfactant 1: BYK302 manufactured by BYK-Chemie GmbH was used as a 25% by mass solution of 1-methoxy-2-propanol.
Iodonium salt 1: the following compound

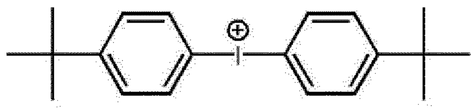

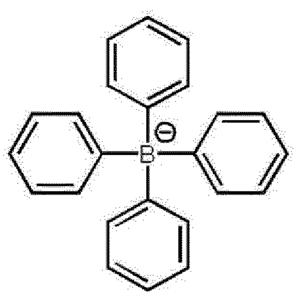

Iodonium salt 2: the following compound

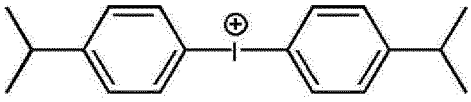

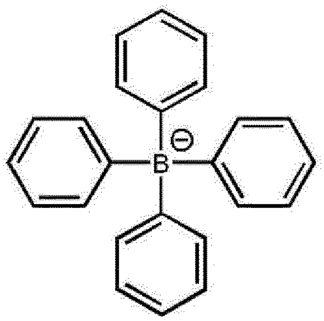

Phenothiazine: the following compound

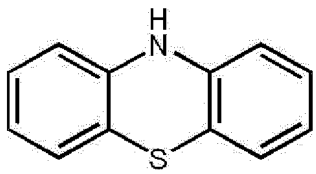

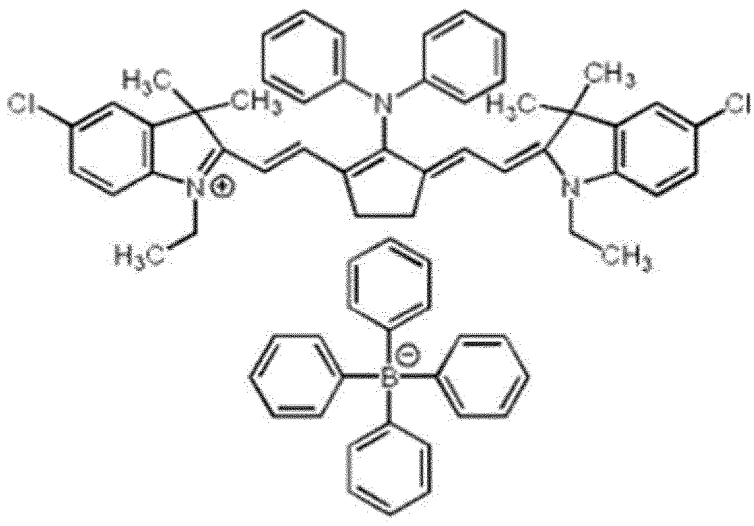

IR Dye - 6

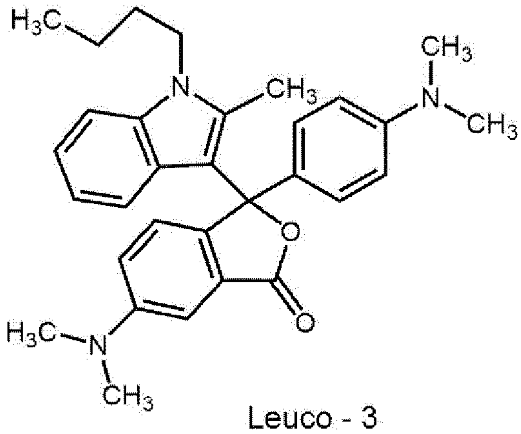

Leuco - 3

<Formation of protective layer>

The image-recording layer 2 was bar-coated with the above-described protective layer coating liquid 1 and dried in an oven at 120°C for 60 seconds, thereby forming a protective layer having a dry coating amount of 0.05 g/m$^2$. In this way, a lithographic printing plate precursor was prepared. In Comparative Examples 2 and 3, the protective layer was not formed.

(Example 7)

A lithographic printing plate precursor was produced in the same manner as in Example 1, except that the dry coating amount of the protective layer was changed to 0.025 g/m$^2$ (protective layer 2).

(Example 8)

A lithographic printing plate precursor was produced in the same manner as in Example 1, except that the dry coating amount of the protective layer was changed to 0.010 g/m$^2$ (protective layer 3).

(Example 9)

A lithographic printing plate precursor was produced in the same manner as in Example 1, except that 0.3375 parts of the inorganic lamellar compound dispersion liquid (1) of the protective layer was changed to pure water (protective layer 4).

(Example 10)

A lithographic printing plate precursor was produced in the same manner as in Example 1, except that the support was changed to the support D.

-Production of support D-

«Alkaline etching treatment>»

The aluminum plate was subjected to an etching treatment by spraying a caustic soda aqueous solution in which the concentration of caustic soda was 26% by mass and the concentration of aluminum ions was 6.5% by mass using a spray at a temperature of 70°C, to grain the surface of an aluminum plate. Then, water washing was performed by means of spraying. The amount of dissolved aluminum within the surface to be subjected to the electrochemical roughening treatment later was 5 g/m2.

<<Desmutting treatment using acidic aqueous solution>>

Next, a desmutting treatment was performed using an acidic aqueous solution. Specifically, the desmutting treatment was performed for 3 seconds by spraying the acidic aqueous solution onto the aluminum plate. As the acidic aqueous solution used for the desmutting treatment, an aqueous solution containing 150 g/L of sulfuric acid was used. The

liquid temperature was 30°C.

<<Electrochemical roughening treatment>>

Next, an electrochemical roughening treatment was performed using a hydrochloric acid electrolytic solution and alternating current. The hydrochloric acid concentration was set to 13 g/L, the aluminum concentration was set to 15 g/L, and the sulfuric acid concentration was set to 1 g/L, and the aluminum ion concentration was adjusted by adding aluminum chloride. The waveform of the alternating current was a sine wave in which positive and negative waveforms are symmetrical, the frequency was 50 Hz, the ratio of the anodic reaction time and the cathodic reaction time in one cycle of the alternating current was 1:1, and the carbon electrode was used as the counter electrode of the aluminum plate. Then, a water washing treatment was performed.

<<Alkaline etching treatment>>

The aluminum plate having undergone the electrochemical roughening treatment was subjected to an etching treatment by spraying a caustic soda aqueous solution having a caustic soda concentration of 5% by mass and an aluminum ion concentration of 0.5% by mass with liquid temperature adjusted according to the etching amount of aluminum (g/m2) described in Table 2, and spraying thereon. Changing the temperature in the etching treatment makes it possible to control the etching amount of aluminum of a surface subjected to an electrochemical roughening treatment. Then, a water washing treatment was performed.

<<Desmutting treatment using acidic aqueous solution>>

Next, a desmutting treatment was performed using an acidic aqueous solution. Specifically, the desmutting treatment was performed for 3 seconds by spraying the acidic aqueous solution onto the aluminum plate. As the acidic aqueous solution used for the desmutting treatment, an aqueous solution having a sulfuric acid concentration of 170 g/L and an aluminum ion concentration of 5 g/L was used. The liquid temperature was 35°C.

<<First-stage anodization treatment (AD treatment)>>

By using the anodization device for direct current electrolysis, a first-stage anodization treatment was performed to form an anodic oxide film having a film thickness of 110 nm.

<<Pore widening treatment>>

The aluminum plate having undergone the above anodization treatment was immersed in an aqueous solution of caustic soda at a temperature of 40°C and having a caustic soda concentration of 5% by mass and an aluminum ion concentration of 0.5% by mass for 2.7 seconds, thereby performing a pore widening treatment. Then, water washing was performed by means of spraying.

<<Second-stage anodization treatment>>

By using the anodization device for direct current electrolysis, a second-stage anodization treatment was performed to form an anodic oxide film having a film thickness of 1,500 nm and to prepare the support D.

Evaluation was performed using each of the obtained lithographic printing plate precursors and the protective materials shown in Table 2. The evaluation results are summarized in Table 2.

[Table 2]

| | Lithographic printing plate precursor | | | | Protective material | | Evaluation result |
|---|---|---|---|---|---|---|---|
| | Type of support | Type of image-recording layer | Type of protective layer | Surface free energy of outermost layer on image-recording layer side (mJ/$m^2$) | Material | Moisture content | Development defect suppressiveness |
| Example 1 | A | 1 | 1 | 76 | Protector cardboard | 10% by mass | 30 sheets |
| Example 2 | B | 2 | 1 | 76 | Protector cardboard | 10% by mass | 30 sheets |
| Example 3 | C | 2 | 1 | 76 | Protector cardboard | 10% by mass | 30 sheets |
| Example 4 | A | 1 | 1 | 76 | Protector cardboard | 7% by mass | 20 sheets |
| Example 5 | A | 1 | 1 | 76 | Protector cardboard | 3% by mass | 15 sheets |
| Example 6 | A | 1 | 1 | 76 | PET | Less than 1% by mass | 15 sheets |
| Example 7 | A | 1 | 2 | 95 | Protector cardboard | 10% by mass | 40 sheets |
| Example 8 | A | 1 | 3 | 112 | Protector cardboard | 10% by mass | 50 sheets |
| Example 9 | A | 1 | 4 | 80 | Protector cardboard | 10% by mass | 35 sheets |
| Example 10 | D | 1 | 1 | 76 | Protector cardboard | 10% by mass | 30 sheets |
| Comparative Example 1 | A | 1 | - | 138 | Protector cardboard | 10% by mass | 100 sheets or more |
| Comparative Example 2 | B | 2 | - | 122 | Protector cardboard | 10% by mass | 100 sheets or more |
| Comparative Example 3 | C | 2 | - | 122 | Protector cardboard | 10% by mass | 100 sheets or more |

For the evaluation results of suppressiveness of development defect by shearing in each of Examples 1 to 10, the same evaluation results as the evaluation results of development defect suppressiveness were obtained.

As is clear from Table 2, it can be seen that the on-press development type lithographic printing plate precursors according to the examples have excellent development defect suppressiveness as compared with the lithographic printing plate precursors according to the comparative examples.

The disclosure of JP2022-13339 filed on January 31, 2022 and the disclosure of JP2022-116662 filed on July 21, 2022 are incorporated in the present specification by reference.

All documents, patent applications, and technical standards described in the present specification are herein incorporated by reference to the same extent that individual documents, patent applications, and technical standards have been specifically and individually indicated to be incorporated by reference, respectively.

Explanation of References

12: striped sample
14: transport roll
16: air cylinder
18: weight
50: main electrolytic cell
51: alternating current power source
52: radial drum roller
53a, 53b: main pole
54: electrolytic solution supply port
55: electrolytic solution
56: auxiliary anode
57: electrolytic liquid channel
58: auxiliary anode
60: auxiliary anode cell
W: aluminum plate
S: liquid supply direction
Ex: electrolytic solution discharge direction
610: anodization treatment device
612: power supply tank
614: electrolytic treatment tank
616: aluminum plate
618, 26: electrolytic solution
620: power supply electrode
622, 628: roller
624: nip roller
630: electrolysis electrode
632: tank wall
634: direct current power source
ta: anodic reaction time
tc: cathodic reaction time
tp: time taken for current to reach peak from 0
Ia: peak current on anodic cycle side
Ic: peak current on cathodic cycle side
AA: current of anodic reaction of aluminum plate
CA: current of cathodic reaction of aluminum plate

## Claims

**1.** An on-press development type lithographic printing plate precursor, comprising:

an image-recording layer on a support,
wherein the image-recording layer contains an infrared absorber A, a borate compound B, an iodonium compound C, and a color forming substance precursor D, and
a surface free energy of an outermost layer on an image-recording layer side is 115 mJ/$m^2$ or less.

**2.** The on-press development type lithographic printing plate precursor according to claim 1, wherein the iodonium compound C includes two types of iodonium compounds.

**3.** The on-press development type lithographic printing plate precursor according to claim 1 or 2, wherein a molar absorption coefficient ε of a color forming substance generated from the color forming substance precursor D is 35,000 or more.

**4.** The on-press development type lithographic printing plate precursor according to claim 3,

wherein a ring-opening ratio of the color forming substance precursor, which is obtained by the following expression, is 40 mol% to 99 mol%, and
a maximum absorption wavelength of the color forming substance generated from the color forming substance precursor, in a wavelength range of 380 nm to 750 nm, is 500 nm to 650 nm,
ring-opening ratio = molar absorption coefficient of the color forming substance obtained in case of adding 1 molar equivalent of acid to the color forming substance precursor/molar absorption coefficient $\varepsilon$ of the color forming substance generated from the color forming substance precursor $\times$ 100.

**5.** The on-press development type lithographic printing plate precursor according to claim 1 or 2, further comprising: a protective layer on the image-recording layer.

**6.** The on-press development type lithographic printing plate precursor according to claim 5, wherein the protective layer contains a filler.

**7.** The on-press development type lithographic printing plate precursor according to claim 1 or 2, wherein the image-recording layer further contains polymer particles containing a polymer having both of

i: a constitutional unit having a pendant cyano group directly bonded to a hydrophobic main chain and
ii: a constitutional unit having a pendant group including a hydrophilic poly(alkylene oxide) segment.

**8.** The on-press development type lithographic printing plate precursor according to claim 1 or 2,

wherein the support has an aluminum plate and an anodic oxide film of aluminum, disposed on the aluminum plate,
the anodic oxide film is positioned closer to the image-recording layer side than the aluminum plate,
the anodic oxide film has a micropore extending in a depth direction from a surface of the anodic oxide film on the image-recording layer side,
the micropore is configured with a large diameter portion extending to a position at a depth of 10 nm to 1,000 nm from the surface of the anodic oxide film and a small diameter portion communicating with a bottom portion of the large diameter portion and extending to a position at a depth of 20 nm to 2,000 nm from a communicate position,
an average diameter of the large diameter portion within the surface of the anodic oxide film is 15 nm to 100 nm, and
an average diameter of the small diameter portion at the communicate position is less than 15 nm.

**9.** The on-press development type lithographic printing plate precursor according to claim 1 or 2,

wherein the support has an aluminum plate and an anodic oxide film of aluminum, disposed on the aluminum plate,
the anodic oxide film is positioned closer to the image-recording layer side than the aluminum plate,
the anodic oxide film has a micropore extending in a depth direction from a surface of the anodic oxide film on the image-recording layer side,
the micropore is configured with a small diameter portion extending to a position at a depth of 10 nm to 1,000 nm from the surface of the anodic oxide film and a large diameter portion communicating with a bottom portion of the small diameter portion and extending to a position at a depth of 20 nm to 2,000 nm from a communicate position,
an average diameter of the small diameter portion within the surface of the anodic oxide film is 35 nm or less, and
an average maximum diameter of the large diameter portion is 40 nm to 300 nm.

**10.** The on-press development type lithographic printing plate precursor according to claim 1 or 2,

wherein the support has an aluminum plate and an anodic oxide film of aluminum, disposed on the aluminum plate,
the anodic oxide film is positioned closer to the image-recording layer side than the aluminum plate,
the anodic oxide film is configured with an upper layer, an intermediate layer, and a lower layer, which have a micropore,
the upper layer has a pore diameter of 20 nm to 100 nm and a thickness of 30 nm to 500 nm,
the intermediate layer has a pore diameter of 1/2 times to 5 times the pore diameter of the upper layer and a thickness of 100 nm to 300 nm, and
the lower layer has a pore diameter of 15 nm or less and a thickness of 300 nm to 2,000 nm.

**11.** A method of preparing a lithographic printing plate, comprising:

a step of exposing the on-press development type lithographic printing plate precursor according to claim 1 or 2 in a shape of an image; and
a step of supplying at least one selected from the group consisting of a printing ink and dampening water on a printer to remove an image-recording layer in a non-image area.

**12.** A lithographic printing method comprising:

a step of exposing the on-press development type lithographic printing plate precursor according to claim 1 or 2 in a shape of an image;
a step of supplying at least one selected from the group consisting of a printing ink and dampening water on a printer to remove an image-recording layer in a non-image area and to prepare a lithographic printing plate; and
a step of performing printing using the obtained lithographic printing plate.

**13.** A laminate comprising:

laminated on-press development type lithographic printing plate precursors, the on-press development type lithographic printing plate precursor including an image-recording layer on a support and having a surface free energy of an outermost layer on an image-recording layer side of 115 $mJ/m^2$ or less, in which the image-recording layer contains an infrared absorber A, a borate compound B, an iodonium compound C, and a color forming substance precursor D,
wherein a protective material that protects the on-press development type lithographic printing plate precursor disposed on at least an uppermost portion of the laminated on-press development type lithographic printing plate precursors is provided, and
the protective material has a moisture content of 10% by mass or less.

FIG. 1

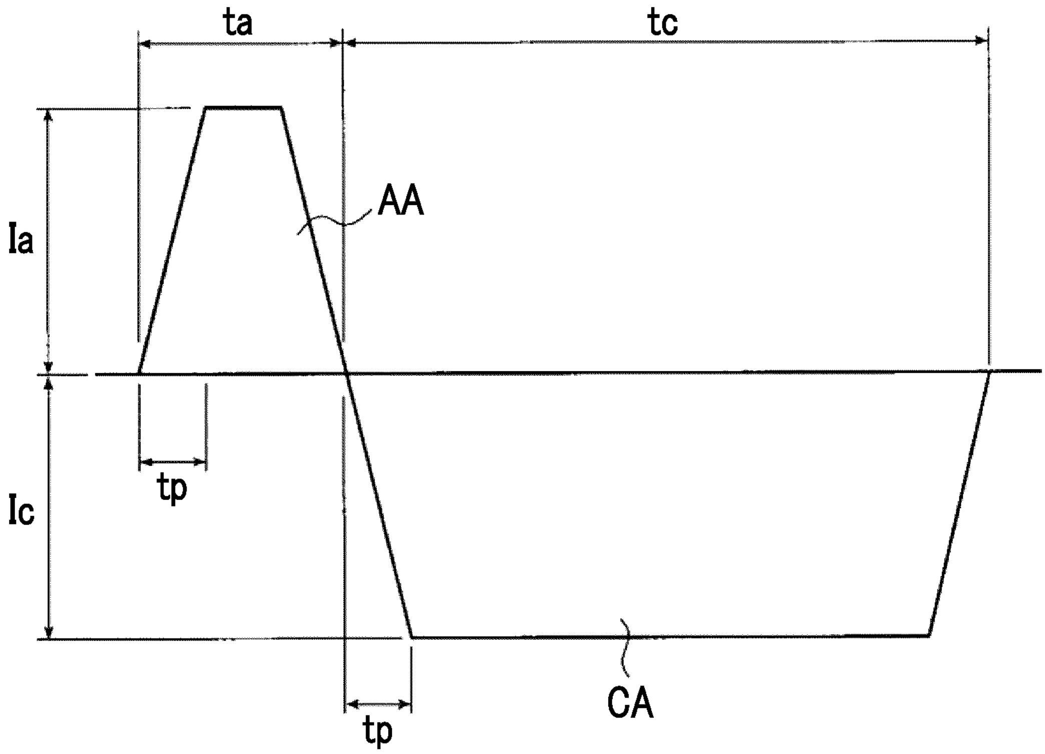


FIG. 2

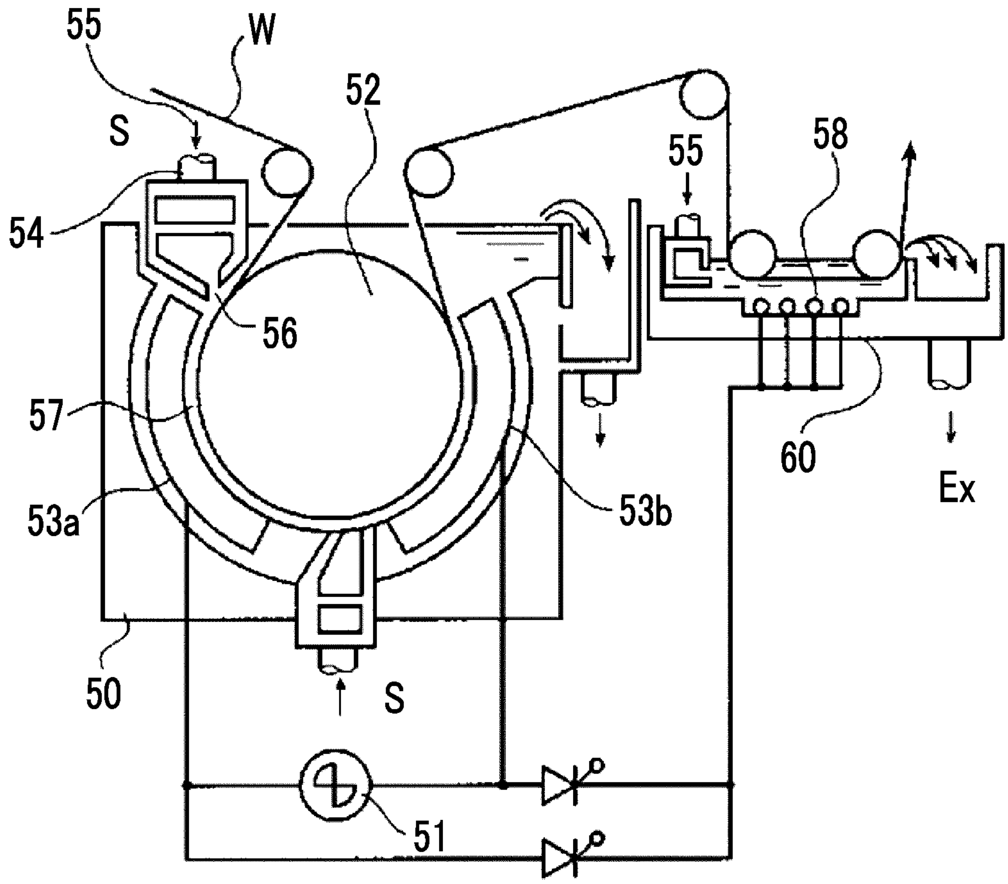

FIG. 3

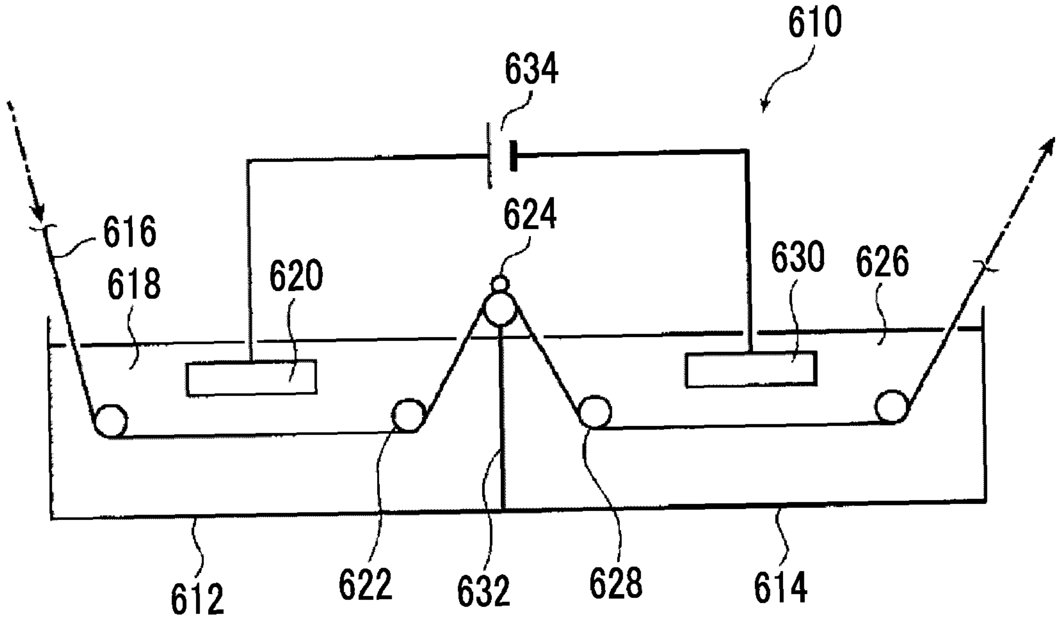


FIG. 4

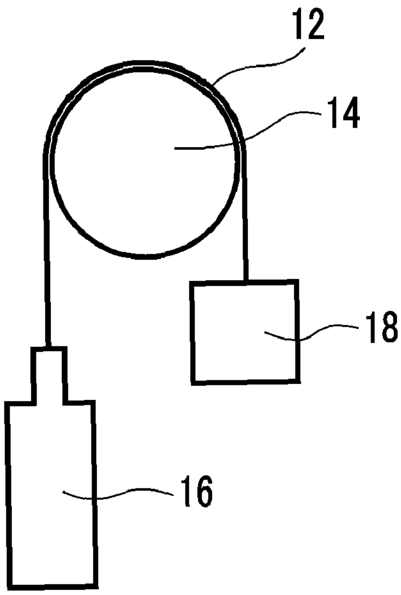

## INTERNATIONAL SEARCH REPORT

International application No. **PCT/JP2023/003124**

**A. CLASSIFICATION OF SUBJECT MATTER**

***B41N 1/14***(2006.01)i; ***B41C 1/055***(2006.01)i; ***B41C 1/10***(2006.01)i; ***B41M 1/06***(2006.01)i; ***B41N 1/08***(2006.01)i; ***B41N 3/00***(2006.01)i; ***G03F 7/00***(2006.01)i; ***G03F 7/004***(2006.01)i; ***G03F 7/029***(2006.01)i; ***G03F 7/09***(2006.01)i; ***G03F 7/11***(2006.01)i

FI: B41N1/14; B41C1/055 501; B41M1/06; G03F7/00 503; G03F7/004 505; G03F7/029; G03F7/004 506; G03F7/11 501; G03F7/09 501; B41C1/10; B41N3/00; G03F7/004 507; B41N1/08

According to International Patent Classification (IPC) or to both national classification and IPC

**B. FIELDS SEARCHED**

Minimum documentation searched (classification system followed by classification symbols)

B41N1/14; B41C1/055; B41C1/10; B41M1/06; B41N1/08; B41N3/00; G03F7/00; G03F7/004; G03F7/029; G03F7/09; G03F7/11

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y | WO 2021/241519 A1 (FUJIFILM CORPORATION) 02 December 2021 (2021-12-02) claims 1-29, paragraphs [0029], [0196], [0245], [0403]-[0498] | 1-2, 5-9, 11-12<br>3-4, 10, 13 |
| X<br>Y | WO 2021/241518 A1 (FUJIFILM CORPORATION) 02 December 2021 (2021-12-02) claims 1-27, paragraphs [0028], [0218], [0267], [0461]-[0577] | 1-2, 5-9, 11-12<br>3-4, 10, 13 |
| Y | WO 2020/262692 A1 (FUJIFILM CORPORATION) 30 December 2020 (2020-12-30) claims 1-39, paragraphs [0553]-[0706] | 3-4 |
| Y | US 2021/0094336 A1 (EASTMAN KODAK COMPANY) 01 April 2021 (2021-04-01) claims 1-21 | 10 |
| Y | WO 2021/241693 A1 (FUJIFILM CORPORATION) 02 December 2021 (2021-12-02) paragraph [0416] | 13 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **31 March 2023** | **11 April 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | <br><br>Telephone No. |

Form PCT/ISA/210 (second sheet) (January 2015)

**INTERNATIONAL SEARCH REPORT**

International application No.
**PCT/JP2023/003124**

**C. DOCUMENTS CONSIDERED TO BE RELEVANT**

| Category* | Citation of document, with indication, where appropriate, of the relevant passages | Relevant to claim No. |
|---|---|---|
| A | EP 1524113 A2 (AGFA-GEVAERT) 20 April 2005 (2005-04-20)<br>whole document | 1-13 |

Form PCT/ISA/210 (second sheet) (January 2015)

**INTERNATIONAL SEARCH REPORT**
**Information on patent family members**

International application No.
**PCT/JP2023/003124**

| Patent document cited in search report | Publication date (day/month/year) | Patent family member(s) | Publication date (day/month/year) |
|---|---|---|---|
| WO 2021/241519 A1 | 02 December 2021 | (Family: none) | |
| WO 2021/241518 A1 | 02 December 2021 | (Family: none) | |
| WO 2020/262692 A1 | 30 December 2020 | US 2022/0111629 A1<br>claims 1-24, paragraphs [1183]-[1549]<br>EP 3991986 A1<br>CN 114051598 A | |
| US 2021/0094336 A1 | 01 April 2021 | WO 2021/067054 A1<br>CN 114502378 A | |
| WO 2021/241693 A1 | 02 December 2021 | (Family: none) | |
| EP 1524113 A2 | 20 April 2005 | US 2005/0089802 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2020262692 A
- JP 2001133969 A
- JP 2002023360 A
- JP 2002040638 A
- JP 2002278057 A
- JP 2008195018 A
- JP 2007090850 A
- JP 2012206495 A
- JP 5005005 A
- JP H055005 A
- JP 2001222101 A
- JP 2008544322 A
- WO 2016027886 A
- WO 2019219560 A
- WO 2019013268 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2008503365 A
- JP 2012148555 A
- JP 2008284817 A
- JP 5045885 A
- JP H545885 A
- JP 6035174 A
- JP H635174 A
- JP 50040047 B
- GB 1412768 A
- JP 2005254638 A
- US 2714066 A
- US 3181461 A
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A
- US 3458311 A
- JP 55049729 B
- JP S5549729 B
- JP 2005250216 A
- JP 2006259137 A
- JP 2010076336 A
- JP 2022013339 A
- JP 2022116662 A


### Non-patent literature cited in the description


- Dye Handbooks. Society of Synthetic Organic Chemistry, 1970